# EUROPEAN PATENT SPECIFICATION

(11) **EP 4 019 477 B1**
(45) Date of publication and mention of the grant of the patent: **28.08.2024**
(21) Application number: 20855691.0
(22) Date of filing: 01.07.2020
(51) Int. Cl.: C03C 3/062, C03C 3/16, C03C 3/17, H01L 33/56, C03C 3/068

(54) **PHOSPHATE GLASS AND LIGHT-EMITTING DEVICE USING SAME**
PHOSPHATGLAS UND LICHTEMITTIERENDE VORRICHTUNG DAMIT
VERRE AU PHOSPHATE ET DISPOSITIF ÉLECTROLUMINESCENT L'UTILISANT

(30) Priority: 21.08.2019 JP 2019151314
(43) Date of publication of application: 29.06.2022
(73) Proprietor: National Institute of Advanced Industrial Science and Technology, Tokyo 100-8921 (JP)
(72) Inventor: MASAI, Hirokazu, Ikeda-shi, Osaka 563-8577 (JP); AKAI, Tomoko, Ikeda-shi, Osaka 563-8577 (JP)
(74) Representative: Mewburn Ellis LLP
(86) International application number: PCT/JP2020/025807
(87) International publication number: WO 2021/033434

(56) References cited:
- WO-A1-2008/114614
- JP-A- 2006 001 808
- JP-A- 2012 072 040
- JP-A- 2012 102 002
- JP-A- H0 360 442
- JP-A- S51 107 311
- JP-B2- 3 158 202
- US-A- 4 248 732
- US-A- 5 053 165
- US-A- 5 234 871

## Description

### TECHNICAL FIELD

The present invention relates to phosphate glass and a light emitting device in which the phosphate glass is used.

### BACKGROUND ART

High-intensity light emitting elements such as light emitting diodes (LEDs) have been actively developed in recent years. In a general method of using a light emitting diode as a light emitting element, the light emitting diode is combined with a material with which the light emitting diode is coated to form a device.

As such a coating material, an organic polymer, a silicon resin, or the like is generally used, but from the viewpoints of light resistance, gas permeability, heat resistance, and chemical durability, oxide glass that is easy to mold is the most suitable.

However, ordinary oxide glass is produced with a melting method in which an oxide raw material powder is once heated to 1,000°C or higher and cooled in order to obtain a uniform melt. Such a high temperature far exceeds the heat-resistant temperature of a light emitting element, and therefore such a high-temperature melting method cannot be used.

Meanwhile, oxide glass having a characteristic of softening at a low temperature is referred to as low melting point glass. Low melting point glass is mainly used for coating and sealing in electronic components, and therefore the working temperature of low melting point glass is approximately 600°C or lower. However, low melting point glass in which lead is used is conventionally difficult to use as a coating material due to regulation in accordance with Restriction of the Use of Certain Hazardous Substances in Electrical and Electronic Equipment (RoHS).

Therefore, low melting point glass having a composition designed to substitute lead with a plurality of other elements is actively developed by industry-academic-government. Among the developed glass, one alternative candidate is low melting point glass containing bismuth, vanadium, and the like, and this glass has both excellent chemical durability and a low melting point (Patent Documents 1 and 2).

However, in many cases, such glass is colored and is difficult to use as low melting point glass for optical applications as described above.

Therefore, development of inorganic oxide glass having both transparency in a near-ultraviolet to visible region and a softening characteristic at a low temperature is earnestly desired by the industry.

As one composition for such optical applications at low temperatures, oxide glass containing 50 mol% or more of zinc is known (Non-Patent Document 1). Such a composition is known as a lead-free low-melting point frit, and has permeability depending on the composition even in an ultraviolet region. However, the lead-free low-melting point frit is to be manufactured through a plurality of steps, such as a step of adjusting the particle size of a frit produced by melting glass, and the glass is essentially to be melted once at a temperature close to 1,000°C.

Examples of a production method that enables production at a low temperature include a sol-gel method in which a solution is used. However, even in this method, heating to 500°C or higher is generally to be performed in order to obtain an oxide material.

As an oxide material that can be produced at a low temperature, a glass thin film containing ZnO is known (Patent Document 3, Non-Patent Document 2). Patent Document 3 describes that an amorphous glass thin film containing three components of SnO-ZnO-P₂O₅ can be formed into a film in the order of micrometer at a low temperature of about 400°C in a single step by controlling the composition.

A method is also known in which bulk low melting point glass is produced using a zinc compound and phosphoric acid as starting raw materials (Patent Document 4). This glass contains 55 to 90 mol% of P₂O₅ and 10 to 45 mol% of ZnO in terms of mole percentage based on oxides, and can be produced at 500°C. Patent document 5 concerns a phosphate based layer glass composition for high average power systems including by mol percent 60-66% P₂O₅, 6-9% Al₂O₃, 8-12% Li₂O, 0-15% MgO, 0-15% ZnO, 0-5% B₂O₃ and 0.1-4% Nd₂O₃, with MgO+ZnO totaling 14-16%. Patent document 6 concerns a low- or no-silica, low- or no-alkali phosphate glass. Patent document 7 concerns a vanadium- and copper-containing glasses.

### PRIOR ART DOCUMENTS

### PATENT DOCUMENTS

Patent document 1: JP 2009-221048 A
Patent document 2: JP 2019-038722 A
Patent document 3: JP 2012-160697 A
Patent document 4: JP 2017-049526 A
Patent document 5: US 5053165 A
Patent document 6: JP 3158202 B2
Patent document 7: US 5234871 A

### NON-PATENT DOCUMENTS

Non-Patent Document 1: Morena, Journal of Non-Crystalline Solids, 2000, vol. 263-264, p. 382
Non-Patent Document 2: Masai et al., Scientific Reports, 2015, vol. 5, p. 11224
Non-Patent Document 3: C. A. ANGELL, Journal of Non-Crystalline Solids, 1988, vol. 102, p. 205-221

### SUMMARY OF THE INVENTION

### PROBLEMS TO BE SOLVED BY THE INVENTION

However, the glass described in Patent Document 4 has low durability against water, and has a problem of being easily dissolved in water when immersed in water. Patent Document 4 describes that the physical property can be adjusted by adding 0.1 to 5 mol% of another component with respect to two components of P₂O₅ and ZnO, but improvement in the durability has not been confirmed.

Therefore, according to an embodiment of the present invention, a phosphate glass is provided that has a low melting point and has excellent water resistance while maintaining a glass structure.

Furthermore, according to an embodiment of the present invention, a light emitting device is provided that includes phosphate glass having a low melting point and having excellent water resistance while maintaining a glass structure.

### MEANS FOR SOLVING THE PROBLEM

### (Configuration 1)

According to an embodiment of the present invention, the phosphate glass includes, in terms of mole percentage based on oxides, 55 to 65 [mol%] of P₂O₅, 10 to 27 [mol%] of ZnO, 0.5 to 7 [mol%] of R₂O₃ being at least one of Al₂O₃, Ga₂O₃, or Y₂O₃, 0.5 to 3.5 [mol%] of a lanthanoid oxide L₂O₃ being at least one of La₂O₃, Ce₂O₃, Pr₂O₃, Nd₂O₃, Pm₂O₃, Sm₂O₃, Lu₂O₃, Gd₂O₃, Tb₂O₃, Dy₂O₃, Ho₂O₃, Er₂O₃, Tm₂O₃, Yb₂O₃, or Lu₂O₃, and 4 to 15 [mol%] of X₂O being at least one of Li₂O, Na₂O, K₂O, Rb₂O, Cs₂O, or Fr₂O, and the phosphate glass has a glass transition temperature of lower than 400°C.

### (Configuration 2)

In the configuration 1, the total content of the P₂O₅ and the ZnO is 68 to 85 [mol%], and the total content of the R₂O₃ and the L₂O₃ is 1 to 10 [mol%].

### (Configuration 3)

In the configuration 1 or 2, the glass transition temperature is 240°C or lower.

### (Configuration 4)

In the configuration 3, the content of the Al₂O₃ is 1 to 5 [mol%].

### (Configuration 5)

In the configuration 3 or 4, the phosphate glass further includes 0.001 to 10.0 [mol%] of SnO.

### (Configuration 6)

In the configuration 1 or 2, the glass transition temperature is higher than 240°C.

### (Configuration 7)

In any one of the configurations 1 to 6, the phosphate glass further includes 5 to 12 [mol%] of QO being at least one of BaO, SrO, CaO, or MgO.

### (Configuration 8)

In any one of the configurations 1 to 7, the phosphate glass further includes 0.1 to 9 [mol%] of SiO₂.

### (Configuration 9)

According to an embodiment of the present invention, the light emitting device includes a light emitting element and a coating material. The light emitting element is coated with the coating material. The coating material includes the phosphate glass in any one of the configurations 1 to 8.

### ADVANTAGES OF THE INVENTION

A phosphate glass can be obtained that has a low melting point and has excellent water resistance while maintaining a glass structure.

### BRIEF DESCRIPTION OF THE DRAWINGS

Fig. 1 is a process chart showing a method for manufacturing phosphate glass PGS.
Fig. 2 is a schematic view of a light emitting device according to an embodiment of the present invention.
Fig. 3 are graphs showing the X-ray diffraction spectra of phosphate glass PGS-8 and PGS-13 to PGS-17 in Examples 8 and 13 to 17.
Fig. 4 is a graph showing the light transmission spectra of the phosphate glass PGS-8 and PGS-13 to PGS-16 in Examples 8 and 13 to 16.
Fig. 5 is a graph showing the fluorescence spectra of the phosphate glass PGS-13 to PGS-16 in Examples 13 to 16.

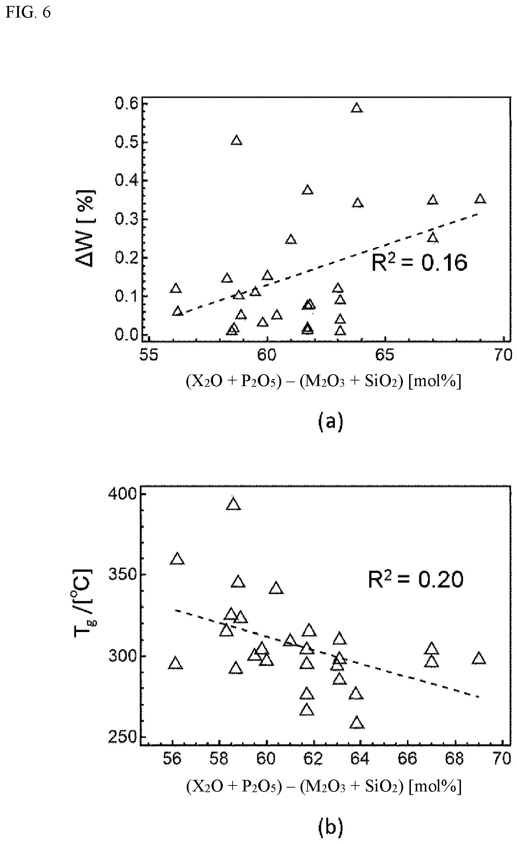

Fig. 6 are graphs, with the content of each component indicated in terms of mole percentage based on oxides, showing a relationship between the water resistance and the content of a specific component and a relationship between the glass transition temperature Tg and the content of the specific component in phosphate glass PGS-1 to PGS-9, PGS-13 to PGS-18, PGS-21, PGS-24, PGS-28, PGS-29, PGS-33 to PGS-38, PGS-61 to PGS-70, PGS-74, PGS-78, PGS-82, PGS-84 to PGS-86, PGS-90 to PGS-100, and PGS-Comp-1 to PGS-Comp-23 in Examples 1 to 9, 13 to 18, 21, 24, 28, 29, 33 to 38, 61 to 70, 74, 78, 82, 84 to 86, 90 to 100, and Comparative Examples 1 to 23.

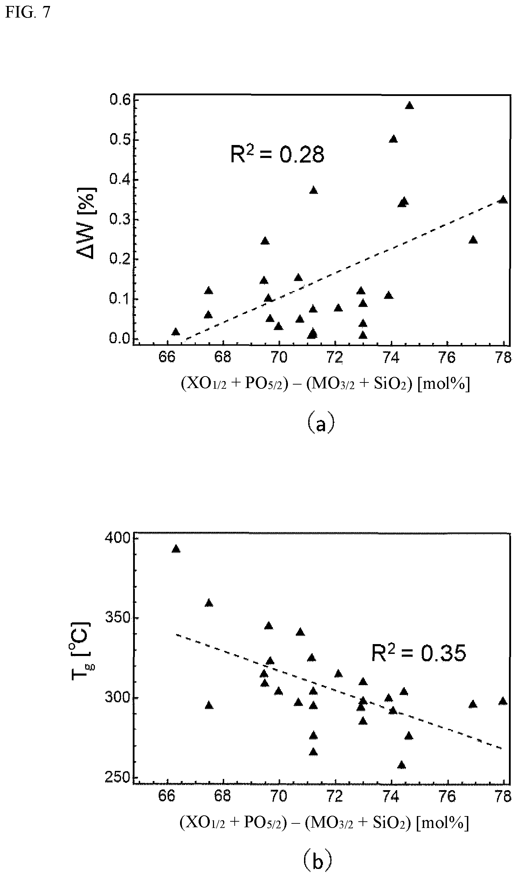

Fig. 7 are graphs, with the content of each component indicated in terms of mole percentage based on cations, showing a relationship between the water resistance and the content of a specific component and a relationship between the glass transition temperature Tg and the content of the specific component in the phosphate glass PGS-1 to PGS-9, PGS-13 to PGS-18, PGS-21, PGS-24, PGS-28, PGS-29, PGS-33 to PGS-38, PGS-61 to PGS-70, PGS-74, PGS-78, PGS-82, PGS-84 to PGS-86, PGS-90 to PGS-100, and PGS-Comp-1 to PGS-Comp-23 in Examples 1 to 9, 13 to 18, 21, 24, 28, 29, 33 to 38, 61 to 70, 74, 78, 82, 84 to 86, 90 to 100, and Comparative Examples 1 to 23.
Fig. 8 is a graph showing relationships between the glass transition temperature and the melting temperature.
Fig. 9 is a graph showing relationships between the viscosity and the glass transition temperature.
Fig. 10 is a graph showing relationships between the transmittance and the wavelength.
Fig. 11 are graphs showing relationships between the fluorescence intensity and the wavelength.

### EMBODIMENTS OF THE INVENTION

The phosphate glass PGS according to an embodiment of the present invention includes, in terms of mole percentage based on oxides, 55 to 65 [mol%] of P₂O₅, 10 to 27 [mol%] of ZnO, 0.5 to 7 [mol%] of R₂O₃ being at least one of Al₂O₃, Ga₂O₃, or Y₂O₃, 0.5 to 3.5 [mol%] of a lanthanoid oxide L₂O₃ being at least one of La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, or Lu₂O₃, and 4 to 15 [mol%] of X₂O being at least one of Li₂O, Na₂O, K₂O, Rb₂O, Cs₂O, or Fr₂O, and the phosphate glass PGS has a glass transition temperature Tg of lower than 400°C.

The P₂O₅ and the ZnO are components that form a network of glass (components that stabilize glass). The R₂O₃ and the L₂O₃ are components that increase the durability against water (water resistance) and the glass transition temperature Tg. The P₂O₅ and the X₂O are components that decrease the water resistance and the glass transition temperature Tg.

The phosphate glass PGS may have a glass transition temperature Tg of 240°C or lower. The phosphate glass PGS may have a glass transition temperature Tg of higher than 240°C and lower than 400°C.

The phosphate glass PGS is characterized in that the glass is stabilized by 55 to 65 [mol%] of P₂O₅ and 10 to 27 [mol%] of ZnO, and that the water resistance is improved by 0.5 to 7 [mol%] of R₂O₃ and 0.5 to 3.5 [mol%] of L₂O₃. That is, the phosphate glass PGS achieves stabilization of the glass and improvement in the water resistance by a balance between the total content of P₂O₅ and ZnO and the total content of R₂O₃ and L₂O₃.

In an embodiment of the present invention, the water resistance of the phosphate glass PGS is evaluated with any one method of the following (1) and (2).
(1) The water resistance is evaluated using a measurement result of the mass loss rate ΔW of the phosphate glass immersed in water having a pH of 7 (room temperature) for 360 minutes.
(2) The water resistance is evaluated using a measurement result of the mass loss rate ΔW of the phosphate glass immersed in water having a pH of 7 (70°C) for 180 minutes.

In both the methods (1) and (2), a smaller value of the loss rate ΔW indicates more excellent water resistance. In the case of evaluating the water resistance with the method (1), the water resistance is determined to be excellent when the loss rate ΔW is smaller than 30 [%], and in the case of evaluating the water resistance with the method (2), the water resistance is determined to be excellent when the loss rate ΔW is smaller than 0.6 [%].

From the viewpoint of the loss rate ΔW, the phosphate glass PGS more preferably includes 55.8 to 63.0 [mol%] of P₂O₅, 1.0 to 7.0 [mol%] of R₂O₃, and 1.0 to 3.5 [mol%] of L₂O₃, and still more preferably includes 1.0 to 6.1 [mol%] of R₂O₃ and 1.0 to 3.0 [mol%] of L₂O₃. From the viewpoint of the glass transition temperature Tg, the phosphate glass PGS more preferably includes 0.7 to 4.9 [mol%] of R₂O₃, and still more preferably includes 0.7 to 3.5 [mol%] of R₂O₃ and 0.7 to 3.0 [mol%] of L₂O₃. In consideration of both the loss rate ΔW and the glass transition temperature Tg, the phosphate glass PGS more preferably includes 55.8 to 63.0 [mol%] of P₂O₅, 1.0 to 4.9 [mol%] of R₂O₃, and 1.0 to 3.5 [mol%] of L₂O₃, and still more preferably includes 1.0 to 3.5 [mol%] of R₂O₃ and 1.0 to 3.0 [mol%] of L₂O₃.

The phosphate glass PGS may further include, in addition to P₂O₅, ZnO, R₂O₃, L₂O₃, and X₂O, 0.001 to 10.0 [mol%] of SnO in terms of mole percentage based on oxides. If the phosphate glass PGS includes 0.001 to 10.0 [mol%] of SnO, the wavelength λ_{TR} of the light at the transmission end in the ultraviolet region can be controlled according to the content of SnO while the glass network structure is maintained. More specifically, the wavelength λ_{TR} of the light at the transmission end shifts to the long wavelength side in the ultraviolet region as the content of SnO increases, and shifts to the short wavelength side in the ultraviolet region as the content of SnO decreases.

The phosphate glass PGS may include, in addition to P₂O₅, ZnO, R₂O₃, L₂O₃, and X₂O, 5 to 12 [mol%] of QO being at least one of BaO, SrO, CaO, or MgO in terms of mole percentage based on oxides. Similarly to X₂O, QO is classified as a network modifier in oxide glass, but has a smaller effect of decreasing the glass transition temperature Tg and the water resistance than X₂O.

Furthermore, the phosphate glass PGS may include, in addition to P₂O₅, ZnO, R₂O₃, L₂O₃, and X₂O, 0.1 to 9 [mol%] of SiO₂ in terms of mole percentage based on oxides. If the phosphate glass PGS includes SiO₂ as a component, the phosphate glass PGS achieving both stabilization of the glass and the water resistance can be manufactured even when the manufacturing process has an atmosphere including SiO₂.

Lanthanoid elements that can be used in an embodiment of the present invention are lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), and lutetium (Lu).

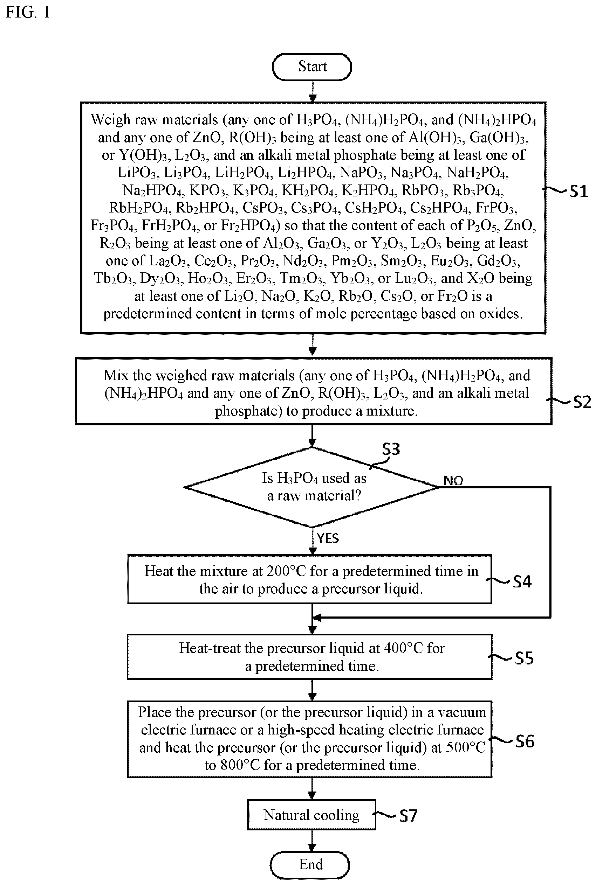

Fig. 1 is a process chart showing a method for manufacturing the phosphate glass PGS. At the start of manufacturing the phosphate glass PGS with reference to Fig. 1, raw materials (any one of H₃PO₄, (NH₄)H₂PO₄, and (NH₄)₂HPO₄ and any one of ZnO, R(OH)₃ being at least one of Al(OH)₃, Ga(OH)₃, or Y(OH)₃, L₂O₃, and an alkali metal phosphate being at least one of LiPO₃, Li₃PO₄, LiH₂PO₄, Li₂HPO₄, NaPO₃, Na₃PO₄, NaH₂PO₄, Na₂HPO₄, KPO₃, K₃PO₄, KH₂PO₄, K₂HPO₄, RbPO₃, Rb₃PO₄, RbH₂PO₄, Rb₂HPO₄, CsPO₃, Cs₃PO₄, CsH₂PO₄, Cs₂HPO₄, FrPO₃, Fr₃PO₄, FrH₂PO₄, or Fr₂HPO₄) are weighed so that the content of each of P₂O₅, ZnO, R₂O₃ being at least one of Al₂O₃, Ga₂O₃, or Y₂O₃, L₂O₃ being at least one of La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, or Lu₂O₃, and X₂O being at least one of Li₂O, Na₂O, K₂O, Rb₂O, Cs₂O, or Fr₂O is a predetermined content in terms of mole percentage based on oxides (step S1).

Then, the weighed raw materials (any one of H₃PO₄, (NH₄)H₂PO₄, and (NH₄)₂HPO₄ and any one of ZnO, R(OH)₃, L₂O₃, and an alkali metal phosphate) are mixed to produce a mixture (step S2).

In the case of using H₃PO₄ as a raw material ("YES" in the step S3), the mixture is heated at 200°C for a predetermined time (20 to 60 minutes) in the air to produce a precursor liquid (step S4).

In the case of using no H₃PO₄ as a raw material ("NO" in the step S3), or after the step S4, the precursor liquid is heat-treated at 400°C for a predetermined time (10 to 60 minutes) (step S5). Then, the precursor liquid is placed in an electric furnace and heated at 500°C for a predetermined time (10 to 30 minutes and preferably 10 to 20 minutes) to melt the mixture (step S6), and then the mixture is naturally cooled (step S7). In the case of melting the mixture at 800°C, the precursor liquid is placed in an electric furnace and heated at 800°C for a predetermined time (10 to 30 minutes and preferably 10 to 20 minutes) to melt the mixture (step S6), and then the mixture is naturally cooled (step S7). In the case of melting the mixture at a temperature between 500°C and 800°C in the step S6, either the melting method at 500°C or the melting method at 800°C described above is used. As a result, the phosphate glass PGS is manufactured. In the case of using a vacuum electric furnace in the step S6, the pressure in the vacuum electric furnace is, for example, 1 kPa to 40 kPa.

As described above, the phosphate glass PGS according to an embodiment of the present invention is manufactured by melting the raw materials at a temperature of 500°C to 800°C.

In a melt-quenching method as a conventional glass manufacturing method, raw materials are melted at a temperature of 1,000°C or higher, but in an embodiment of the present invention, the raw materials are melted at a temperature of 500°C to 800°C. Therefore, in the manufacturing method in an embodiment of the present invention, the temperature is lower than in a conventional glass manufacturing method, and energy used during synthesis can be suppressed. As a result, the environmental load can be reduced.

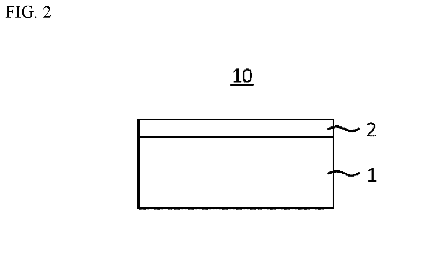

Fig. 2 is a schematic view of the light emitting device according to an embodiment of the present invention. As can be seen with reference to Fig. 2, a light emitting device 10 according to an embodiment of the present invention includes a light emitting element 1 and a coating material 2. The light emitting element 1 is a light emitting element having a light emission wavelength in the ultraviolet region, and is, for example, an LED.

The coating material 2 is disposed on the light emitting element 1 in contact with the light emitting surface of the light emitting element 1. The coating material 2 includes the phosphate glass PGS.

Hereinafter, the phosphate glass PGS will be described in detail with reference to Examples. Note that the sum of the numerical values of mole percentage may not be 100 [mol%] because the values are significant figures.

### (Example 1)

Each of 85% H₃PO₄, ZnO, Al(OH)₃, La₂O₃, KPO₃, and Ba(OH)₂·8H₂O was weighed so that the contents of P₂O₅, ZnO, Al₂O₃, La₂O₃, K₂O, and BaO were 59.6 [mol%], 20.7 [mol%], 2.6 [mol%], 1.0 [mol%], 7.8 [mol%], and 8.3 [mol%], respectively, in terms of mole percentage based on oxides.

Then, the weighed raw materials were mixed, and the resulting mixture was heated at 200°C for 30 minutes in the air to obtain a precursor liquid. Next, the precursor liquid was heated at 400°C for 20 minutes, then the heated precursor liquid was put into a vacuum electric furnace of model number KDF-75 Plus manufactured by DENKEN-HIGHDENTAL Co., Ltd., the pressure in the vacuum electric furnace was set to 40 kPa, and the precursor liquid was heated at 500°C for 15 minutes and then naturally cooled to produce phosphate glass PGS-1 in Example 1.

### (Example 2)

Phosphate glass PGS-2 in Example 2 was produced in the same manner as in Example 1 except that 85% H₃PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 62.1 [mol%], 22.6 [mol%], 2.8 [mol%], 1.1 [mol%], 5.7 [mol%], and 5.7 [mol%], respectively, in terms of mole percentage based on oxides.

### (Example 3)

Phosphate glass PGS-3 in Example 3 was produced in the same manner as in Example 1 except that 85% H₃PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 59.8 [mol%], 21.7 [mol%], 3.3 [mol%], 1.1 [mol%], 5.4 [mol%], and 8.7 [mol%], respectively, in terms of mole percentage based on oxides.

### (Example 4)

Phosphate glass PGS-4 in Example 4 was produced in the same manner as in Example 1 except that 85% H₃PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 64.9 [mol%], 10.8 [mol%], 2.7 [mol%], 2.2 [mol%], 10.8 [mol%], and 8.6 [mol%], respectively, in terms of mole percentage based on oxides.

### (Example 5)

Phosphate glass PGS-5 in Example 5 was produced in the same manner as in Example 1 except that 85% H₃PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 59.5 [mol%], 21.6 [mol%], 2.7 [mol%], 2.2 [mol%], 5.4 [mol%], and 8.6 [mol%], respectively, in terms of mole percentage based on oxides.

### (Example 6)

Phosphate glass PGS-6 in Example 6 was produced in the same manner as in Example 1 except that 85% H₃PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 56.1 [mol%], 25.4 [mol%], 2.6 [mol%], 2.6 [mol%], 5.1 [mol%], and 8.2 [mol%], respectively, in terms of mole percentage based on oxides.

### (Example 7)

Phosphate glass PGS-7 in Example 7 was produced in the same manner as in Example 1 except that 85% H₃PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 61.0 [mol%], 16.7 [mol%], 2.8 [mol%], 2.8 [mol%], 5.6 [mol%], and 11.1 [mol%], respectively, in terms of mole percentage based on oxides.

### (Example 8)

Phosphate glass PGS-8 in Example 8 was produced in the same manner as in Example 1 except that 85% H₃PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 62.8 [mol%], 17.4 [mol%], 2.9 [mol%], 2.9 [mol%], 4.7 [mol%], and 9.3 [mol%], respectively, in terms of mole percentage based on oxides.

### (Example 9)

Phosphate glass PGS-9 in Example 9 was produced in the same manner as in Example 1 except that 85% H₃PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 58.5 [mol%], 14.6 [mol%], 4.9 [mol%], 2.4 [mol%], 9.8 [mol%], and 9.8 [mol%], respectively, in terms of mole percentage based on oxides.

### (Example 10)

Phosphate glass PGS-10 in Example 10 was produced in the same manner as in Example 1 except that 85% H₃PO₄, ZnO, Al(OH)₃, La₂O₃, Lu₂O₃, KPO₃, and Ba(OH)₂·8H₂O were weighed so that the contents of P₂O₅, ZnO, Al₂O₃, La₂O₃, Lu₂O₃, K₂O, and BaO were 60.0 [mol%], 20.0 [mol%], 1.5 [mol%], 2.0 [mol%], 1.5 [mol%], 6.0 [mol%], and 9.0 [mol%], respectively, in terms of mole percentage based on oxides.

### (Example 11)

Phosphate glass PGS-11 in Example 11 was produced in the same manner as in Example 1 except that 85% H₃PO₄, ZnO, Al(OH)₃, La₂O₃, KPO₃, Ba(OH)₂·8H₂O, and Y₂O₃ were weighed so that the contents of P₂O₅, ZnO, Al₂O₃, La₂O₃, K₂O, BaO, and Y₂O₃ were 60.0 [mol%], 20.0 [mol%], 1.5 [mol%], 1.5 [mol%], 6.0 [mol%], 9.0 [mol%], and 2.0 [mol%], respectively, in terms of mole percentage based on oxides.

### (Example 12)

Phosphate glass PGS-12 in Example 12 was produced in the same manner as in Example 1 except that 85% H₃PO₄, ZnO, Al(OH)₃, La₂O₃, Ga₂O₃, KPO₃, Ba(OH)₂·8H₂O, and Y₂O₃ were weighed so that the contents of P₂O₅, ZnO, Al₂O₃, La₂O₃, Ga₂O₃, K₂O, BaO, and Y₂O₃ were 60.0 [mol%], 20.0 [mol%], 1.0 [mol%], 1.5 [mol%], 0.5 [mol%], 6.0 [mol%], 9.0 [mol%], and 2.0 [mol%], respectively, in terms of mole percentage based on oxides.

### (Example 13)

Phosphate glass PGS-13 in Example 13 was produced in the same manner as in Example 1 except that 85% H₃PO₄, ZnO, Al(OH)₃, La₂O₃, KPO₃, Ba(OH)₂·8H₂O, and SnO were weighed so that the contents of P₂O₅, ZnO, Al₂O₃, La₂O₃, K₂O, BaO, and SnO were 62.8 [mol%], 17.4 [mol%], 2.9 [mol%], 2.9 [mol%], 4.7 [mol%], 9.3 [mol%], and 0.001 [mol%], respectively, in terms of mole percentage based on oxides.

### (Example 14)

Phosphate glass PGS-14 in Example 14 was produced in the same manner as in Example 1 except that 85% H₃PO₄, ZnO, Al(OH)₃, La₂O₃, KPO₃, Ba(OH)₂·8H₂O, and SnO were weighed so that the contents of P₂O₅, ZnO, Al₂O₃, La₂O₃, K₂O, BaO, and SnO were 62.8 [mol%], 17.4 [mol%], 2.9 [mol%], 2.9 [mol%], 4.7 [mol%], 9.3 [mol%], and 0.010 [mol%], respectively, in terms of mole percentage based on oxides.

### (Example 15)

Phosphate glass PGS-15 in Example 15 was produced in the same manner as in Example 1 except that 85% H₃PO₄, ZnO, Al(OH)₃, La₂O₃, KPO₃, Ba(OH)₂·8H₂O, and SnO were weighed so that the contents of P₂O₅, ZnO, Al₂O₃, La₂O₃, K₂O, BaO, and SnO were 62.7 [mol%], 17.4 [mol%], 2.9 [mol%], 2.9 [mol%], 4.7 [mol%], 9.3 [mol%], and 0.1 [mol%], respectively, in terms of mole percentage based on oxides.

### (Example 16)

Phosphate glass PGS-16 in Example 16 was produced in the same manner as in Example 1 except that 85% H₃PO₄, ZnO, Al(OH)₃, La₂O₃, KPO₃, Ba(OH)₂·8H₂O, and SnO were weighed so that the contents of P₂O₅, ZnO, Al₂O₃, La₂O₃, K₂O, BaO, and SnO were 62.1 [mol%], 17.3 [mol%], 2.9 [mol%], 2.9 [mol%], 4.6 [mol%], 9.2 [mol%], and 1.0 [mol%], respectively, in terms of mole percentage based on oxides.

### (Example 17)

Phosphate glass PGS-17 in Example 17 was produced in the same manner as in Example 1 except that 85% H₃PO₄, ZnO, Al(OH)₃, La₂O₃, KPO₃, Ba(OH)₂·8H₂O, and SnO were weighed so that the contents of P₂O₅, ZnO, Al₂O₃, La₂O₃, K₂O, BaO, and SnO were 57.1 [mol%], 15.8 [mol%], 2.6 [mol%], 2.6 [mol%], 4.3 [mol%], 8.5 [mol%], and 9.1 [mol%], respectively, in terms of mole percentage based on oxides.

### (Example 18)

Phosphate glass PGS-18 in Example 18 was produced in the same manner as in Example 1 except that 85% H₃PO₄, ZnO, Al(OH)₃, La₂O₃, Ga₂O₃, KPO₃, and Ba(OH)₂·8H₂O were weighed so that the contents of P₂O₅, ZnO, Al₂O₃, La₂O₃, Ga₂O₃, K₂O, and BaO were 62.8 [mol%], 17.4 [mol%], 1.4 [mol%], 2.9 [mol%], 1.5 [mol%], 4.7 [mol%], and 9.3 [mol%], respectively, in terms of mole percentage based on oxides.

### (Example 19)

Phosphate glass PGS-19 in Example 19 was produced in the same manner as in Example 1 except that 85% H₃PO₄, ZnO, Al(OH)₃, Lu₂O₃, Ga₂O₃, KPO₃, and Ba(OH)₂·8H₂O were weighed so that the contents of P₂O₅, ZnO, Al₂O₃, Lu₂O₃, Ga₂O₃, K₂O, and BaO were 60.0 [mol%], 20.0 [mol%], 2.0 [mol%], 1.0 [mol%], 2.0 [mol%], 6.0 [mol%], and 9.0 [mol%], respectively, in terms of mole percentage based on oxides.

### (Example 20)

Phosphate glass PGS-20 in Example 20 was produced in the same manner as in Example 1 except that 85% H₃PO₄, ZnO, Al(OH)₃, Lu₂O₃, Ga₂O₃, KPO₃, Ba(OH)₂·8H₂O, and Y₂O₃ were weighed so that the contents of P₂O₅, ZnO, Al₂O₃, Lu₂O₃, Ga₂O₃, K₂O, BaO, and Y₂O₃ were 60.0 [mol%], 20.0 [mol%], 1.5 [mol%], 1.5 [mol%], 1.0 [mol%], 6.0 [mol%], 9.0 [mol%], and 1.0 [mol%], respectively, in terms of mole percentage based on oxides.

### (Example 21)

Phosphate glass PGS-21 in Example 21 was produced in the same manner as in Example 1 except that 85% H₃PO₄, ZnO, Lu₂O₃, Ga₂O₃, KPO₃, and Ba(OH)₂·8H₂O were weighed so that the contents of P₂O₅, ZnO, Lu₂O₃, Ga₂O₃, K₂O, and BaO were 62.8 [mol%], 17.4 [mol%], 2.9 [mol%], 2.9 [mol%], 4.7 [mol%], and 9.3 [mol%], respectively, in terms of mole percentage based on oxides.

### (Example 22)

Phosphate glass PGS-22 in Example 22 was produced in the same manner as in Example 1 except that 85% H₃PO₄, ZnO, Lu₂O₃, KPO₃, Ba(OH)₂·8H₂O, and Y₂O₃ were weighed so that the contents of P₂O₅, ZnO, Lu₂O₃, K₂O, BaO, and Y₂O₃ were 60.0 [mol%], 20.0 [mol%], 3.0 [mol%], 6.0 [mol%], 9.0 [mol%], and 2.0 [mol%], respectively, in terms of mole percentage based on oxides.

### (Example 23)

Phosphate glass PGS-23 in Example 23 was produced in the same manner as in Example 1 except that 85% H₃PO₄, ZnO, Al₂O₃, Lu₂O₃, KPO₃, Ba(OH)₂·8H₂O, and Y₂O₃ were weighed so that the contents of P₂O₅, ZnO, Al₂O₃, Lu₂O₃, K₂O, BaO, and Y₂O₃ were 60.0 [mol%], 20.0 [mol%], 1.5 [mol%], 1.5 [mol%], 6.0 [mol%], 9.0 [mol%], and 2.0 [mol%], respectively, in terms of mole percentage based on oxides.

### (Example 24)

Phosphate glass PGS-24 in Example 24 was produced in the same manner as in Example 1 except that 85% H₃PO₄, ZnO, La₂O₃, Ga₂O₃, KPO₃, and Ba(OH)₂·8H₂O were weighed so that the contents of P₂O₅, ZnO, La₂O₃, Ga₂O₃, K₂O, and BaO were 62.8 [mol%], 17.4 [mol%], 2.9 [mol%], 2.9 [mol%], 4.7 [mol%], and 9.3 [mol%], respectively, in terms of mole percentage based on oxides.

### (Example 25)

Phosphate glass PGS-25 in Example 25 was produced in the same manner as in Example 1 except that 85% H₃PO₄, ZnO, La₂O₃, KPO₃, Ba(OH)₂·8H₂O, and Y₂O₃ were weighed so that the contents of P₂O₅, ZnO, La₂O₃, K₂O, BaO, and Y₂O₃ were 60.0 [mol%], 20.0 [mol%], 3.0 [mol%], 6.0 [mol%], 9.0 [mol%], and 2.0 [mol%], respectively, in terms of mole percentage based on oxides.

### (Example 26)

Phosphate glass PGS-26 in Example 26 was produced in the same manner as in Example 1 except that 85% H₃PO₄, ZnO, La₂O₃, Ga₂O₃, KPO₃, Ba(OH)₂·8H₂O, and Y₂O₃ were weighed so that the contents of P₂O₅, ZnO, La₂O₃, Ga₂O₃, K₂O, BaO, and Y₂O₃ were 60.0 [mol%], 20.0 [mol%], 1.0 [mol%], 2.0 [mol%], 6.0 [mol%], 9.0 [mol%], and 2.0 [mol%], respectively, in terms of mole percentage based on oxides.

### (Example 27)

Phosphate glass PGS-27 in Example 27 was produced in the same manner as in Example 1 except that 85% H₃PO₄, ZnO, Lu₂O₃, Ga₂O₃, KPO₃, Ba(OH)₂·8H₂O, and Y₂O₃ were weighed so that the contents of P₂O₅, ZnO, Lu₂O₃, Ga₂O₃, K₂O, BaO, and Y₂O₃ were 60.0 [mol%], 20.0 [mol%], 1.0 [mol%], 2.0 [mol%], 6.0 [mol%], 9.0 [mol%], and 2.0 [mol%], respectively, in terms of mole percentage based on oxides.

### (Example 28)

Phosphate glass PGS-28 in Example 28 was produced in the same manner as in Example 1 except that 85% H₃PO₄, ZnO, Al(OH)₃, La₂O₃, KPO₃, and Ca(H₂PO₄)₂·H₂O were weighed so that the contents of P₂O₅, ZnO, Al₂O₃, La₂O₃, K₂O, and CaO were 62.1 [mol%], 22.6 [mol%], 2.8 [mol%], 1.1 [mol%], 5.7 [mol%], and 5.7 [mol%], respectively, in terms of mole percentage based on oxides.

### (Example 28-2)

Phosphate glass PGS-28-2 in Example 28-2 was produced in the same manner as in Example 1 except that (NH₄)H₂PO₄, ZnO, Al₂O₃, La₂O₃, KPO₃, and SrO were weighed so that the contents of P₂O₅, ZnO, Al₂O₃, La₂O₃, K₂O, and SrO were 62.1 [mol%], 22.6 [mol%], 2.8 [mol%], 1.1 [mol%], 5.7 [mol%], and 5.7 [mol%], respectively, in terms of mole percentage based on oxides.

### (Example 29)

Phosphate glass PGS-29 in Example 29 was produced in the same manner as in Example 1 except that 85% H₃PO₄, ZnO, Al(OH)₃, La₂O₃, and KPO₃ were weighed so that the contents of P₂O₅, ZnO, Al₂O₃, La₂O₃, and K₂O were 59.0 [mol%], 20.0 [mol%], 3.5 [mol%], 3.0 [mol%], and 14.5 [mol%], respectively, in terms of mole percentage based on oxides.

### (Example 30)

Phosphate glass PGS-30 in Example 30 was produced in the same manner as in Example 1 except that 85% H₃PO₄, ZnO, Al(OH)₃, La₂O₃, and LiPO₃ were weighed so that the contents of P₂O₅, ZnO, Al₂O₃, La₂O₃, and Li₂O were 62.5 [mol%], 21.5 [mol%], 1.5 [mol%], 2.5 [mol%], and 12.0 [mol%], respectively, in terms of mole percentage based on oxides.

### (Example 31)

Phosphate glass PGS-31 in Example 31 was produced in the same manner as in Example 1 except that 85% H₃PO₄, ZnO, Al(OH)₃, La₂O₃, and NaPO₃ were weighed so that the contents of P₂O₅, ZnO, Al₂O₃, La₂O₃, and Na₂O were 62.5 [mol%], 21.5 [mol%], 1.5 [mol%], 2.5 [mol%], and 12.0 [mol%], respectively, in terms of mole percentage based on oxides.

### (Example 32)

Phosphate glass PGS-32 in Example 32 was produced in the same manner as in Example 1 except that 85% H₃PO₄, ZnO, Al(OH)₃, La₂O₃, NaPO₃, and KPO₃ were weighed so that the contents of P₂O₅, ZnO, Al₂O₃, La₂O₃, Na₂O, and K₂O were 62.0 [mol%], 21.0 [mol%], 2.0 [mol%], 3.0 [mol%], 6.0 [mol%], and 6.0 [mol%], respectively, in terms of mole percentage based on oxides.

### (Example 33)

Phosphate glass PGS-33 in Example 33 was produced in the same manner as in Example 1 except that 85% H₃PO₄, ZnO, Al(OH)₃, Lu₂O₃, KPO₃, and Ba(OH)₂·8H₂O were weighed so that the contents of P₂O₅, ZnO, Al₂O₃, Lu₂O₃, K₂O, and BaO were 62.8 [mol%], 17.4 [mol%], 2.9 [mol%], 2.9 [mol%], 4.7 [mol%], and 9.3 [mol%], respectively, in terms of mole percentage based on oxides.

### (Example 34)

Phosphate glass PGS-34 in Example 34 was produced in the same manner as in Example 1 except that 85% H₃PO₄, ZnO, Al(OH)₃, La₂O₃, KPO₃, Ba(OH)₂·8H₂O, and SiO₂ were weighed so that the contents of P₂O₅, ZnO, Al₂O₃, La₂O₃, K₂O, BaO, and SiO₂ were 58.5 [mol%], 22.0 [mol%], 2.9 [mol%], 2.2 [mol%], 5.5 [mol%], 8.8 [mol%], and 0.1 [mol%], respectively, in terms of mole percentage based on oxides.

### (Example 35)

Phosphate glass PGS-35 in Example 35 was produced in the same manner as in Example 1 except that 85% H₃PO₄, ZnO, Al(OH)₃, La₂O₃, KPO₃, Ba(OH)₂·8H₂O, and SiO₂ were weighed so that the contents of P₂O₅, ZnO, Al₂O₃, La₂O₃, K₂O, BaO, and SiO₂ were 62.1 [mol%], 17.2 [mol%], 2.9 [mol%], 2.9 [mol%], 4.6 [mol%], 9.2 [mol%], and 1.1 [mol%], respectively, in terms of mole percentage based on oxides.

### (Example 36)

Phosphate glass PGS-36 in Example 36 was produced in the same manner as in Example 1 except that 85% H₃PO₄, ZnO, Al(OH)₃, La₂O₃, KPO₃, and SiO₂ were weighed so that the contents of P₂O₅, ZnO, Al₂O₃, La₂O₃, K₂O, and SiO₂ were 59.0 [mol%], 20.0 [mol%], 1.0 [mol%], 3.0 [mol%], 14.5 [mol%], and 2.5 [mol%], respectively, in terms of mole percentage based on oxides.

### (Example 37)

Phosphate glass PGS-37 in Example 37 was produced in the same manner as in Example 1 except that 85% H₃PO₄, ZnO, Al(OH)₃, La₂O₃, KPO₃, Ba(OH)₂·8H₂O, and SiO₂ were weighed so that the contents of P₂O₅, ZnO, Al₂O₃, La₂O₃, K₂O, BaO, and SiO₂ were 57.0 [mol%], 12.5 [mol%], 1.0 [mol%], 1.0 [mol%], 11.5 [mol%], 10.0 [mol%], and 7.0 [mol%], respectively, in terms of mole percentage based on oxides.

### (Example 38)

Phosphate glass PGS-38 in Example 38 was produced in the same manner as in Example 1 except that 85% H₃PO₄, ZnO, Al(OH)₃, La₂O₃, KPO₃, Ba(OH)₂·8H₂O, and SiO₂ were weighed so that the contents of P₂O₅, ZnO, Al₂O₃, La₂O₃, K₂O, BaO, and SiO₂ were 56.7 [mol%], 11.7 [mol%], 0.7 [mol%], 0.7 [mol%], 11.9 [mol%], 9.8 [mol%], and 8.5 [mol%], respectively, in terms of mole percentage based on oxides.

### (Example 39)

Phosphate glass PGS-39 in Example 39 was produced in the same manner as in Example 1 except that 85% H₃PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 60.0 [mol%], 20.0 [mol%], 2.0 [mol%], 3.0 [mol%], 6.0 [mol%], and 9.0 [mol%], respectively, in terms of mole percentage based on oxides.

### (Example 40)

Phosphate glass PGS-40 in Example 40 was produced in the same manner as in Example 1 except that 85% H₃PO₄, ZnO, La₂O₃, Ga₂O₃, KPO₃, and Ba(OH)₂·8H₂O were weighed so that the contents of P₂O₅, ZnO, La₂O₃, Ga₂O₃, K₂O, and BaO were 61.0 [mol%], 20.5 [mol%], 1.5 [mol%], 2.0 [mol%], 6.0 [mol%], and 9.0 [mol%], respectively, in terms of mole percentage based on oxides.

### (Example 41)

Phosphate glass PGS-41 in Example 41 was produced in the same manner as in Example 1 except that 85% H₃PO₄, ZnO, La₂O₃, KPO₃, Ba(OH)₂·8H₂O, and Y₂O₃ were weighed so that the contents of P₂O₅, ZnO, La₂O₃, K₂O, BaO, and Y₂O₃ were 60.0 [mol%], 20.0 [mol%], 3.0 [mol%], 6.0 [mol%], 9.0 [mol%], and 2.0 [mol%], respectively, in terms of mole percentage based on oxides.

### (Example 42)

Phosphate glass PGS-42 in Example 42 was produced in the same manner as in Example 1 except that 85% H₃PO₄, ZnO, Lu₂O₃, Ga₂O₃, KPO₃, and Ba(OH)₂·8H₂O were weighed so that the contents of P₂O₅, ZnO, Lu₂O₃, Ga₂O₃, K₂O, and BaO were 60.0 [mol%], 20.0 [mol%], 1.0 [mol%], 2.0 [mol%], 7.0 [mol%], and 10.0 [mol%], respectively, in terms of mole percentage based on oxides.

### (Example 43)

Phosphate glass PGS-43 in Example 43 was produced in the same manner as in Example 1 except that 85% H₃PO₄, ZnO, La₂O₃, Ga₂O₃, KPO₃, and Ba(OH)₂·8H₂O were weighed so that the contents of P₂O₅, ZnO, La₂O₃, Ga₂O₃, K₂O, and BaO were 60.0 [mol%], 20.0 [mol%], 2.0 [mol%], 2.0 [mol%], 7.0 [mol%], and 9.0 [mol%], respectively, in terms of mole percentage based on oxides.

### (Example 44)

Phosphate glass PGS-44 in Example 44 was produced in the same manner as in Example 1 except that 85% H₃PO₄, ZnO, Al₂O₃, La₂O₃, LiPO₃, NaPO₃, KPO₃, and Ba(OH)₂·8H₂O were weighed so that the contents of P₂O₅, ZnO, Al₂O₃, La₂O₃, Li₂O, Na₂O, K₂O, and BaO were 60.0 [mol%], 20.0 [mol%], 1.5 [mol%], 1.5 [mol%], 1.0 [mol%], 1.0 [mol%], 6.0 [mol%], and 9.0 [mol%], respectively, in terms of mole percentage based on oxides.

### (Example 45)

Phosphate glass PGS-45 in Example 45 was produced in the same manner as in Example 1 except that 85% H₃PO₄, ZnO, Al₂O₃, La₂O₃, KPO₃, and Ca(H₂PO₄)₂·H₂O were weighed so that the contents of P₂O₅, ZnO, Al₂O₃, La₂O₃, K₂O, and CaO were 60.0 [mol%], 20.0 [mol%], 2.0 [mol%], 2.0 [mol%], 8.0 [mol%], and 8.0 [mol%], respectively, in terms of mole percentage based on oxides.

### (Example 46)

Phosphate glass PGS-46 in Example 46 was produced in the same manner as in Example 1 except that 85% H₃PO₄, ZnO, Al₂O₃, La₂O₃, KPO₃, Ba(OH)₂·8H₂O, and SnO were weighed so that the contents of P₂O₅, ZnO, Al₂O₃, La₂O₃, K₂O, BaO, and SnO were 60.0 [mol%], 20.0 [mol%], 1.0 [mol%], 2.0 [mol%], 7.0 [mol%], 9.0 [mol%], and 1.0 [mol%], respectively, in terms of mole percentage based on oxides.

### (Example 47)

Phosphate glass PGS-47 in Example 47 was produced in the same manner as in Example 1 except that 85% H₃PO₄, ZnO, Al₂O₃, La₂O₃, KPO₃, and MgO were weighed so that the contents of P₂O₅, ZnO, Al₂O₃, La₂O₃, K₂O, and MgO were 60.0 [mol%], 20.0 [mol%], 1.5 [mol%], 3.0 [mol%], 9.0 [mol%], and 6.5 [mol%], respectively, in terms of mole percentage based on oxides.

### (Example 48)

Phosphate glass PGS-48 in Example 48 was produced in the same manner as in Example 1 except that 85% H₃PO₄, ZnO, Al₂O₃, La₂O₃, Ga₂O₃, and KPO₃ were weighed so that the contents of P₂O₅, ZnO, Al₂O₃, La₂O₃, Ga₂O₃, and K₂O were 62.5 [mol%], 22.0 [mol%], 1.5 [mol%], 2.0 [mol%], 2.0 [mol%], and 10.0 [mol%], respectively, in terms of mole percentage based on oxides.

### (Example 49)

Phosphate glass PGS-49 in Example 49 was produced in the same manner as in Example 1 except that 85% H₃PO₄, ZnO, Al₂O₃, La₂O₃, Ga₂O₃, KPO₃, and Ba(OH)₂·8H₂O were weighed so that the contents of P₂O₅, ZnO, Al₂O₃, La₂O₃, Ga₂O₃, K₂O, and BaO were 60.0 [mol%], 20.0 [mol%], 1.5 [mol%], 2.5 [mol%], 1.0 [mol%], 7.0 [mol%], and 8.0 [mol%], respectively, in terms of mole percentage based on oxides.

### (Example 50)

Phosphate glass PGS-50 in Example 50 was produced in the same manner as in Example 1 except that 85% H₃PO₄, ZnO, Al₂O₃, La₂O₃, KPO₃, Ba(OH)₂·8H₂O, and SiO₂ were weighed so that the contents of P₂O₅, ZnO, Al₂O₃, La₂O₃, K₂O, BaO, and SiO₂ were 60.0 [mol%], 20.0 [mol%], 1.5 [mol%], 2.5 [mol%], 6.0 [mol%], 9.0 [mol%], and 1.0 [mol%], respectively, in terms of mole percentage based on oxides.

### (Example 51)

Phosphate glass PGS-51 in Example 51 was produced in the same manner as in Example 1 except that 85% H₃PO₄, ZnO, Al₂O₃, La₂O₃, KPO₃, and SiO₂ were weighed so that the contents of P₂O₅, ZnO, Al₂O₃, La₂O₃, K₂O, and SiO₂ were 62.5 [mol%], 21.0 [mol%], 2.0 [mol%], 3.0 [mol%], 10.0 [mol%], and 1.5 [mol%], respectively, in terms of mole percentage based on oxides.

### (Example 52)

Phosphate glass PGS-52 in Example 52 was produced in the same manner as in Example 1 except that (NH₄)H₂PO₄, ZnO, Al₂O₃, La₂O₃, and KPO₃ were weighed so that the contents of P₂O₅, ZnO, Al₂O₃, La₂O₃, and K₂O were 63.0 [mol%], 22.0 [mol%], 2.0 [mol%], 3.0 [mol%], and 10.0 [mol%], respectively, in terms of mole percentage based on oxides.

### (Example 53)

Phosphate glass PGS-53 in Example 53 was produced in the same manner as in Example 1 except that 85% H₃PO₄, ZnO, Al₂O₃, Lu₂O₃, KPO₃, and Ba(OH)₂·8H₂O were weighed so that the contents of P₂O₅, ZnO, Al₂O₃, Lu₂O₃, K₂O, and BaO were 61.0 [mol%], 20.0 [mol%], 2.0 [mol%], 3.0 [mol%], 6.0 [mol%], and 8.0 [mol%], respectively, in terms of mole percentage based on oxides.

### (Example 54)

Phosphate glass PGS-54 in Example 54 was produced in the same manner as in Example 1 except that 85% H₃PO₄, ZnO, Al₂O₃, La₂O₃, Ga₂O₃, KPO₃, Ba(OH)₂·8H₂O, and Cu₂O were weighed so that the contents of P₂O₅, ZnO, Al₂O₃, La₂O₃, Ga₂O₃, K₂O, BaO, and CU₂O were 60.0 [mol%], 20.0 [mol%], 1.0 [mol%], 1.0 [mol%], 1.0 [mol%], 7.0 [mol%], 9.0 [mol%], and 1.0 [mol%], respectively, in terms of mole percentage based on oxides.

### (Example 55)

Phosphate glass PGS-55 in Example 55 was produced in the same manner as in Example 1 except that 85% H₃PO₄, ZnO, Al₂O₃, La₂O₃, Ga₂O₃, KPO₃, Ba(OH)₂·8H₂O, and Ag₂O were weighed so that the contents of P₂O₅, ZnO, Al₂O₃, La₂O₃, Ga₂O₃, K₂O, BaO, and Ag₂O were 60.0 [mol%], 20.0 [mol%], 1.0 [mol%], 1.0 [mol%], 1.0 [mol%], 7.0 [mol%], 9.0 [mol%], and 1.0 [mol%], respectively, in terms of mole percentage based on oxides.

### (Example 56)

Phosphate glass PGS-56 in Example 56 was produced in the same manner as in Example 1 except that 85% H₃PO₄, ZnO, Al₂O₃, La₂O₃, Ga₂O₃, KPO₃, Ba(OH)₂·8H₂O, and MnO were weighed so that the contents of P₂O₅, ZnO, Al₂O₃, La₂O₃, Ga₂O₃, K₂O, BaO, and MnO were 60.0 [mol%], 20.0 [mol%], 1.0 [mol%], 1.0 [mol%], 1.0 [mol%], 7.0 [mol%], 9.0 [mol%], and 1.0 [mol%], respectively, in terms of mole percentage based on oxides.

### (Example 57)

Phosphate glass PGS-57 in Example 57 was produced in the same manner as in Example 1 except that 85% H₃PO₄, ZnO, Al₂O₃, La₂O₃, Ga₂O₃, KPO₃, Ba(OH)₂·8H₂O, and Cu₂O were weighed so that the contents of P₂O₅, ZnO, Al₂O₃, La₂O₃, Ga₂O₃, K₂O, BaO, and CU₂O were 60.0 [mol%], 20.0 [mol%], 1.0 [mol%], 1.0 [mol%], 1.9 [mol%], 7.0 [mol%], 9.0 [mol%], and 0.1 [mol%], respectively, in terms of mole percentage based on oxides.

### (Example 58)

Phosphate glass PGS-58 in Example 58 was produced in the same manner as in Example 1 except that (NH₄)H₂PO₄, ZnO, Al₂O₃, La₂O₃, Ga₂O₃, KPO₃, Ba(OH)₂·8H₂O, and Ag₂O were weighed so that the contents of P₂O₅, ZnO, Al₂O₃, La₂O₃, Ga₂O₃, K₂O, BaO, and Ag₂O were 60.0 [mol%], 20.0 [mol%], 1.0 [mol%], 1.0 [mol%], 1.9 [mol%], 7.0 [mol%], 9.0 [mol%], and 0.1 [mol%], respectively, in terms of mole percentage based on oxides.

### (Example 59)

Phosphate glass PGS-59 in Example 59 was produced in the same manner as in Example 1 except that (NH₄)H₂PO₄, ZnO, Al₂O₃, La₂O₃, Ga₂O₃, KPO₃, Ba(OH)₂·8H₂O, and MnO were weighed so that the contents of P₂O₅, ZnO, Al₂O₃, La₂O₃, Ga₂O₃, K₂O, BaO, and MnO were 60.0 [mol%], 20.0 [mol%], 1.0 [mol%], 1.0 [mol%], 1.9 [mol%], 7.0 [mol%], 9.0 [mol%], and 0.1 [mol%], respectively, in terms of mole percentage based on oxides.

### (Example 60)

Phosphate glass PGS-60 in Example 60 was produced in the same manner as in Example 1 except that (NH₄)H₂PO₄, ZnO, Al₂O₃, La₂O₃, Ga₂O₃, KPO₃, and Ba(OH)₂·8H₂O were weighed so that the contents of P₂O₅, ZnO, Al₂O₃, La₂O₃, Ga₂O₃, K₂O, and BaO were 60.0 [mol%], 20.0 [mol%], 1.0 [mol%], 1.0 [mol%], 2.0 [mol%], 7.0 [mol%], and 9.0 [mol%], respectively, in terms of mole percentage based on oxides.

### (Comparative Example 1)

Phosphate glass PGS-Comp-1 in Comparative Example 1 was produced in the same manner as in Example 1 except that 85% H₃PO₄ and ZnO were weighed so that the contents of P₂O₅ and ZnO were 50.0 [mol%] and 50.0 [mol%], respectively, in terms of mole percentage based on oxides.

### (Comparative Example 2)

Phosphate glass PGS-Comp-2 in Comparative Example 2 was produced in the same manner as in Example 1 except that 85% H₃PO₄, ZnO, and Ba(OH)₂·8H₂O were weighed so that the contents of P₂O₅, ZnO, and BaO were 60.0 [mol%], 30.0 [mol%], and 10.0 [mol%], respectively, in terms of mole percentage based on oxides.

### (Comparative Example 3)

Phosphate glass PGS-Comp-3 in Comparative Example 3 was produced in the same manner as in Example 1 except that 85% H₃PO₄, ZnO, KPO₃, and Ba(OH)₂·8H₂O were weighed so that the contents of P₂O₅, ZnO, K₂O, and BaO were 59.1 [mol%], 27.3 [mol%], 4.5 [mol%], and 9.1 [mol%], respectively, in terms of mole percentage based on oxides.

### (Comparative Example 4)

Phosphate glass PGS-Comp-4 in Comparative Example 4 was produced in the same manner as in Example 1 except that 85% H₃PO₄, ZnO, KPO₃, and Ba(OH)₂·8H₂O were weighed so that the contents of P₂O₅, ZnO, K₂O, and BaO were 57.9 [mol%], 26.3 [mol%], 5.3 [mol%], and 10.5 [mol%], respectively, in terms of mole percentage based on oxides.

### (Comparative Example 5)

Phosphate glass PGS-Comp-5 in Comparative Example 5 was produced in the same manner as in Example 1 except that 85% H₃PO₄, ZnO, and Ba(OH)₂·8H₂O were weighed so that the contents of P₂O₅, ZnO, and BaO were 58.8 [mol%], 29.4 [mol%], and 11.8 [mol%], respectively, in terms of mole percentage based on oxides.

### (Comparative Example 6)

Phosphate glass PGS-Comp-6 in Comparative Example 6 was produced in the same manner as in Example 1 except that 85% H₃PO₄, ZnO, Al(OH)₃, KPO₃, and Ba(OH)₂·8H₂O were weighed so that the contents of P₂O₅, ZnO, Al₂O₃, K₂O, and BaO were 59.5 [mol%], 21.6 [mol%], 2.7 [mol%], 5.4 [mol%], and 10.8 [mol%], respectively, in terms of mole percentage based on oxides.

### (Comparative Example 7)

Phosphate glass PGS-Comp-7 in Comparative Example 7 was produced in the same manner as in Example 1 except that 85% H₃PO₄, ZnO, Al(OH)₃, KPO₃, and Ba(OH)₂·8H₂O were weighed so that the contents of P₂O₅, ZnO, Al₂O₃, K₂O, and BaO were 62.9 [mol%], 22.9 [mol%], 2.9 [mol%], 5.6 [mol%], and 5.7 [mol%], respectively, in terms of mole percentage based on oxides.

### (Comparative Example 8)

Phosphate glass PGS-Comp-8 in Comparative Example 8 was produced in the same manner as in Example 1 except that 85% H₃PO₄, ZnO, Al(OH)₃, KPO₃, and Ba(OH)₂·8H₂O were weighed so that the contents of P₂O₅, ZnO, Al₂O₃, K₂O, and BaO were 61.1 [mol%], 22.2 [mol%], 5.6 [mol%], 5.5 [mol%], and 5.6 [mol%], respectively, in terms of mole percentage based on oxides.

### (Comparative Example 9)

Phosphate glass PGS-Comp-9 in Comparative Example 9 was produced in the same manner as in Example 1 except that 85% H₃PO₄, ZnO, La₂O₃, KPO₃, and Ba(OH)₂·8H₂O were weighed so that the contents of P₂O₅, ZnO, La₂O₃, K₂O, and BaO were 62.9 [mol%], 22.9 [mol%], 2.9 [mol%], 5.6 [mol%], and 5.7 [mol%], respectively, in terms of mole percentage based on oxides.

### (Comparative Example 10)

Phosphate glass PGS-Comp-10 in Comparative Example 10 was produced in the same manner as in Example 1 except that 85% H₃PO₄, ZnO, La₂O₃, KPO₃, and Ba(OH)₂·8H₂O were weighed so that the contents of P₂O₅, ZnO, La₂O₃, K₂O, and BaO were 59.1 [mol%], 21.5 [mol%], 5.4 [mol%], 5.4 [mol%], and 8.6 [mol%], respectively, in terms of mole percentage based on oxides.

### (Comparative Example 11)

Phosphate glass PGS-Comp-11 in Comparative Example 11 was produced in the same manner as in Example 1 except that 85% H₃PO₄, ZnO, La₂O₃, KPO₃, and Ba(OH)₂·8H₂O were weighed so that the contents of P₂O₅, ZnO, La₂O₃, K₂O, and BaO were 58.7 [mol%], 20.4 [mol%], 5.1 [mol%], 7.7 [mol%], and 8.1 [mol%], respectively, in terms of mole percentage based on oxides.

### (Comparative Example 12)

Phosphate glass PGS-Comp-12 in Comparative Example 12 was produced in the same manner as in Example 1 except that 85% H₃PO₄, ZnO, Al(OH)₃, La₂O₃, KPO₃, Ba(OH)₂·8H₂O, and SnO were weighed so that the contents of P₂O₅, ZnO, Al₂O₃, La₂O₃, K₂O, BaO, and SnO were 62.8 [mol%], 5.8 [mol%], 2.9 [mol%], 2.9 [mol%], 4.7 [mol%], 9.3 [mol%], and 11.6 [mol%], respectively, in terms of mole percentage based on oxides.

### (Comparative Example 13)

Phosphate glass PGS-Comp-13 in Comparative Example 13 was produced in the same manner as in Example 1 except that 85% H₃PO₄, ZnO, Al(OH)₃, La₂O₃, KPO₃, Ba(OH)₂·8H₂O, and SnO were weighed so that the contents of P₂O₅, ZnO, Al₂O₃, La₂O₃, K₂O, BaO, and SnO were 53.5 [mol%], 14.9 [mol%], 2.5 [mol%], 2.5 [mol%], 4.0 [mol%], 7.8 [mol%], and 14.8 [mol%], respectively, in terms of mole percentage based on oxides.

### (Comparative Example 14)

Phosphate glass PGS-Comp-14 in Comparative Example 14 was produced in the same manner as in Example 1 except that 85% H₃PO₄, ZnO, Al(OH)₃, La₂O₃, KPO₃, Ba(OH)₂. 8H₂O, and SnO were weighed so that the contents of P₂O₅, ZnO, Al₂O₃, La₂O₃, K₂O, BaO, and SnO were 59.3 [mol%], 5.5 [mol%], 2.7 [mol%], 2.7 [mol%], 4.5 [mol%], 8.8 [mol%], and 16.5 [mol%], respectively, in terms of mole percentage based on oxides.

In Examples 1 to 60 and Comparative Examples 1 to 14, phosphate glass was produced through melting at a temperature of 500°C.

### (Example 61)

Each of (NH₄)H₂PO₄, ZnO, Al(OH)₃, La₂O₃, KPO₃, and Ba(OH)₂·8H₂O was weighed so that the contents of P₂O₅, ZnO, Al₂O₃, La₂O₃, K₂O, and BaO were 58.5 [mol%], 22.1 [mol%], 2.9 [mol%], 2.2 [mol%], 5.5 [mol%], and 8.8 [mol%], respectively, in terms of mole percentage based on oxides.

Then, the weighed raw materials were mixed, and the resulting mixture was heated at 400°C for 20 minutes in the air. Next, the heated precursor was put into a high-speed heating electric furnace of model number SH manufactured by MOTOYAMA, heated at 800°C for 15 minutes, and then naturally cooled to produce phosphate glass PGS-61 in Example 61.

### (Example 62)

Phosphate glass PGS-62 in Example 62 was produced in the same manner as in Example 61 except that (NH₄)H₂PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 57.1 [mol%], 21.0 [mol%], 2.4 [mol%], 2.4 [mol%], 9.5 [mol%], and 7.6 [mol%], respectively, in terms of mole percentage based on oxides.

### (Example 63)

Phosphate glass PGS-63 in Example 63 was produced in the same manner as in Example 61 except that (NH₄)H₂PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 57.6 [mol%], 13.1 [mol%], 6.1 [mol%], 3.0 [mol%], 10.1 [mol%], and 10.1 [mol%], respectively, in terms of mole percentage based on oxides.

### (Example 64)

Phosphate glass PGS-64 in Example 64 was produced in the same manner as in Example 61 except that (NH₄)H₂PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 58.5 [mol%], 14.6 [mol%], 4.9 [mol%], 2.4 [mol%], 9.8 [mol%], and 9.8 [mol%], respectively, in terms of mole percentage based on oxides.

### (Example 65)

Phosphate glass PGS-65 in Example 65 was produced in the same manner as in Example 61 except that (NH₄)H₂PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 62.8 [mol%], 17.4 [mol%], 2.9 [mol%], 2.9 [mol%], 4.7 [mol%], and 9.3 [mol%], respectively, in terms of mole percentage based on oxides.

### (Example 66)

Phosphate glass PGS-66 in Example 66 was produced in the same manner as in Example 61 except that (NH₄)H₂PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 56.1 [mol%], 25.5 [mol%], 2.55 [mol%], 2.55 [mol%], 5.1 [mol%], and 8.2 [mol%], respectively, in terms of mole percentage based on oxides.

### (Example 67)

Phosphate glass PGS-67 in Example 67 was produced in the same manner as in Example 61 except that (NH₄)H₂PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 55.8 [mol%], 24.3 [mol%], 2.4 [mol%], 2.4 [mol%], 7.3 [mol%], and 7.8 [mol%], respectively, in terms of mole percentage based on oxides.

### (Example 68)

Phosphate glass PGS-68 in Example 68 was produced in the same manner as in Example 61 except that (NH₄)H₂PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 59.6 [mol%], 20.7 [mol%], 2.6 [mol%], 1.0 [mol%], 7.8 [mol%], and 8.3 [mol%], respectively, in terms of mole percentage based on oxides.

### (Example 69)

Phosphate glass PGS-69 in Example 69 was produced in the same manner as in Example 61 except that (NH₄)H₂PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 59.6 [mol%], 21.6 [mol%], 2.7 [mol%], 2.2 [mol%], 5.4 [mol%], and 8.6 [mol%], respectively, in terms of mole percentage based on oxides.

### (Example 70)

Phosphate glass PGS-70 in Example 70 was produced in the same manner as in Example 61 except that (NH₄)H₂PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 62.5 [mol%], 21.7 [mol%], 2.7 [mol%], 2.2 [mol%], 5.5 [mol%], and 5.4 [mol%], respectively, in terms of mole percentage based on oxides.

### (Example 71)

Phosphate glass PGS-71 in Example 71 was produced in the same manner as in Example 61 except that (NH₄)H₂PO₄, ZnO, Al(OH)₃, La₂O₃, Lu₂O₃, KPO₃, and Ba(OH)₂·8H₂O were weighed so that the contents of P₂O₅, ZnO, Al₂O₃, La₂O₃, Lu₂O₃, K₂O, and BaO were 60.0 [mol%], 20.0 [mol%], 1.5 [mol%], 2.0 [mol%], 1.5 [mol%], 6.0 [mol%], and 9.0 [mol%], respectively, in terms of mole percentage based on oxides.

### (Example 72)

Phosphate glass PGS-72 in Example 72 was produced in the same manner as in Example 61 except that (NH₄)H₂PO₄, ZnO, Al(OH)₃, La₂O₃, KPO₃, Ba(OH)₂·8H₂O, and Y₂O₃ were weighed so that the contents of P₂O₅, ZnO, Al₂O₃, La₂O₃, K₂O, BaO, and Y₂O₃ were 60.0 [mol%], 20.0 [mol%], 1.5 [mol%], 1.5 [mol%], 6.0 [mol%], 9.0 [mol%], and 2.0 [mol%], respectively, in terms of mole percentage based on oxides.

### (Example 73)

Phosphate glass PGS-73 in Example 73 was produced in the same manner as in Example 61 except that (NH₄)H₂PO₄, ZnO, Al(OH)₃, La₂O₃, Ga₂O₃, KPO₃, Ba(OH)₂. 8H₂O, and Y₂O₃ were weighed so that the contents of P₂O₅, ZnO, Al₂O₃, La₂O₃, Ga₂O₃, K₂O, BaO, and Y₂O₃ were 60.0 [mol%], 20.0 [mol%], 1.0 [mol%], 1.5 [mol%], 0.5 [mol%], 6.0 [mol%], 9.0 [mol%], and 2.0 [mol%], respectively, in terms of mole percentage based on oxides.

### (Example 74)

Phosphate glass PGS-74 in Example 74 was produced in the same manner as in Example 61 except that (NH₄)H₂PO₄, ZnO, La₂O₃, Ga₂O₃, KPO₃, and Ba(OH)₂·8H₂O were weighed so that the contents of P₂O₅, ZnO, La₂O₃, Ga₂O₃, K₂O, and BaO were 62.5 [mol%], 21.7 [mol%], 2.2 [mol%], 2.7 [mol%], 5.5 [mol%], and 5.4 [mol%], respectively, in terms of mole percentage based on oxides.

### (Example 75)

Phosphate glass PGS-75 in Example 75 was produced in the same manner as in Example 61 except that (NH₄)H₂PO₄, ZnO, Al(OH)₃, Lu₂O₃, Ga₂O₃, KPO₃, and Ba(OH)₂·8H₂O were weighed so that the contents of P₂O₅, ZnO, Al₂O₃, Lu₂O₃, Ga₂O₃, K₂O, and BaO were 60.0 [mol%], 20.0 [mol%], 2.0 [mol%], 1.0 [mol%], 2.0 [mol%], 6.0 [mol%], and 9.0 [mol%], respectively, in terms of mole percentage based on oxides.

### (Example 76)

Phosphate glass PGS-76 in Example 76 was produced in the same manner as in Example 61 except that (NH₄)H₂PO₄, ZnO, Al(OH)₃, Lu₂O₃, Ga₂O₃, KPO₃, Ba(OH)₂. 8H₂O, and Y₂O₃ were weighed so that the contents of P₂O₅, ZnO, Al₂O₃, Lu₂O₃, Ga₂O₃, K₂O, BaO, and Y₂O₃ were 60.0 [mol%], 20.0 [mol%], 1.5 [mol%], 1.5 [mol%], 1.0 [mol%], 6.0 [mol%], 9.0 [mol%], and 1.0 [mol%], respectively, in terms of mole percentage based on oxides.

### (Example 77)

Phosphate glass PGS-77 in Example 77 was produced in the same manner as in Example 61 except that (NH₄)H₂PO₄, ZnO, Al(OH)₃, Lu₂O₃, KPO₃, Ba(OH)₂·8H₂O, and Y₂O₃ were weighed so that the contents of P₂O₅, ZnO, Al₂O₃, Lu₂O₃, K₂O, BaO, and Y₂O₃ were 60.0 [mol%], 20.0 [mol%], 1.5 [mol%], 1.5 [mol%], 6.0 [mol%], 9.0 [mol%], and 2.0 [mol%], respectively, in terms of mole percentage based on oxides.

### (Example 78)

Phosphate glass PGS-78 in Example 78 was produced in the same manner as in Example 61 except that (NH₄)₂HPO₄, ZnO, La₂O₃, KPO₃, Ba(OH)₂·8H₂O, and Y₂O₃ were weighed so that the contents of P₂O₅, ZnO, La₂O₃, K₂O, BaO, and Y₂O₃ were 62.5 [mol%], 21.7 [mol%], 2.2 [mol%], 5.5 [mol%], 5.4 [mol%], and 2.7 [mol%], respectively, in terms of mole percentage based on oxides.

### (Example 79)

Phosphate glass PGS-79 in Example 79 was produced in the same manner as in Example 61 except that (NH₄)₂HPO₄, ZnO, La₂O₃, KPO₃, Ba(OH)₂·8H₂O, and Y₂O₃ were weighed so that the contents of P₂O₅, ZnO, La₂O₃, K₂O, BaO, and Y₂O₃ were 60.0 [mol%], 20.0 [mol%], 3.0 [mol%], 6.0 [mol%], 9.0 [mol%], and 2.0 [mol%], respectively, in terms of mole percentage based on oxides.

### (Example 80)

Phosphate glass PGS-80 in Example 80 was produced in the same manner as in Example 61 except that (NH₄)₂HPO₄, ZnO, La₂O₃, Ga₂O₃, KPO₃, Ba(OH)₂·8H₂O, and Y₂O₃ were weighed so that the contents of P₂O₅, ZnO, La₂O₃, Ga₂O₃, K₂O, BaO, and Y₂O₃ were 60.0 [mol%], 20.0 [mol%], 1.0 [mol%], 2.0 [mol%], 6.0 [mol%], 9.0 [mol%], and 2.0 [mol%], respectively, in terms of mole percentage based on oxides.

### (Example 81)

Phosphate glass PGS-81 in Example 81 was produced in the same manner as in Example 61 except that (NH₄)₂HPO₄, ZnO, Lu₂O₃, KPO₃, Ba(OH)₂·8H₂O, and Y₂O₃ were weighed so that the contents of P₂O₅, ZnO, Lu₂O₃, K₂O, BaO, and Y₂O₃ were 60.0 [mol%], 20.0 [mol%], 3.0 [mol%], 6.0 [mol%], 9.0 [mol%], and 2.0 [mol%], respectively, in terms of mole percentage based on oxides.

### (Example 82)

Phosphate glass PGS-82 in Example 82 was produced in the same manner as in Example 61 except that (NH₄)H₂PO₄, ZnO, Lu₂O₃, Ga₂O₃, KPO₃, and Ba(OH)₂·8H₂O were weighed so that the contents of P₂O₅, ZnO, Lu₂O₃, Ga₂O₃, K₂O, and BaO were 62.8 [mol%], 17.4 [mol%], 2.9 [mol%], 2.9 [mol%], 4.7 [mol%], and 9.3 [mol%], respectively, in terms of mole percentage based on oxides.

### (Example 83)

Phosphate glass PGS-83 in Example 83 was produced in the same manner as in Example 61 except that (NH₄)H₂PO₄, ZnO, Lu₂O₃, Ga₂O₃, KPO₃, Ba(OH)₂·8H₂O, and Y₂O₃ were weighed so that the contents of P₂O₅, ZnO, Lu₂O₃, Ga₂O₃, K₂O, BaO, and Y₂O₃ were 60.0 [mol%], 20.0 [mol%], 1.0 [mol%], 2.0 [mol%], 6.0 [mol%], 9.0 [mol%], and 2.0 [mol%], respectively, in terms of mole percentage based on oxides.

### (Example 84)

Phosphate glass PGS-84 in Example 84 was produced in the same manner as in Example 61 except that (NH₄)H₂PO₄, ZnO, La₂O₃, Ga₂O₃, KPO₃, and Ba(OH)₂·8H₂O were weighed so that the contents of P₂O₅, ZnO, La₂O₃, Ga₂O₃, K₂O, and BaO were 62.8 [mol%], 17.4 [mol%], 2.9 [mol%], 2.9 [mol%], 4.7 [mol%], and 9.3 [mol%], respectively, in terms of mole percentage based on oxides.

### (Example 85)

Phosphate glass PGS-85 in Example 85 was produced in the same manner as in Example 61 except that (NH₄)H₂PO₄, ZnO, Al(OH)₃, La₂O₃, LiPO₃, NaPO₃, KPO₃, and Ba(OH)₂·8H₂O were weighed so that the contents of P₂O₅, ZnO, Al₂O₃, La₂O₃, Li₂O, Na₂O, K₂O, and BaO were 62.5 [mol%], 21.8 [mol%], 2.7 [mol%], 2.2 [mol%], 1.8 [mol%], 1.8 [mol%], 1.8 [mol%], and 5.4 [mol%], respectively, in terms of mole percentage based on oxides.

### (Example 86)

Phosphate glass PGS-86 in Example 86 was produced in the same manner as in Example 61 except that (NH₄)H₂PO₄, ZnO, Al(OH)₃, La₂O₃, LiPO₃, NaPO₃, KPO₃, and Ba(OH)₂·8H₂O were weighed so that the contents of P₂O₅, ZnO, Al₂O₃, La₂O₃, Li₂O, Na₂O, K₂O, and BaO were 60.2 [mol%], 20.9 [mol%], 2.6 [mol%], 2.6 [mol%], 1.8 [mol%], 1.8 [mol%], 1.8 [mol%], and 8.3 [mol%], respectively, in terms of mole percentage based on oxides.

### (Example 87)

Phosphate glass PGS-87 in Example 87 was produced in the same manner as in Example 61 except that (NH₄)H₂PO₄, ZnO, Al(OH)₃, La₂O₃, and LiPO₃ were weighed so that the contents of P₂O₅, ZnO, Al₂O₃, La₂O₃, and Li₂O were 62.5 [mol%], 21.5 [mol%], 1.5 [mol%], 2.5 [mol%], and 12.0 [mol%], respectively, in terms of mole percentage based on oxides.

### (Example 88)

Phosphate glass PGS-88 in Example 88 was produced in the same manner as in Example 61 except that (NH₄)H₂PO₄, ZnO, Al(OH)₃, La₂O₃, and NaPO₃ were weighed so that the contents of P₂O₅, ZnO, Al₂O₃, La₂O₃, and Na₂O were 62.5 [mol%], 21.5 [mol%], 1.5 [mol%], 2.5 [mol%], and 12.0 [mol%], respectively, in terms of mole percentage based on oxides.

### (Example 89)

Phosphate glass PGS-89 in Example 89 was produced in the same manner as in Example 61 except that (NH₄)H₂PO₄, ZnO, Al(OH)₃, La₂O₃, NaPO₃, and KPO₃ were weighed so that the contents of P₂O₅, ZnO, Al₂O₃, La₂O₃, Na₂O, and K₂O were 62.0 [mol%], 21.0 [mol%], 2.0 [mol%], 3.0 [mol%], 6.0 [mol%], and 6.0 [mol%], respectively, in terms of mole percentage based on oxides.

### (Example 90)

Phosphate glass PGS-90 in Example 90 was produced in the same manner as in Example 61 except that (NH₄)H₂PO₄, ZnO, Al(OH)₃, La₂O₃, KPO₃, and Ca(H₂PO₄)₂·H₂O were weighed so that the contents of P₂O₅, ZnO, Al₂O₃, La₂O₃, K₂O, and CaO were 62.1 [mol%], 22.6 [mol%], 2.8 [mol%], 1.1 [mol%], 5.7 [mol%], and 5.7 [mol%], respectively, in terms of mole percentage based on oxides.

### (Example 90-2)

Phosphate glass PGS-90-2 in Example 90-2 was produced in the same manner as in Example 61 except that (NH₄)H₂PO₄, ZnO, Al₂O₃, La₂O₃, KPO₃, and SrO were weighed so that the contents of P₂O₅, ZnO, Al₂O₃, La₂O₃, K₂O, and SrO were 62.1 [mol%], 22.6 [mol%], 2.8 [mol%], 1.1 [mol%], 5.7 [mol%], and 5.7 [mol%], respectively, in terms of mole percentage based on oxides.

### (Example 91)

Phosphate glass PGS-91 in Example 91 was produced in the same manner as in Example 61 except that (NH₄)₂HPO₄, ZnO, Al(OH)₃, La₂O₃, KPO₃, Ba(OH)₂·8H₂O, and SnO were weighed so that the contents of P₂O₅, ZnO, Al₂O₃, La₂O₃, K₂O, BaO, and SnO were 57.1 [mol%], 15.8 [mol%], 2.6 [mol%], 2.6 [mol%], 4.3 [mol%], 8.5 [mol%], and 9.1 [mol%], respectively, in terms of mole percentage based on oxides.

### (Example 92)

Phosphate glass PGS-92 in Example 92 was produced in the same manner as in Example 61 except that (NH₄)H₂PO₄, ZnO, Al(OH)₃, La₂O₃, KPO₃, and MgO were weighed so that the contents of P₂O₅, ZnO, Al₂O₃, La₂O₃, K₂O, and MgO were 59.0 [mol%], 20.0 [mol%], 1.0 [mol%], 3.0 [mol%], 14.0 [mol%], and 3.0 [mol%], respectively, in terms of mole percentage based on oxides.

### (Example 93)

Phosphate glass PGS-93 in Example 93 was produced in the same manner as in Example 61 except that (NH₄)H₂PO₄, ZnO, Al(OH)₃, La₂O₃, and KPO₃ were weighed so that the contents of P₂O₅, ZnO, Al₂O₃, La₂O₃, and K₂O were 59.0 [mol%], 20.0 [mol%], 3.5 [mol%], 3.0 [mol%], and 14.5 [mol%], respectively, in terms of mole percentage based on oxides.

### (Example 94)

Phosphate glass PGS-94 in Example 94 was produced in the same manner as in Example 61 except that (NH₄)H₂PO₄, ZnO, Al(OH)₃, La₂O₃, Ga₂O₃, KPO₃, and Ba(OH)₂·8H₂O were weighed so that the contents of P₂O₅, ZnO, Al₂O₃, La₂O₃, Ga₂O₃, K₂O, and BaO were 62.8 [mol%], 17.4 [mol%], 1.4 [mol%], 2.9 [mol%], 1.5 [mol%], 4.7 [mol%], and 9.3 [mol%], respectively, in terms of mole percentage based on oxides.

### (Example 95)

Phosphate glass PGS-95 in Example 95 was produced in the same manner as in Example 61 except that (NH₄)H₂PO₄, ZnO, Al(OH)₃, La₂O₃, KPO₃, Ba(OH)₂·8H₂O, and SiO₂ were weighed so that the contents of P₂O₅, ZnO, Al₂O₃, La₂O₃, K₂O, BaO, and SiO₂ were 58.5 [mol%], 22.0 [mol%], 2.9 [mol%], 2.2 [mol%], 5.5 [mol%], 8.8 [mol%], and 0.1 [mol%], respectively, in terms of mole percentage based on oxides.

### (Example 96)

Phosphate glass PGS-96 in Example 96 was produced in the same manner as in Example 61 except that (NH₄)H₂PO₄, ZnO, Al(OH)₃, La₂O₃, KPO₃, Ba(OH)₂·8H₂O, and SiO₂ were weighed so that the contents of P₂O₅, ZnO, Al₂O₃, La₂O₃, K₂O, BaO, and SiO₂ were 62.1 [mol%], 17.2 [mol%], 2.9 [mol%], 2.9 [mol%], 4.6 [mol%], 9.2 [mol%], and 1.1 [mol%], respectively, in terms of mole percentage based on oxides.

### (Example 97)

Phosphate glass PGS-97 in Example 97 was produced in the same manner as in Example 61 except that (NH₄)H₂PO₄, ZnO, Al(OH)₃, La₂O₃, KPO₃, and SiO₂ were weighed so that the contents of P₂O₅, ZnO, Al₂O₃, La₂O₃, K₂O, and SiO₂ were 59.0 [mol%], 20.0 [mol%], 1.0 [mol%], 3.0 [mol%], 14.5 [mol%], and 2.5 [mol%], respectively, in terms of mole percentage based on oxides.

### (Example 98)

Phosphate glass PGS-98 in Example 98 was produced in the same manner as in Example 61 except that (NH₄)H₂PO₄, ZnO, Al(OH)₃, La₂O₃, KPO₃, Ba(OH)₂·8H₂O, and SiO₂ were weighed so that the contents of P₂O₅, ZnO, Al₂O₃, La₂O₃, K₂O, BaO, and SiO₂ were 57.5 [mol%], 13.5 [mol%], 2.0 [mol%], 2.0 [mol%], 10.0 [mol%], 10.0 [mol%], and 5.0 [mol%], respectively, in terms of mole percentage based on oxides.

### (Example 99)

Phosphate glass PGS-99 in Example 99 was produced in the same manner as in Example 61 except that (NH₄)H₂PO₄, ZnO, Al(OH)₃, La₂O₃, KPO₃, Ba(OH)₂·8H₂O, and SiO₂ were weighed so that the contents of P₂O₅, ZnO, Al₂O₃, La₂O₃, K₂O, BaO, and SiO₂ were 57.0 [mol%], 12.5 [mol%], 1.0 [mol%], 1.0 [mol%], 11.5 [mol%], 10.0 [mol%], and 7.0 [mol%], respectively, in terms of mole percentage based on oxides.

### (Example 100)

Phosphate glass PGS-100 in Example 100 was produced in the same manner as in Example 61 except that (NH₄)H₂PO₄, ZnO, Al(OH)₃, La₂O₃, KPO₃, Ba(OH)₂·8H₂O, and SiO₂ were weighed so that the contents of P₂O₅, ZnO, Al₂O₃, La₂O₃, K₂O, BaO, and SiO₂ were 56.7 [mol%], 11.7 [mol%], 0.7 [mol%], 0.7 [mol%], 11.9 [mol%], 9.8 [mol%], and 8.5 [mol%], respectively, in terms of mole percentage based on oxides.

### (Example 101)

Phosphate glass PGS-101 in Example 101 was produced in the same manner as in Example 61 except that (NH₄)H₂PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 60.0 [mol%], 20.0 [mol%], 2.0 [mol%], 3.0 [mol%], 6.0 [mol%], and 9.0 [mol%], respectively, in terms of mole percentage based on oxides.

### (Example 102)

Phosphate glass PGS-102 in Example 102 was produced in the same manner as in Example 61 except that (NH₄)H₂PO₄, ZnO, La₂O₃, Ga₂O₃, KPO₃, and Ba(OH)₂·8H₂O were weighed so that the contents of P₂O₅, ZnO, La₂O₃, Ga₂O₃, K₂O, and BaO were 61.0 [mol%], 20.5 [mol%], 1.5 [mol%], 2.0 [mol%], 6.0 [mol%], and 9.0 [mol%], respectively, in terms of mole percentage based on oxides.

### (Example 103)

Phosphate glass PGS-103 in Example 103 was produced in the same manner as in Example 61 except that (NH₄)H₂PO₄, ZnO, La₂O₃, KPO₃, Ba(OH)₂·8H₂O, and Y₂O₃ were weighed so that the contents of P₂O₅, ZnO, La₂O₃, K₂O, BaO, and Y₂O₃ were 60.0 [mol%], 20.0 [mol%], 3.0 [mol%], 6.0 [mol%], 9.0 [mol%], and 2.0 [mol%], respectively, in terms of mole percentage based on oxides.

### (Example 104)

Phosphate glass PGS-104 in Example 104 was produced in the same manner as in Example 61 except that (NH₄)H₂PO₄, ZnO, Lu₂O₃, Ga₂O₃, KPO₃, and Ba(OH)₂·8H₂O were weighed so that the contents of P₂O₅, ZnO, Lu₂O₃, Ga₂O₃, K₂O, and BaO were 60.0 [mol%], 20.0 [mol%], 1.0 [mol%], 2.0 [mol%], 7.0 [mol%], and 10.0 [mol%], respectively, in terms of mole percentage based on oxides.

### (Example 105)

Phosphate glass PGS-105 in Example 105 was produced in the same manner as in Example 61 except that (NH₄)H₂PO₄, ZnO, La₂O₃, Ga₂O₃, KPO₃, and Ba(OH)₂·8H₂O were weighed so that the contents of P₂O₅, ZnO, La₂O₃, Ga₂O₃, K₂O, and BaO were 60.0 [mol%], 20.0 [mol%], 2.0 [mol%], 2.0 [mol%], 7.0 [mol%], and 9.0 [mol%], respectively, in terms of mole percentage based on oxides.

### (Example 106)

Phosphate glass PGS-106 in Example 106 was produced in the same manner as in Example 61 except that (NH₄)H₂PO₄, ZnO, Al₂O₃, La₂O₃, LiPO₃, NaPO₃, KPO₃, and Ba(OH)₂·8H₂O were weighed so that the contents of P₂O₅, ZnO, Al₂O₃, La₂O₃, Li₂O, Na₂O, K₂O, and BaO were 60.0 [mol%], 20.0 [mol%], 1.5 [mol%], 1.5 [mol%], 1.0 [mol%], 1.0 [mol%], 6.0 [mol%], and 9.0 [mol%], respectively, in terms of mole percentage based on oxides.

### (Example 107)

Phosphate glass PGS-107 in Example 107 was produced in the same manner as in Example 61 except that (NH₄)H₂PO₄, ZnO, Al₂O₃, La₂O₃, KPO₃, and Ca(H₂PO₄)₂·H₂O were weighed so that the contents of P₂O₅, ZnO, Al₂O₃, La₂O₃, K₂O, and CaO were 60.0 [mol%], 20.0 [mol%], 2.0 [mol%], 2.0 [mol%], 8.0 [mol%], and 8.0 [mol%], respectively, in terms of mole percentage based on oxides.

### (Example 108)

Phosphate glass PGS-108 in Example 108 was produced in the same manner as in Example 61 except that (NH₄)H₂PO₄, ZnO, Al₂O₃, La₂O₃, KPO₃, Ba(OH)₂·8H₂O, and SnO were weighed so that the contents of P₂O₅, ZnO, Al₂O₃, La₂O₃, K₂O, BaO, and SnO were 60.0 [mol%], 20.0 [mol%], 1.0 [mol%], 2.0 [mol%], 7.0 [mol%], 9.0 [mol%], and 1.0 [mol%], respectively, in terms of mole percentage based on oxides.

### (Example 109)

Phosphate glass PGS-109 in Example 109 was produced in the same manner as in Example 61 except that 85% H₃PO₄, ZnO, Al₂O₃, La₂O₃, KPO₃, and MgO were weighed so that the contents of P₂O₅, ZnO, Al₂O₃, La₂O₃, K₂O, and MgO were 60.0 [mol%], 20.0 [mol%], 1.5 [mol%], 3.0 [mol%], 9.0 [mol%], and 6.5 [mol%], respectively, in terms of mole percentage based on oxides.

### (Example 110)

Phosphate glass PGS-110 in Example 110 was produced in the same manner as in Example 61 except that (NH₄)H₂PO₄, ZnO, Al₂O₃, La₂O₃, Ga₂O₃, and KPO₃ were weighed so that the contents of P₂O₅, ZnO, Al₂O₃, La₂O₃, Ga₂O₃, and K₂O were 62.5 [mol%], 22.0 [mol%], 1.5 [mol%], 2.0 [mol%], 2.0 [mol%], and 10.0 [mol%], respectively, in terms of mole percentage based on oxides.

### (Example 111)

Phosphate glass PGS-111 in Example 111 was produced in the same manner as in Example 61 except that 85% H₃PO₄, ZnO, Al₂O₃, La₂O₃, Ga₂O₃, KPO₃, and Ba(OH)₂·8H₂O were weighed so that the contents of P₂O₅, ZnO, Al₂O₃, La₂O₃, Ga₂O₃, K₂O, and BaO were 60.0 [mol%], 20.0 [mol%], 1.5 [mol%], 2.5 [mol%], 1.0 [mol%], 7.0 [mol%], and 8.0 [mol%], respectively, in terms of mole percentage based on oxides.

### (Example 112)

Phosphate glass PGS-112 in Example 112 was produced in the same manner as in Example 61 except that 85% H₃PO₄, ZnO, Al₂O₃, La₂O₃, KPO₃, Ba(OH)₂·8H₂O, and SiO₂ were weighed so that the contents of P₂O₅, ZnO, Al₂O₃, La₂O₃, K₂O, BaO, and SiO₂ were 60.0 [mol%], 20.0 [mol%], 1.5 [mol%], 2.5 [mol%], 6.0 [mol%], 9.0 [mol%], and 1.0 [mol%], respectively, in terms of mole percentage based on oxides.

### (Example 113)

Phosphate glass PGS-113 in Example 113 was produced in the same manner as in Example 61 except that 85% H₃PO₄, ZnO, Al₂O₃, La₂O₃, KPO₃, and SiO₂ were weighed so that the contents of P₂O₅, ZnO, Al₂O₃, La₂O₃, K₂O, and SiO₂ were 62.5 [mol%], 21.0 [mol%], 2.0 [mol%], 3.0 [mol%], 10.0 [mol%], and 1.5 [mol%], respectively, in terms of mole percentage based on oxides.

### (Example 114)

Phosphate glass PGS-114 in Example 114 was produced in the same manner as in Example 61 except that 85% H₃PO₄, ZnO, Al₂O₃, La₂O₃, and KPO₃ were weighed so that the contents of P₂O₅, ZnO, Al₂O₃, La₂O₃, and K₂O were 63.0 [mol%], 22.0 [mol%], 2.0 [mol%], 3.0 [mol%], and 10.0 [mol%], respectively, in terms of mole percentage based on oxides.

### (Example 115)

Phosphate glass PGS-115 in Example 115 was produced in the same manner as in Example 61 except that 85% H₃PO₄, ZnO, Al₂O₃, Lu₂O₃, KPO₃, and Ba(OH)₂·8H₂O were weighed so that the contents of P₂O₅, ZnO, Al₂O₃, Lu₂O₃, K₂O, and BaO were 61.0 [mol%], 20.0 [mol%], 2.0 [mol%], 3.0 [mol%], 6.0 [mol%], and 8.0 [mol%], respectively, in terms of mole percentage based on oxides.

### (Example 116)

Phosphate glass PGS-116 in Example 116 was produced in the same manner as in Example 61 except that 85% H₃PO₄, ZnO, Al₂O₃, La₂O₃, Ga₂O₃, KPO₃, Ba(OH)₂·8H₂O, and Cu₂O were weighed so that the contents of P₂O₅, ZnO, Al₂O₃, La₂O₃, Ga₂O₃, K₂O, BaO, and CU₂O were 60.0 [mol%], 20.0 [mol%], 1.0 [mol%], 1.0 [mol%], 1.0 [mol%], 7.0 [mol%], 9.0 [mol%], and 1.0 [mol%], respectively, in terms of mole percentage based on oxides.

### (Example 117)

Phosphate glass PGS-117 in Example 117 was produced in the same manner as in Example 61 except that 85% H₃PO₄, ZnO, Al₂O₃, La₂O₃, Ga₂O₃, KPO₃, Ba(OH)₂·8H₂O, and Ag₂O were weighed so that the contents of P₂O₅, ZnO, Al₂O₃, La₂O₃, Ga₂O₃, K₂O, BaO, and Ag₂O were 60.0 [mol%], 20.0 [mol%], 1.0 [mol%], 1.0 [mol%], 1.0 [mol%], 7.0 [mol%], 9.0 [mol%], and 1.0 [mol%], respectively, in terms of mole percentage based on oxides.

### (Example 118)

Phosphate glass PGS-118 in Example 118 was produced in the same manner as in Example 61 except that 85% H₃PO₄, ZnO, Al₂O₃, La₂O₃, Ga₂O₃, KPO₃, Ba(OH)₂·8H₂O, and MnO were weighed so that the contents of P₂O₅, ZnO, Al₂O₃, La₂O₃, Ga₂O₃, K₂O, BaO, and MnO were 60.0 [mol%], 20.0 [mol%], 1.0 [mol%], 1.0 [mol%], 1.0 [mol%], 7.0 [mol%], 9.0 [mol%], and 1.0 [mol%], respectively, in terms of mole percentage based on oxides.

### (Example 119)

Phosphate glass PGS-119 in Example 119 was produced in the same manner as in Example 61 except that (NH₄)H₂PO₄, ZnO, Al₂O₃, La₂O₃, Ga₂O₃, KPO₃, Ba(OH)₂·8H₂O, and Cu₂O were weighed so that the contents of P₂O₅, ZnO, Al₂O₃, La₂O₃, Ga₂O₃, K₂O, BaO, and CU₂O were 60.0 [mol%], 20.0 [mol%], 1.0 [mol%], 1.0 [mol%], 1.9 [mol%], 7.0 [mol%], 9.0 [mol%], and 0.1 [mol%], respectively, in terms of mole percentage based on oxides.

### (Example 120)

Phosphate glass PGS-120 in Example 120 was produced in the same manner as in Example 61 except that (NH₄)H₂PO₄, ZnO, Al₂O₃, La₂O₃, Ga₂O₃, KPO₃, Ba(OH)₂·8H₂O, and Ag₂O were weighed so that the contents of P₂O₅, ZnO, Al₂O₃, La₂O₃, Ga₂O₃, K₂O, BaO, and Ag₂O were 60.0 [mol%], 20.0 [mol%], 1.0 [mol%], 1.0 [mol%], 1.9 [mol%], 7.0 [mol%], 9.0 [mol%], and 0.1 [mol%], respectively, in terms of mole percentage based on oxides.

### (Example 121)

Phosphate glass PGS-121 in Example 121 was produced in the same manner as in Example 61 except that 85% H₃PO₄, ZnO, Al₂O₃, La₂O₃, Ga₂O₃, KPO₃, Ba(OH)₂·8H₂O, and MnO were weighed so that the contents of P₂O₅, ZnO, Al₂O₃, La₂O₃, Ga₂O₃, K₂O, BaO, and MnO were 60.0 [mol%], 20.0 [mol%], 1.0 [mol%], 1.0 [mol%], 1.9 [mol%], 7.0 [mol%], 9.0 [mol%], and 0.1 [mol%], respectively, in terms of mole percentage based on oxides.

### (Example 122)

Phosphate glass PGS-122 in Example 122 was produced in the same manner as in Example 61 except that 85% H₃PO₄, ZnO, Al₂O₃, La₂O₃, Ga₂O₃, KPO₃, and Ba(OH)₂·8H₂O were weighed so that the contents of P₂O₅, ZnO, Al₂O₃, La₂O₃, Ga₂O₃, K₂O, and BaO were 60.0 [mol%], 20.0 [mol%], 1.0 [mol%], 1.0 [mol%], 2.0 [mol%], 7.0 [mol%], and 9.0 [mol%], respectively, in terms of mole percentage based on oxides.

### (Example 123)

Phosphate glass PGS-123 in Example 123 was produced in the same manner as in Example 61 except that (NH₄)H₂PO₄, ZnO, Al₂O₃, La₂O₃, Ga₂O₃, KPO₃, Ba(OH)₂·8H₂O, and Cu₂O were weighed so that the contents of P₂O₅, ZnO, Al₂O₃, La₂O₃, Ga₂O₃, K₂O, BaO, and CU₂O were 60.0 [mol%], 20.0 [mol%], 1.0 [mol%], 1.0 [mol%], 2.0 [mol%], 7.0 [mol%], 9.0 [mol%], and 0.01 [mol%], respectively, in terms of mole percentage based on oxides.

### (Example 124)

Phosphate glass PGS-124 in Example 124 was produced in the same manner as in Example 61 except that (NH₄)H₂PO₄, ZnO, Al₂O₃, La₂O₃, Ga₂O₃, KPO₃, Ba(OH)₂·8H₂O, and Ag₂O were weighed so that the contents of P₂O₅, ZnO, Al₂O₃, La₂O₃, Ga₂O₃, K₂O, BaO, and Ag₂O were 60.0 [mol%], 20.0 [mol%], 1.0 [mol%], 1.0 [mol%], 2.0 [mol%], 7.0 [mol%], 9.0 [mol%], and 0.01 [mol%], respectively, in terms of mole percentage based on oxides.

### (Example 125)

Phosphate glass PGS-125 in Example 125 was produced in the same manner as in Example 61 except that (NH₄)H₂PO₄, ZnO, Al₂O₃, La₂O₃, Ga₂O₃, KPO₃, Ba(OH)₂·8H₂O, and MnO were weighed so that the contents of P₂O₅, ZnO, Al₂O₃, La₂O₃, Ga₂O₃, K₂O, BaO, and MnO were 60.0 [mol%], 20.0 [mol%], 1.0 [mol%], 1.0 [mol%], 2.0 [mol%], 7.0 [mol%], 9.0 [mol%], and 0.01 [mol%], respectively, in terms of mole percentage based on oxides.

### (Comparative Example 15)

Phosphate glass PGS-Comp-15 in Comparative Example 15 was produced in the same manner as in Example 61 except that (NH₄)H₂PO₄, ZnO, Al(OH)₃, KPO₃, and Ba(OH)₂·8H₂O were weighed so that the contents of P₂O₅, ZnO, Al₂O₃, K₂O, and BaO were 65.7 [mol%], 23.5 [mol%], 2.9 [mol%], 3.0 [mol%], and 4.9 [mol%], respectively, in terms of mole percentage based on oxides.

### (Comparative Example 16)

An attempt was made to produce phosphate glass in the same manner as in Example 61 except that (NH₄)H₂PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 69.2 [mol%], 4.4 [mol%], 3.5 [mol%], 1.8 [mol%], 18.5 [mol%], and 2.6 [mol%], respectively, in terms of mole percentage based on oxides, but no phosphate glass was obtained.

### (Comparative Example 17)

Phosphate glass PGS-Comp-17 in Comparative Example 17 was produced in the same manner as in Example 61 except that (NH₄)H₂PO₄, ZnO, Al(OH)₃, KPO₃, and Ba(OH)₂·8H₂O were weighed so that the contents of P₂O₅, ZnO, Al₂O₃, K₂O, and BaO were 59.0 [mol%], 21.9 [mol%], 0.9 [mol%], 13.6 [mol%], and 4.6 [mol%], respectively, in terms of mole percentage based on oxides.

### (Comparative Example 18)

An attempt was made to produce phosphate glass in the same manner as in Example 61 except that (NH₄)H₂PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 75.5 [mol%], 9.8 [mol%], 4.9 [mol%], 2.0 [mol%], 2.9 [mol%], and 4.9 [mol%], respectively, in terms of mole percentage based on oxides, but no phosphate glass was obtained.

### (Comparative Example 19)

An attempt was made to produce phosphate glass in the same manner as in Example 61 except that (NH₄)H₂PO₄, ZnO, and Al(OH)₃ were weighed so that the contents of P₂O₅, ZnO, and Al₂O₃ were 62.5 [mol%], 32.0 [mol%], and 5.5 [mol%], respectively, in terms of mole percentage based on oxides, but no phosphate glass was obtained.

### (Comparative Example 20)

Phosphate glass PGS-Comp-20 in Comparative Example 20 was produced in the same manner as in Example 61 except that (NH₄)H₂PO₄, ZnO, Al(OH)₃, La₂O₃, Lu₂O₃, KPO₃, and Ba(OH)₂·8H₂O were weighed so that the contents of P₂O₅, ZnO, Al₂O₃, La₂O₃, Lu₂O₃, K₂O, and BaO were 65.0 [mol%], 24.0 [mol%], 2.0 [mol%], 0.5 [mol%], 0.5 [mol%], 2.5 [mol%], and 5.5 [mol%], respectively, in terms of mole percentage based on oxides.

### (Comparative Example 21)

An attempt was made to produce phosphate glass in the same manner as in Example 61 except that (NH₄)H₂PO₄, ZnO, Al(OH)₃, KPO₃, and Ba(OH)₂·8H₂O were weighed so that the contents of P₂O₅, ZnO, Al₂O₃, K₂O, and BaO were 63.4 [mol%], 24.3 [mol%], 5.4 [mol%], 4.9 [mol%], and 2.0 [mol%], respectively, in terms of mole percentage based on oxides, but no phosphate glass was obtained.

### (Comparative Example 22)

Phosphate glass PGS-Comp-22 in Comparative Example 22 was produced in the same manner as in Example 61 except that (NH₄)H₂PO₄, ZnO, Al(OH)₃, KPO₃, and Ba(OH)₂·8H₂O were weighed so that the contents of P₂O₅, ZnO, Al₂O₃, K₂O, and BaO were 59.5 [mol%], 21.6 [mol%], 2.7 [mol%], 5.4 [mol%], and 10.8 [mol%], respectively, in terms of mole percentage based on oxides.

### (Comparative Example 23)

An attempt was made to produce phosphate glass in the same manner as in Example 61 except that (NH₄)H₂PO₄, ZnO, Al(OH)₃, La₂O₃, KPO₃, and Ba(OH)₂·8H₂O were weighed so that the contents of P₂O₅, ZnO, Al₂O₃, La₂O₃, K₂O, and BaO were 54.0 [mol%], 18.4 [mol%], 3.1 [mol%], 9.8 [mol%], 4.9 [mol%], and 9.8 [mol%], respectively, in terms of mole percentage based on oxides, but no phosphate glass was obtained.

In Examples 61 to 125 and Comparative Examples 15, 17, 20, and 22, phosphate glass was produced through melting at a temperature of 800°C.

### [Evaluation]

The X-ray diffraction of phosphate glass was measured using an X-ray diffractometer of model number RINT2100 manufactured by Rigaku Corporation.

In addition, the glass transition temperature Tg of the phosphate glass was measured using a differential thermal analyzer of model number Thermo plus EVO2 manufactured by Rigaku Corporation.

Furthermore, the light transmission spectrum of the phosphate glass was measured using an ultraviolet-visible near-infrared spectrophotometer of model number UV4150 manufactured by Hitachi High-Tech Corporation.

Furthermore, the fluorescence spectrum of the phosphate glass was measured using a fluorescence spectrophotometer of model number F-7000 manufactured by Hitachi High-Tech Corporation.

Furthermore, the water resistance of the phosphate glass produced through melting at a temperature of 500°C was evaluated with the above-described method (1). In addition, the water resistance of the phosphate glass produced through melting at a temperature of 800°C was evaluated with the above-described method (2).

Table 1 shows the contents of the components, the water resistance, and the glass transition temperature of the phosphate glass PGS-1 to PGS-7 in Examples 1 to 7. Table 2 shows the contents of the components, the water resistance, and the glass transition temperature of the phosphate glass PGS-8 to PGS-14 in Examples 8 to 14. Table 3 shows the contents of the components, the water resistance, and the glass transition temperature of the phosphate glass PGS-15 to PGS-20 in Examples 15 to 20. Table 4 shows the contents of the components, the water resistance, and the glass transition temperature of the phosphate glass PGS-21 to PGS-26 in Examples 21 to 26.

**[Table 1]**

| | Example 1 | Example 2 | Example 3 | Example 4 | Example 5 | Example 6 | Example 7 |
|---|---|---|---|---|---|---|---|
| Composition (mol%) | | | | | | | |
| P₂O₅ | 59.6 | 62.1 | 59.8 | 64.9 | 59.5 | 56.1 | 61.0 |
| ZnO | 20.7 | 22.6 | 21.7 | 10.8 | 21.6 | 25.4 | 16.7 |
| Al₂O₃ | 2.6 | 2.8 | 3.3 | 2.7 | 2.7 | 2.6 | 2.8 |
| La₂O₃ | 1.0 | 1.1 | 1.1 | 2.2 | 2.2 | 2.6 | 2.8 |
| Lu₂O₃ | 0.0 | 0.0 | 0.0 | 0.0 | 0.0 | 0.0 | 0.0 |
| Ga₂O₃ | 0.0 | 0.0 | 0.0 | 0.0 | 0.0 | 0.0 | 0.0 |
| Li₂O | 0.0 | 0.0 | 0.0 | 0.0 | 0.0 | 0.0 | 0.0 |
| Na₂O | 0.0 | 0.0 | 0.0 | 0.0 | 0.0 | 0.0 | 0.0 |
| K₂O | 7.8 | 5.7 | 5.4 | 10.8 | 5.4 | 5.1 | 5.6 |
| BaO | 8.3 | 5.7 | 8.7 | 8.6 | 8.6 | 8.2 | 11.1 |
| MgO | 0.0 | 0.0 | 0.0 | 0.0 | 0.0 | 0.0 | 0.0 |
| CaO | 0.0 | 0.0 | 0.0 | 0.0 | 0.0 | 0.0 | 0.0 |
| SrO | 0.0 | 0.0 | 0.0 | 0.0 | 0.0 | 0.0 | 0.0 |
| SiO₂ | 0.0 | 0.0 | 0.0 | 0.0 | 0.0 | 0.0 | 0.0 |
| Y₂O₃ | 0.0 | 0.0 | 0.0 | 0.0 | 0.0 | 0.0 | 0.0 |
| SnO | 0.0 | 0.0 | 0.0 | 0.0 | 0.0 | 0.0 | 0.0 |
| Cu₂O | 0.0 | 0.0 | 0.0 | 0.0 | 0.0 | 0.0 | 0.0 |
| Ag₂O | 0.0 | 0.0 | 0.0 | 0.0 | 0.0 | 0.0 | 0.0 |
| MnO | 0.0 | 0.0 | 0.0 | 0.0 | 0.0 | 0.0 | 0.0 |
| Total | 100.0 | 100.0 | 100.0 | 100.0 | 100.0 | 100.0 | 100.0 |
| Water resistance (ΔW) [%] | 1.0 | 1.0 | 7.0 | 1.0 | 19.0 | 12.0 | 10.0 |
| Glass transition temperature Tg [°C] | 140 | 153 | 125 | 182 | 183 | 148 | 174 |

**[Table 2]**

| | Example 8 | Example 9 | Example 10 | Example 11 | Example 12 | Example 13 | Example 14 |
|---|---|---|---|---|---|---|---|
| Composition (mol%) | | | | | | | |
| P₂O₅ | 62.8 | 58.5 | 60.0 | 60.0 | 60.0 | 62.8 | 62.8 |
| ZnO | 17.4 | 14.6 | 20.0 | 20.0 | 20.0 | 17.4 | 17.4 |
| Al₂O₃ | 2.9 | 4.9 | 1.5 | 1.5 | 1.0 | 2.9 | 2.9 |
| La₂O₃ | 2.9 | 2.4 | 2.0 | 1.5 | 1.5 | 2.9 | 2.9 |
| Lu₂O₃ | 0.0 | 0.0 | 1.5 | 0.0 | 0.0 | 0.0 | 0.0 |
| Ga₂O₃ | 0.0 | 0.0 | 0.0 | 0.0 | 0.5 | 0.0 | 0.0 |
| Li₂O | 0.0 | 0.0 | 0.0 | 0.0 | 0.0 | 0.0 | 0.0 |
| Na₂O | 0.0 | 0.0 | 0.0 | 0.0 | 0.0 | 0.0 | 0.0 |
| K₂O | 4.7 | 9.8 | 6.0 | 6.0 | 6.0 | 4.7 | 4.7 |
| BaO | 9.3 | 9.8 | 9.0 | 9.0 | 9.0 | 9.3 | 9.3 |
| MgO | 0.0 | 0.0 | 0.0 | 0.0 | 0.0 | 0.0 | 0.0 |
| CaO | 0.0 | 0.0 | 0.0 | 0.0 | 0.0 | 0.0 | 0.0 |
| SrO | 0.0 | 0.0 | 0.0 | 0.0 | 0.0 | 0.0 | 0.0 |
| SiO₂ | 0.0 | 0.0 | 0.0 | 0.0 | 0.0 | 0.0 | 0.0 |
| T₂O₃ | 0.0 | 0.0 | 0.0 | 2.0 | 2.0 | 0.0 | 0.0 |
| SnO | 0.0 | 0.0 | 0.0 | 0.0 | 0.0 | 0.001 | 0.010 |
| Cu₂O | 0.0 | 0.0 | 0.0 | 0.0 | 0.0 | 0.0 | 0.0 |
| Ag₂O | 0.0 | 0.0 | 0.0 | 0.0 | 0.0 | 0.0 | 0.0 |
| MnO | 0.0 | 0.0 | 0.0 | 0.0 | 0.0 | 0.0 | 0.0 |
| Total | 100.0 | 100.0 | 100.0 | 100.0 | 100.0 | 100.001 | 100.01 |
| Water resistance (ΔW) [%] | 25.0 | 1.0 | 0.5 | 0.1 | 0.0 | 0.5 | 0.5 |
| Glass transition temperature Tg [°C] | 196 | 224 | 218 | 232 | 229 | 180 | 184 |

**[Table 3]**

| | Example 15 | Example 16 | Example 17 | Example 18 | Example 19 | Example 20 |
|---|---|---|---|---|---|---|
| Composition (mol%) | | | | | | |
| P₂O₅ | 62.7 | 62.1 | 57.1 | 62.8 | 60.0 | 60.0 |
| ZnO | 17.4 | 17.3 | 15.8 | 17.4 | 20.0 | 20.0 |
| Al₂O₃ | 2.9 | 2.9 | 2.6 | 1.4 | 2.0 | 1.5 |
| La₂O₃ | 2.9 | 2.9 | 2.6 | 2.9 | 0.0 | 0.0 |
| Lu₂O₃ | 0.0 | 0.0 | 0.0 | 0.0 | 1.0 | 1.5 |
| Ga₂O₃ | 0.0 | 0.0 | 0.0 | 1.5 | 2.0 | 1.0 |
| Li₂O | 0.0 | 0.0 | 0.0 | 0.0 | 0.0 | 0.0 |
| Na₂O | 0.0 | 0.0 | 0.0 | 0.0 | 0.0 | 0.0 |
| K₂O | 4.7 | 4.6 | 4.3 | 4.7 | 6.0 | 6.0 |
| BaO | 9.3 | 9.2 | 8.5 | 9.3 | 9.0 | 9.0 |
| MgO | 0.0 | 0.0 | 0.0 | 0.0 | 0.0 | 0.0 |
| CaO | 0.0 | 0.0 | 0.0 | 0.0 | 0.0 | 0.0 |
| SrO | 0.0 | 0.0 | 0.0 | 0.0 | 0.0 | 0.0 |
| SiO₂ | 0.0 | 0.0 | 0.0 | 0.0 | 0.0 | 0.0 |
| Y₂O₃ | 0.0 | 0.0 | 0.0 | 0.0 | 0.0 | 1.0 |
| SnO | 0.1 | 1.0 | 9.1 | 0.0 | 0.0 | 0.0 |
| Cu₂O | 0.0 | 0.0 | 0.0 | 0.0 | 0.0 | 0.0 |
| Ag₂O | 0.0 | 0.0 | 0.0 | 0.0 | 0.0 | 0.0 |
| MnO | 0.0 | 0.0 | 0.0 | 0.0 | 0.0 | 0.0 |
| Total | 100.0 | 100.0 | 100.0 | 100.0 | 100.0 | 100.0 |
| Water resistance (ΔW) [%] | 0.5 | 0.5 | 0.5 | 0.5 | 0.059 | 0.105 |
| Glass transition temperature Tg [°C] | 174 | 184 | 200 | 190 | 214 | 207 |

**[Table 4]**

| | Example 21 | Example 22 | Example 23 | Example 24 | Example 25 | Example 26 |
|---|---|---|---|---|---|---|
| Composition (mol%) | | | | | | |
| P₂O₅ | 62.8 | 60.0 | 60.0 | 62.8 | 60.0 | 60.0 |
| ZnO | 17.4 | 20.0 | 20.0 | 17.4 | 20.0 | 20.0 |
| Al₂O₃ | 0.0 | 0.0 | 1.5 | 0.0 | 0.0 | 0.0 |
| La₂O₃ | 0.0 | 0.0 | 0.0 | 2.9 | 3.0 | 1.0 |
| Lu₂O₃ | 2.9 | 3.0 | 1.5 | 0.0 | 0.0 | 0.0 |
| Ga₂O₃ | 2.9 | 0.0 | 0.0 | 2.9 | 0.0 | 2.0 |
| Li₂O | 0.0 | 0.0 | 0.0 | 0.0 | 0.0 | 0.0 |
| Na₂O | 0.0 | 0.0 | 0.0 | 0.0 | 0.0 | 0.0 |
| K₂O | 4.7 | 6.0 | 6.0 | 4.7 | 6.0 | 6.0 |
| BaO | 9.3 | 9.0 | 9.0 | 9.3 | 9.0 | 9.0 |
| MgO | 0.0 | 0.0 | 0.0 | 0.0 | 0.0 | 0.0 |
| CaO | 0.0 | 0.0 | 0.0 | 0.0 | 0.0 | 0.0 |
| SrO | 0.0 | 0.0 | 0.0 | 0.0 | 0.0 | 0.0 |
| SiO₂ | 0.0 | 0.0 | 0.0 | 0.0 | 0.0 | 0.0 |
| Y₂O₃ | 0.0 | 2.0 | 2.0 | 0.0 | 2.0 | 2.0 |
| SnO | 0.0 | 0.0 | 0.0 | 0.0 | 0.0 | 0.0 |
| Cu₂O | 0.0 | 0.0 | 0.0 | 0.0 | 0.0 | .0 |
| Ag₂O | 0.0 | 0.0 | 0.0 | 0.0 | 0.0 | 0.0 |
| MnO | 0.0 | 0.0 | 0.0 | 0.0 | 0.0 | 0.0 |
| Total | 100.0 | 100.0 | 100.0 | 100.0 | 100.0 | 100.0 |
| Water resistance (ΔW) [%] | 1.0 | 9.607 | 0.017 | 4.0 | 0.289 | 0.022 |
| Glass transition temperature Tg [°C] | 184 | 214 | 215 | 129 | 226 | 219 |

Table 5 shows the contents of the components, the water resistance, and the glass transition temperature of the phosphate glass PGS-27 to PGS-32 in Examples 27 to 32. Table 6 shows the contents of the components, the water resistance, and the glass transition temperature of the phosphate glass PGS-33 to PGS-38 in Examples 33 to 38. Table 7 shows the contents of the components, the water resistance, and the glass transition temperature of the phosphate glass PGS-39 to PGS-44 in Examples 39 to 44. Table 8 shows the contents of the components, the water resistance, and the glass transition temperature of the phosphate glass PGS-45 to PGS-50 in Examples 45 to 50. Table 9 shows the contents of the components, the water resistance, and the glass transition temperature of the phosphate glass PGS-51 to PGS-56 in Examples 51 to 56. Table 10 shows the contents of the components, the water resistance, and the glass transition temperature of the phosphate glass PGS-57 to PGS-60 in Examples 57 to 60.

**[Table 5]**

| | Example 27 | Example 28 | Example 28-2 | Example 29 | Example 30 | Example 31 | Example 32 |
|---|---|---|---|---|---|---|---|
| Composition (mol%) | | | | | | | |
| P₂O₅ | 60.0 | 62.1 | 62.1 | 59.0 | 62.5 | 62.5 | 62.0 |
| ZnO | 20.0 | 22.6 | 22.6 | 20.0 | 21.5 | 21.5 | 21.0 |
| Al₂O₃ | 0.0 | 2.8 | 2.8 | 3.5 | 1.5 | 1.5 | 2.0 |
| La₂O₃ | 0.0 | 1.1 | 1.1 | 3.0 | 2.5 | 2.5 | 3.0 |
| Lu₂O₃ | 1.0 | 0.0 | 0.0 | 0.0 | 0.0 | 0.0 | 0.0 |
| Ga₂O₃ | 2.0 | 0.0 | 0.0 | 0.0 | 0.0 | 0.0 | 0.0 |
| Li₂O | 0.0 | 0.0 | 0.0 | 0.0 | 12.0 | 0.0 | 0.0 |
| Na₂O | 0.0 | 0.0 | 0.0 | 0.0 | 0.0 | 12.0 | 6.0 |
| K₂O | 6.0 | 5.7 | 5.7 | 14.5 | 0.0 | 0.0 | 6.0 |
| BaO | 9.0 | 0.0 | 0.0 | 0.0 | 0.0 | 0.0 | 0.0 |
| MgO | 0.0 | 0.0 | 0.0 | 0.0 | 0.0 | 0.0 | 0.0 |
| CaO | 0.0 | 5.7 | 0.0 | 0.0 | 0.0 | 0.0 | 0.0 |
| SrO | 0.0 | 0.0 | 5.7 | 0.0 | 0.0 | 0.0 | 0.0 |
| SiO₂ | 0.0 | 0.0 | 0.0 | 0.0 | 0.0 | 0.0 | 0.0 |
| Y₂O₃ | 2.0 | 0.0 | 0.0 | 0.0 | 0.0 | 0.0 | 0.0 |
| SnO | 0.0 | 0.0 | 0.0 | 0.0 | 0.0 | 0.0 | 0.0 |
| CU₂O | 0.0 | 0.0 | 0.0 | 0.0 | 0.0 | 0.0 | 0.0 |
| Ag₂O | 0.0 | 0.0 | 0.0 | 0.0 | 0.0 | 0.0 | 0.0 |
| MnO | 0.0 | 0.0 | 0.0 | 0.0 | 0.0 | 0.0 | 0.0 |
| Total | 100.0 | 100.0 | 100.0 | 100.0 | 100.0 | 100.0 | 100.0 |
| Water resistance (ΔW) [%] | 0.129 | 2.0 | 0.209 | 5.0 | 15.964 | 3.156 | 0.33 |
| Glass transition temperature Tg [°C] | 208 | 139 | 182 | 187 | 150 | 164 | 183 |

**[Table 6]**

| | Example 33 | Example 34 | Example 35 | Example 36 | Example 37 | Example 38 |
|---|---|---|---|---|---|---|
| Composition (mol%) | | | | | | |
| P₂O₅ | 62.8 | 58.5 | 62.1 | 59.0 | 57.0 | 56.7 |
| ZnO | 17.4 | 22.0 | 17.2 | 20.0 | 12.5 | 11.7 |
| Al₂O₃ | 2.9 | 2.9 | 2.9 | 1.0 | 1.0 | 0.7 |
| La₂O₃ | 0.0 | 2.2 | 2.9 | 3.0 | 1.0 | 0.7 |
| Lu₂O₃ | 2.9 | 0.0 | 0.0 | 0.0 | 0.0 | 0.0 |
| Ga₂O₃ | 0.0 | 0.0 | 0.0 | 0.0 | 0.0 | 0.0 |
| Li₂O | 0.0 | 0.0 | 0.0 | 0.0 | 0.0 | 0.0 |
| Na₂O | 0.0 | 0.0 | 0.0 | 0.0 | 0.0 | 0.0 |
| K₂O | 4.7 | 5.5 | 4.6 | 14.5 | 11.5 | 11.9 |
| BaO | 9.3 | 8.8 | 9.2 | 0.0 | 10.0 | 9.8 |
| MgO | 0.0 | 0.0 | 0.0 | 0.0 | 0.0 | 0.0 |
| CaO | 0.0 | 0.0 | 0.0 | 0.0 | 0.0 | 0.0 |
| SrO | 0.0 | 0.0 | 0.0 | 0.0 | 0.0 | 0.0 |
| SiO₂ | 0.0 | 0.1 | 1.1 | 2.5 | 7.0 | 8.5 |
| Y₂O₃ | 0.0 | 0.0 | 0.0 | 0.0 | 0.0 | 0.0 |
| SnO | 0.0 | 0.0 | 0.0 | 0.0 | 0.0 | 0.0 |
| Cu₂O | 0.0 | 0.0 | 0.0 | 0.0 | 0.0 | 0.0 |
| Ag₂O | 0.0 | 0.0 | 0.0 | 0.0 | 0.0 | 0.0 |
| MnO | 0.0 | 0.0 | 0.0 | 0.0 | 0.0 | 0.0 |
| Total | 100.0 | 100.0 | 100.0 | 100.0 | 100.0 | 100.0 |
| Water resistance (ΔW) [%] | 0.5 | 1.0 | 0.5 | 1.0 | 1.0 | 1.0 |
| Glass transition temperature Tg [°C] | 184 | 205 | 202 | 171 | 158 | 168 |

**Table 7]**

| | Example 39 | Example 40 | Example 41 | Example 42 | Example 43 | Example 44 |
|---|---|---|---|---|---|---|
| Composition (mol%) | | | | | | |
| P₂O₅ | 60.0 | 61.0 | 60.0 | 60.0 | 60.0 | 60.0 |
| ZnO | 20.0 | 20.5 | 20.0 | 20.0 | 20.0 | 20.0 |
| Al₂O₃ | 2.0 | 0.0 | 0.0 | 0.0 | 0.0 | 1.5 |
| La₂O₃ | 3.0 | 1.5 | 3.0 | 0.0 | 2.0 | 1.5 |
| Lu₂O₃ | 0.0 | 0.0 | 0.0 | 1.0 | 0.0 | 0.0 |
| Ga₂O₃ | 0.0 | 2.0 | 0.0 | 2.0 | 2.0 | 0.0 |
| Li₂O | 0.0 | 0.0 | 0.0 | 0.0 | 0.0 | 1.0 |
| Na₂O | 0.0 | 0.0 | 0.0 | 0.0 | 0.0 | 1.0 |
| K₂O | 6.0 | 6.0 | 6.0 | 7.0 | 7.0 | 6.0 |
| BaO | 9.0 | 9.0 | 9.0 | 10.0 | 9.0 | 9.0 |
| MgO | 0.0 | 0.0 | 0.0 | 0.0 | 0.0 | 0.0 |
| CaO | 0.0 | 0.0 | 0.0 | 0.0 | 0.0 | 0.0 |
| SrO | 0.0 | 0.0 | 0.0 | 0.0 | 0.0 | 0.0 |
| SiO₂ | 0.0 | 0.0 | 0.0 | 0.0 | 0.0 | 0.0 |
| Y₂O₃ | 0.0 | 0.0 | 2.0 | 0.0 | 0.0 | 0.0 |
| SnO | 0.0 | 0.0 | 0.0 | 0.0 | 0.0 | 0.0 |
| Cu₂O | 0.0 | 0.0 | 0.0 | 0.0 | 0.0 | 0.0 |
| Ag₂O | 0.0 | 0.0 | 0.0 | 0.0 | 0.0 | 0.0 |
| MnO | 0.0 | 0.0 | 0.0 | 0.0 | 0.0 | 0.0 |
| Total | 100.0 | 100.0 | 100.0 | 100.0 | 100.0 | 100.0 |
| Water resistance (ΔW) [%] | 0.019 | 0.031 | 0.020 | 0.045 | 0.145 | 0.014 |
| Glass transition temperature Tg [°C] | 223 | 195 | 213 | 184 | 203 | 194 |

**[Table 8]**

| | Example 45 | Example 46 | Example 47 | Example 48 | Example 49 | Example 50 |
|---|---|---|---|---|---|---|
| Composition (mol%) | | | | | | |
| P₂O₅ | 60.0 | 60.0 | 60.0 | 62.5 | 60.0 | 60.0 |
| ZnO | 20.0 | 20.0 | 20.0 | 22.0 | 20.0 | 20.0 |
| Al₂O₃ | 2.0 | 1.0 | 1.5 | 1.5 | 1.5 | 1.5 |
| La₂O₃ | 2.0 | 2.0 | 3.0 | 2.0 | 2.5 | 2.5 |
| Lu₂O₃ | 0.0 | 0.0 | 0.0 | 0.0 | 0.0 | 0.0 |
| Ga₂O₃ | 0.0 | 0.0 | 0.0 | 2.0 | 1.0 | 0.0 |
| Li₂O | 0.0 | 0.0 | 0.0 | 0.0 | 0.0 | 0.0 |
| Na₂O | 0.0 | 0.0 | 0.0 | 0.0 | 0.0 | 0.0 |
| K₂O | 8.0 | 7.0 | 9.0 | 10.0 | 7.0 | 6.0 |
| BaO | 0.0 | 9.0 | 0.0 | 0.0 | 8.0 | 9.0 |
| MgO | 0.0 | 0.0 | 6.5 | 0.0 | 0.0 | 0.0 |
| CaO | 8.0 | 0.0 | 0.0 | 0.0 | 0.0 | 0.0 |
| SrO | 0.0 | 0.0 | 0.0 | 0.0 | 0.0 | 0.0 |
| SiO₂ | 0.0 | 0.0 | 0.0 | 0.0 | 0.0 | 1.0 |
| Y₂O₃ | 0.0 | 0.0 | 0.0 | 0.0 | 0.0 | 0.0 |
| SnO | 0.0 | 1.0 | 0.0 | 0.0 | 0.0 | 0.0 |
| Cu₂O | 0.0 | 0.0 | 0.0 | 0.0 | 0.0 | 0.0 |
| Ag₂O | 0.0 | 0.0 | 0.0 | 0.0 | 0.0 | 0.0 |
| MnO | 0.0 | 0.0 | 0.0 | 0.0 | 0.0 | 0.0 |
| Total | 100.0 | 100.0 | 100.0 | 100.0 | 100.0 | 100.0 |
| Water resistance (ΔW) [%] | 0.031 | 0.026 | 0.006 | 0.120 | 0.049 | 0.098 |
| Glass transition temperature Tg [°C] | 194 | 194 | 194 | 169 | 221 | 214 |

**[Table 9]**

| | Example 51 | Example 52 | Example 53 | Example 54 | Example 55 | Example 56 |
|---|---|---|---|---|---|---|
| Composition (mol%) | | | | | | |
| P₂O₅ | 62.5 | 63.0 | 61.0 | 60.0 | 60.0 | 60.0 |
| ZnO | 21.0 | 22.0 | 20.0 | 20.0 | 20.0 | 20.0 |
| Al₂O₃ | 2.0 | 2.0 | 2.0 | 1.0 | 1.0 | 1.0 |
| La₂O₃ | 3.0 | 3.0 | 0.0 | 1.0 | 1.0 | 1.0 |
| Lu₂O₃ | 0.0 | 0.0 | 3.0 | 0.0 | 0.0 | 0.0 |
| Ga₂O₃ | 0.0 | 0.0 | 0.0 | 1.0 | 1.0 | 1.0 |
| Li₂O | 0.0 | 0.0 | 0.0 | 0.0 | 0.0 | 0.0 |
| Na₂O | 0.0 | 0.0 | 0.0 | 0.0 | 0.0 | 0.0 |
| K₂O | 10.0 | 10.0 | 6.0 | 7.0 | 7.0 | 7.0 |
| BaO | 0.0 | 0.0 | 8.0 | 9.0 | 9.0 | 9.0 |
| MgO | 0.0 | 0.0 | 0.0 | 0.0 | 0.0 | 0.0 |
| CaO | 0.0 | 0.0 | 0.0 | 0.0 | 0.0 | 0.0 |
| SrO | 0.0 | 0.0 | 0.0 | 0.0 | 0.0 | 0.0 |
| SiO₂ | 1.5 | 0.0 | 0.0 | 0.0 | 0.0 | 0.0 |
| Y₂O₃ | 0.0 | 0.0 | 0.0 | 0.0 | 0.0 | 0.0 |
| SnO | 0.0 | 0.0 | 0.0 | 0.0 | 0.0 | 0.0 |
| Cu₂O | 0.0 | 0.0 | 0.0 | 1.0 | 0.0 | 0.0 |
| Ag₂O | 0.0 | 0.0 | 0.0 | 0.0 | 1.0 | 0.0 |
| MnO | 0.0 | 0.0 | 0.0 | 0.0 | 0.0 | 1.0 |
| Total | 100.0 | 100.0 | 100.0 | 100.0 | 100.0 | 100.0 |
| Water resistance (ΔW) [%] | 0.510 | 0.730 | 0.030 | 0.138 | 0.290 | 1.999 |
| Glass transition temperature Tg [°C] | 190 | 156 | 208 | 183 | 185 | 188 |

**[Table 10]**

| | Example 57 | Example 58 | Example 59 | Example 60 |
|---|---|---|---|---|
| Composition (mol%) | | | | |
| P₂O₅ | 60.0 | 60.0 | 60.0 | 60.0 |
| ZnO | 20.0 | 20.0 | 20.0 | 20.0 |
| Al₂O₃ | 1.0 | 1.0 | 1.0 | 1.0 |
| La₂O₃ | 1.0 | 1.0 | 1.0 | 1.0 |
| Lu₂O₃ | 0.0 | 0.0 | 0.0 | 0.0 |
| Ga₂O₃ | 1.9 | 1.9 | 1.9 | 2.0 |
| Li₂O | 0.0 | 0.0 | 0.0 | 0.0 |
| Na₂O | 0.0 | 0.0 | 0.0 | 0.0 |
| K₂O | 7.0 | 7.0 | 7.0 | 7.0 |
| BaO | 9.0 | 9.0 | 9.0 | 9.0 |
| MgO | 0.0 | 0.0 | 0.0 | 0.0 |
| CaO | 0.0 | 0.0 | 0.0 | 0.0 |
| SrO | 0.0 | 0.0 | 0.0 | 0.0 |
| SiO₂ | 0.0 | 0.0 | 0.0 | 0.0 |
| Y₂O₃ | 0.0 | 0.0 | 0.0 | 0.0 |
| SnO | 0.0 | 0.0 | 0.0 | 0.0 |
| Cu₂O | 0.1 | 0.0 | 0.0 | 0.0 |
| Ag₂O | 0.0 | 0.1 | 0.0 | 0.0 |
| MnO | 0.0 | 0.0 | 0.1 | 0.0 |
| Total | 100.0 | 100.0 | 100.0 | 100.0 |
| Water resistance (ΔW) [%] | 0.028 | 0.229 | 0.249 | 0.068 |
| Glass transition temperature Tg [°C] | 211 | 185 | 194 | 199 |

Table 11 shows the contents of the components, the water resistance, and the glass transition temperature of the phosphate glass PGS-Comp-1 to PGS-Comp-5 in Comparative Examples 1 to 5. Table 12 shows the contents of the components, the water resistance, and the glass transition temperature of the phosphate glass PGS-Comp-6 to PGS-Comp-10 in Comparative Examples 6 to 10. Table 13 shows the contents of the components, the water resistance, and the glass transition temperature of the phosphate glass PGS-Comp-11 to PGS-Comp-14 in Comparative Examples 11 to 14.

**[Table 11]**

| | Comparative Example 1 | Comparative Example 2 | Comparative Example 3 | Comparative Example 4 | Comparative Example 5 |
|---|---|---|---|---|---|
| Composition (mol%) | | | | | |
| P₂O₅ | 50.0 | 60.0 | 59.1 | 57.9 | 58.8 |
| ZnO | 50.0 | 30.0 | 27.3 | 26.3 | 29.4 |
| Al₂O₃ | 0.0 | 0.0 | 0.0 | 0.0 | 0.0 |
| La₂O₃ | 0.0 | 0.0 | 0.0 | 0.0 | 0.0 |
| Lu₂O₃ | 0.0 | 0.0 | 0.0 | 0.0 | 0.0 |
| Ga₂O₃ | 0.0 | 0.0 | 0.0 | 0.0 | 0.0 |
| Li₂O | 0.0 | 0.0 | 0.0 | 0.0 | 0.0 |
| Na₂O | 0.0 | 0.0 | 0.0 | 0.0 | 0.0 |
| K₂O | 0.0 | 0.0 | 4.5 | 5.3 | 0.0 |
| BaO | 0.0 | 10.0 | 9.1 | 10.5 | 11.8 |
| MgO | 0.0 | 0.0 | 0.0 | 0.0 | 0.0 |
| CaO | 0.0 | 0.0 | 0.0 | 0.0 | 0.0 |
| SiO₂ | 0.0 | 0.0 | 0.0 | 0.0 | 0.0 |
| Y₂O₃ | 0.0 | 0.0 | 0.0 | 0.0 | 0.0 |
| SnO | 0.0 | 0.0 | 0.0 | 0.0 | 0.0 |
| CU₂O | 0.0 | 0.0 | 0.0 | 0.0 | 0.0 |
| Ag₂O | 0.0 | 0.0 | 0.0 | 0.0 | 0.0 |
| MnO | 0.0 | 0.0 | 0.0 | 0.0 | 0.0 |
| Total | 100.0 | 100.0 | 100.0 | 100.0 | 100.0 |
| Water resistance (ΔW) [%] | 99.0 | 99.0 | 99.0 | 99.0 | 99.0 |
| Glass transition temperature Tg [°C] | 50 | 129 | 130 | 154 | 128 |

**[Table 12]**

| | Comparative Example 6 | Comparative Example 7 | Comparative Example 8 | Comparative Example 9 | Comparative Example 10 |
|---|---|---|---|---|---|
| Composition (mol%) | | | | | |
| P₂O₅ | 59.5 | 62.9 | 61.1 | 62.9 | 59.1 |
| ZnO | 21.6 | 22.9 | 22.2 | 22.9 | 21.5 |
| Al₂O₃ | 2.7 | 2.9 | 5.6 | 0.0 | 0.0 |
| La₂O₃ | 0.0 | 0.0 | 0.0 | 2.9 | 5.4 |
| Lu₂O₃ | 0.0 | 0.0 | 0.0 | 0.0 | 0.0 |
| Ga₂O₃ | 0.0 | 0.0 | 0.0 | 0.0 | 0.0 |
| Li₂O | 0.0 | 0.0 | 0.0 | 0.0 | 0.0 |
| Na₂O | 0.0 | 0.0 | 0.0 | 0.0 | 0.0 |
| K₂O | 5.4 | 5.6 | 5.5 | 5.6 | 5.4 |
| BaO | 10.8 | 5.7 | 5.6 | 5.7 | 8.6 |
| MgO | 0.0 | 0.0 | 0.0 | 0.0 | 0.0 |
| CaO | 0.0 | 0.0 | 0.0 | 0.0 | 0.0 |
| SiO₂ | 0.0 | 0.0 | 0.0 | 0.0 | 0.0 |
| Y₂O₃ | 0.0 | 0.0 | 0.0 | 0.0 | 0.0 |
| SnO | 0.0 | 0.0 | 0.0 | 0.0 | 0.0 |
| Cu₂O | 0.0 | 0.0 | 0.0 | 0.0 | 0.0 |
| Ag₂O | 0.0 | 0.0 | 0.0 | 0.0 | 0.0 |
| MnO | 0.0 | 0.0 | 0.0 | 0.0 | 0.0 |
| Total | 100.0 | 100.0 | 100.0 | 100.0 | 100.0 |
| Water resistance (ΔW) [%] | 57.0 | 57.0 | 64.0 | 50.0 | NG |
| Glass transition temperature Tg [°C] | 149 | 114 | 147 | 119 | Unmeasurable |

**[Table 13]**

| | Comparative Example 11 | Comparative Example 12 | Comparative Example 13 | Comparative Example 14 |
|---|---|---|---|---|
| Composition (mol%) | | | | |
| P₂O₅ | 58.7 | 62.8 | 53.5 | 59.3 |
| ZnO | 20.4 | 5.8 | 14.9 | 5.5 |
| Al₂O₃ | 0.0 | 2.9 | 2.5 | 2.7 |
| La₂O₃ | 5.1 | 2.9 | 2.5 | 2.7 |
| Lu₂O₃ | 0.0 | 0.0 | 0.0 | 0.0 |
| Ga₂O₃ | 0.0 | 0.0 | 0.0 | 0.0 |
| Li₂O | 0.0 | 0.0 | 0.0 | 0.0 |
| Na₂O | 0.0 | 0.0 | 0.0 | 0.0 |
| K₂O | 7.7 | 4.7 | 4.0 | 4.5 |
| BaO | 8.1 | 9.3 | 7.8 | 8.8 |
| MgO | 0.0 | 0.0 | 0.0 | 0.0 |
| CaO | 0.0 | 0.0 | 0.0 | 0.0 |
| SiO₂ | 0.0 | 0.0 | 0.0 | 0.0 |
| Y₂O₃ | 0.0 | 0.0 | 0.0 | 0.0 |
| SnO | 0.0 | 11.6 | 14.8 | 16.5 |
| Cu₂O | 0.0 | 0.0 | 0.0 | 0.0 |
| Ag₂O | 0.0 | 0.0 | 0.0 | 0.0 |
| MnO | 0.0 | 0.0 | 0.0 | 0.0 |
| Total | 100.0 | 100.0 | 100.0 | 100.0 |
| Water resistance (ΔW) [%] | NG | NG | NG | NG |
| Glass transition temperature Tg [°C] | Unmeasurable | Unmeasurable | Unmeasurable | Unmeasurable |

Table 14 shows the contents of the components, the water resistance, and the glass transition temperature of the phosphate glass PGS-61 to PGS-67 in Examples 61 to 67. Table 15 shows the contents of the components, the water resistance, and the glass transition temperature of the phosphate glass PGS-68 to PGS-74 in Examples 68 to 74. Table 16 shows the contents of the components, the water resistance, and the glass transition temperature of the phosphate glass PGS-75 to PGS-81 in Examples 75 to 81. Table 17 shows the contents of the components, the water resistance, and the glass transition temperature of the phosphate glass PGS-82 to PGS-87 in Examples 82 to 87. Table 18 shows the contents of the components, the water resistance, and the glass transition temperature of the phosphate glass PGS-88 to PGS-93 in Examples 88 to 93. Table 19 shows the contents of the components, the water resistance, and the glass transition temperature of the phosphate glass PGS-94 to PGS-100 in Examples 94 to 100.

**[Table 14]**

| | Example 61 | Example 62 | Example 63 | Example 64 | Example 65 | Example 66 | Example 67 |
|---|---|---|---|---|---|---|---|
| Composition (mol%) | | | | | | | |
| P₂O₅ | 58.5 | 57.1 | 57.6 | 58.5 | 62.8 | 56.1 | 55.8 |
| ZnO | 22.1 | 21.0 | 13.1 | 14.6 | 17.4 | 25.5 | 24.3 |
| Al₂O₃ | 2.9 | 2.4 | 6.1 | 4.9 | 2.9 | 2.55 | 2.4 |
| La₂O₃ | 2.2 | 2.4 | 3.0 | 2.4 | 2.9 | 2.55 | 2.4 |
| Lu₂O₃ | 0.0 | 0.0 | 0.0 | 0.0 | 0.0 | 0.0 | 0.0 |
| Ga₂O₃ | 0.0 | 0.0 | 0.0 | 0.0 | 0.0 | 0.0 | 0.0 |
| Li₂O | 0.0 | 0.0 | 0.0 | 0.0 | 0.0 | 0.0 | 0.0 |
| Na₂O | 0.0 | 0.0 | 0.0 | 0.0 | 0.0 | 0.0 | 0.0 |
| K₂O | 5.5 | 9.5 | 10.1 | 9.8 | 4.7 | 5.1 | 7.3 |
| BaO | 8.8 | 7.6 | 10.1 | 9.8 | 9.3 | 8.2 | 7.8 |
| MgO | 0.0 | 0.0 | 0.0 | 0.0 | 0.0 | 0.0 | 0.0 |
| CaO | 0.0 | 0.0 | 0.0 | 0.0 | 0.0 | 0.0 | 0.0 |
| SrO | 0.0 | 0.0 | 0.0 | 0.0 | 0.0 | 0.0 | 0.0 |
| SiO₂ | 0.0 | 0.0 | 0.0 | 0.0 | 0.0 | 0.0 | 0.0 |
| Y₂O₃ | 0.0 | 0.0 | 0.0 | 0.0 | 0.0 | 0.0 | 0.0 |
| SnO | 0.0 | 0.0 | 0.0 | 0.0 | 0.0 | 0.0 | 0.0 |
| Cu₂O | 0.0 | 0.0 | 0.0 | 0.0 | 0.0 | 0.0 | 0.0 |
| Ag₂O | 0.0 | 0.0 | 0.0 | 0.0 | 0.0 | 0.0 | 0.0 |
| MnO | 0.0 | 0.0 | 0.0 | 0.0 | 0.0 | 0.0 | 0.0 |
| Total | 100.0 | 100.0 | 100.0 | 100.0 | 100.0 | 100.0 | 100.0 |
| Water resistance (ΔW) [%] | 0.050 | 0.077 | 0.016 | 0.246 | 0.373 | 0.120 | 0.147 |
| Glass transition temperature Tg [°C] | 323 | 315 | 393 | 309 | 276 | 295 | 315 |

**[Table 15]**

| | Example 68 | Example 69 | Example 70 | Example 71 | Example 72 | Example 73 | Example 74 |
|---|---|---|---|---|---|---|---|
| Composition (mol%) | | | | | | | |
| P₂O₅ | 59.6 | 59.5 | 62.5 | 60.0 | 60.0 | 60.0 | 62.5 |
| ZnO | 20.7 | 21.6 | 21.7 | 20.0 | 20.0 | 20.0 | 21.7 |
| Al₂O₃ | 2.6 | 2.7 | 2.7 | 1.5 | 1.5 | 1.0 | 0.0 |
| La₂O₃ | 1.0 | 2.2 | 2.2 | 2.0 | 1.5 | 1.5 | 2.2 |
| Lu₂O₃ | 0.0 | 0.0 | 0.0 | 1.5 | 0.0 | 0.0 | 0.0 |
| Ga₂O₃ | 0.0 | 0.0 | 0.0 | 0.0 | 0.0 | 0.5 | 2.7 |
| Li₂O | 0.0 | 0.0 | 0.0 | 0.0 | 0.0 | 0.0 | 0.0 |
| Na₂O | 0.0 | 0.0 | 0.0 | 0.0 | 0.0 | 0.0 | 0.0 |
| K₂O | 7.8 | 5.4 | 5.5 | 6.0 | 6.0 | 6.0 | 5.5 |
| BaO | 8.3 | 8.6 | 5.4 | 9.0 | 9.0 | 9.0 | 5.4 |
| MgO | 0.0 | 0.0 | 0.0 | 0.0 | 0.0 | 0.0 | 0.0 |
| CaO | 0.0 | 0.0 | 0.0 | 0.0 | 0.0 | 0.0 | 0.0 |
| SrO | 0.0 | 0.0 | 0.0 | 0.0 | 0.0 | 0.0 | 0.0 |
| SiO₂ | 0.0 | 0.0 | 0.0 | 0.0 | 0.0 | 0.0 | 0.0 |
| Y₂O₃ | 0.0 | 0.0 | 0.0 | 0.0 | 2.0 | 2.0 | 0.0 |
| SnO | 0.0 | 0.0 | 0.0 | 0.0 | 0.0 | 0.0 | 0.0 |
| Cu₂O | 0.0 | 0.0 | 0.0 | 0.0 | 0.0 | 0.0 | 0.0 |
| Ag₂O | 0.0 | 0.0 | 0.0 | 0.0 | 0.0 | 0.0 | 0.0 |
| MnO | 0.0 | 0.0 | 0.0 | 0.0 | 0.0 | 0.0 | 0.0 |
| Total | 100.0 | 100.0 | 100.0 | 100.0 | 100.0 | 100.0 | 100.0 |
| Water resistance (ΔW) [%] | 0.587 | 0.153 | 0.038 | 0.572 | 0.556 | 0.542 | 0.009 |
| Glass transition temperature Tg [°C] | 276 | 297 | 310 | 358 | 333 | 372 | 298 |

**[Table 16]**

| | Example 75 | Example 76 | Example 77 | Example 78 | Example 79 | Example 80 | Example 81 |
|---|---|---|---|---|---|---|---|
| Composition (mol%) | | | | | | | |
| P₂O₅ | 60.0 | 60.0 | 60.0 | 62.5 | 60.0 | 60.0 | 60.0 |
| ZnO | 20.0 | 20.0 | 20.0 | 21.7 | 20.0 | 20.0 | 20.0 |
| Al₂O₃ | 2.0 | 1.5 | 1.5 | 0.0 | 0.0 | 0.0 | 0.0 |
| La₂O₃ | 0.0 | 0.0 | 0.0 | 2.2 | 3.0 | 1.0 | 0.0 |
| Lu₂O₃ | 1.0 | 1.5 | 1.5 | 0.0 | 0.0 | 0.0 | 3.0 |
| Ga₂O₃ | 2.0 | 1.0 | 0.0 | 0.0 | 0.0 | 2.0 | 0.0 |
| Li₂O | 0.0 | 0.0 | 0.0 | 0.0 | 0.0 | 0.0 | 0.0 |
| Na₂O | 0.0 | 0.0 | 0.0 | 0.0 | 0.0 | 0.0 | 0.0 |
| K₂O | 6.0 | 6.0 | 6.0 | 5.5 | 6.0 | 6.0 | 6.0 |
| BaO | 9.0 | 9.0 | 9.0 | 5.4 | 9.0 | 9.0 | 9.0 |
| MgO | 0.0 | 0.0 | 0.0 | 0.0 | 0.0 | 0.0 | 0.0 |
| CaO | 0.0 | 0.0 | 0.0 | 0.0 | 0.0 | 0.0 | 0.0 |
| SrO | 0.0 | 0.0 | 0.0 | 0.0 | 0.0 | 0.0 | 0.0 |
| SiO₂ | 0.0 | 0.0 | 0.0 | 0.0 | 0.0 | 0.0 | 0.0 |
| Y₂O₃ | 0.0 | 1.0 | 2.0 | 2.7 | 2.0 | 2.0 | 2.0 |
| SnO | 0.0 | 0.0 | 0.0 | 0.0 | 0.0 | 0.0 | 0.0 |
| Cu₂O | 0.0 | 0.0 | 0.0 | 0.0 | 0.0 | 0.0 | 0.0 |
| Ag₂O | 0.0 | 0.0 | 0.0 | 0.0 | 0.0 | 0.0 | 0.0 |
| MnO | 0.0 | 0.0 | 0.0 | 0.0 | 0.0 | 0.0 | 0.0 |
| Total | 100.0 | 100.0 | 100.0 | 100.0 | 100.0 | 100.0 | 100.0 |
| Water resistance (ΔW) [%] | 0.030 | 0.536 | 0.299 | 0.089 | 0.377 | 0.346 | 0.323 |
| Glass transition temperature Tg [°C] | 386 | 366 | 344 | 285 | 316 | 358 | 291 |

**[Table 17]**

| | Example 82 | Example 83 | Example 84 | Example 85 | Example 86 | Example 87 |
|---|---|---|---|---|---|---|
| Composition (mol%) | | | | | | |
| P₂O₅ | 62.8 | 60.0 | 62.8 | 62.5 | 60.2 | 62.5 |
| ZnO | 17.4 | 20.0 | 17.4 | 21.8 | 20.9 | 21.5 |
| Al₂O₃ | 0.0 | 0.0 | 0.0 | 2.7 | 2.6 | 1.5 |
| La₂O₃ | 0.0 | 0.0 | 2.9 | 2.2 | 2.6 | 2.5 |
| Lu₂O₃ | 2.9 | 1.0 | 0.0 | 0.0 | 0.0 | 0.0 |
| Ga₂O₃ | 2.9 | 2.0 | 2.9 | 0.0 | 0.0 | 0.0 |
| Li₂O | 0.0 | 0.0 | 0.0 | 1.8 | 1.8 | 12.0 |
| Na₂O | 0.0 | 0.0 | 0.0 | 1.8 | 1.8 | 0.0 |
| K₂O | 4.7 | 6.0 | 4.7 | 1.8 | 1.8 | 0.0 |
| BaO | 9.3 | 9.0 | 9.3 | 5.4 | 8.3 | 0.0 |
| MgO | 0.0 | 0.0 | 0.0 | 0.0 | 0.0 | 0.0 |
| CaO | 0.0 | 0.0 | 0.0 | 0.0 | 0.0 | 0.0 |
| SrO | 0.0 | 0.0 | 0.0 | 0.0 | 0.0 | 0.0 |
| SiO₂ | 0.0 | 0.0 | 0.0 | 0.0 | 0.0 | 0.0 |
| Y₂O₃ | 0.0 | 2.0 | 0.0 | 0.0 | 0.0 | 0.0 |
| SnO | 0.0 | 0.0 | 0.0 | 0.0 | 0.0 | 0.0 |
| Cu₂O | 0.0 | 0.0 | 0.0 | 0.0 | 0.0 | 0.0 |
| Ag₂O | 0.0 | 0.0 | 0.0 | 0.0 | 0.0 | 0.0 |
| MnO | 0.0 | 0.0 | 0.0 | 0.0 | 0.0 | 0.0 |
| Total | 100.0 | 100.0 | 100.0 | 100.0 | 100.0 | 100.0 |
| Water resistance (ΔW) [%] | 0.075 | 0.537 | 0.017 | 0.121 | 0.049 | 0.196 |
| Glass transition temperature Tg [°C] | 266 | 316 | 295 | 294 | 341 | 292 |

**[Table 18]**

| | Example 88 | Example 89 | Example 90 | Example 90-2 | Example 91 | Example 92 | Example 93 |
|---|---|---|---|---|---|---|---|
| Composition (mol%) | | | | | | | |
| P₂O₅ | 62.5 | 62.0 | 62.1 | 62.1 | 57.1 | 59.0 | 59.0 |
| ZnO | 21.5 | 21.0 | 22.6 | 22.6 | 15.8 | 20.0 | 20.0 |
| Al₂O₃ | 1.5 | 2.0 | 2.8 | 2.8 | 2.6 | 1.0 | 3.5 |
| La₂O₃ | 2.5 | 3.0 | 1.1 | 1.1 | 2.6 | 3.0 | 3.0 |
| Lu₂O₃ | 0.0 | 0.0 | 0.0 | 0.0 | 0.0 | 0.0 | 0.0 |
| Ga₂O₃ | 0.0 | 0.0 | 0.0 | 0.0 | 0.0 | 0.0 | 0.0 |
| Li₂O | 0.0 | 0.0 | 0.0 | 0.0 | 0.0 | 0.0 | 0.0 |
| Na₂O | 12.0 | 6.0 | 0.0 | 0.0 | 0.0 | 0.0 | 0.0 |
| K₂O | 0.0 | 6.0 | 5.7 | 5.7 | 4.3 | 14.0 | 14.5 |
| BaO | 0.0 | 0.0 | 0.0 | 0.0 | 8.5 | 0.0 | 0.0 |
| MgO | 0.0 | 0.0 | 0.0 | 0.0 | 0.0 | 3.0 | 0.0 |
| CaO | 0.0 | 0.0 | 5.7 | 0.0 | 0.0 | 0.0 | 0.0 |
| SrO | 0.0 | 0.0 | 0.0 | 5.7 | 0.0 | 0.0 | 0.0 |
| SiO₂ | 0.0 | 0.0 | 0.0 | 0.0 | 0.0 | 0.0 | 0.0 |
| Y₂O₃ | 0.0 | 0.0 | 0.0 | 0.0 | 0.0 | 0.0 | 0.0 |
| SnO | 0.0 | 0.0 | 0.0 | 0.0 | 9.1 | 0.0 | 0.0 |
| Cu₂O | 0.0 | 0.0 | 0.0 | 0.0 | 0.0 | 0.0 | 0.0 |
| Ag₂O | 0.0 | 0.0 | 0.0 | 0.0 | 0.0 | 0.0 | 0.0 |
| MnO | 0.0 | 0.0 | 0.0 | 0.0 | 0.0 | 0.0 | 0.0 |
| Total | 100.0 | 100.0 | 100.0 | 100.0 | 100.0 | 100.0 | 100.0 |
| Water resistance (ΔW) [%] | 0.127 | 0.242 | 0.340 | 0.079 | 0.059 | 0.350 | 0.347 |
| Glass transition temperature Tg [°C] | 262 | 319 | 258 | 335 | 359 | 298 | 304 |

**[Table 19]**

| | Example 94 | Example 95 | Example 96 | Example 97 | Example 98 | Example 99 | Example 100 |
|---|---|---|---|---|---|---|---|
| Composition (mol%) | | | | | | | |
| P₂O₅ | 62.8 | 58.5 | 62.1 | 59.0 | 57.5 | 57.0 | 56.7 |
| ZnO | 17.4 | 22.0 | 17.2 | 20.0 | 13.5 | 12.5 | 11.7 |
| Al₂O₃ | 1.4 | 2.9 | 2.9 | 1.0 | 2.0 | 1.0 | 0.7 |
| La₂O₃ | 2.9 | 2.2 | 2.9 | 3.0 | 2.0 | 1.0 | 0.7 |
| Lu₂O₃ | 0.0 | 0.0 | 0.0 | 0.0 | 0.0 | 0.0 | 0.0 |
| Ga₂O₃ | 1.5 | 0.0 | 0.0 | 0.0 | 0.0 | 0.0 | 0.0 |
| Li₂O | 0.0 | 0.0 | 0.0 | 0.0 | 0.0 | 0.0 | 0.0 |
| Na₂O | 0.0 | 0.0 | 0.0 | 0.0 | 0.0 | 0.0 | 0.0 |
| K₂O | 4.7 | 5.5 | 4.6 | 14.5 | 10.0 | 11.5 | 11.9 |
| BaO | 9.3 | 8.8 | 9.2 | 0.0 | 10.0 | 10.0 | 9.8 |
| MgO | 0.0 | 0.0 | 0.0 | 0.0 | 0.0 | 0.0 | 0.0 |
| CaO | 0.0 | 0.0 | 0.0 | 0.0 | 0.0 | 0.0 | 0.0 |
| SrO | 0.0 | 0.0 | 0.0 | 0.0 | 0.0 | 0.0 | 0.0 |
| SiO₂ | 0.0 | 0.1 | 1.1 | 2.5 | 5.0 | 7.0 | 8.5 |
| Y₂O₃ | 0.0 | 0.0 | 0.0 | 0.0 | 0.0 | 0.0 | 0.0 |
| SnO | 0.0 | 0.0 | 0.0 | 0.0 | 0.0 | 0.0 | 0.0 |
| Cu₂O | 0.0 | 0.0 | 0.0 | 0.0 | 0.0 | 0.0 | 0.0 |
| Ag₂O | 0.0 | 0.0 | 0.0 | 0.0 | 0.0 | 0.0 | 0.0 |
| MnO | 0.0 | 0.0 | 0.0 | 0.0 | 0.0 | 0.0 | 0.0 |
| Total | 100.0 | 100.0 | 100.0 | 100.0 | 100.0 | 100.0 | 100.0 |
| Water resistance (ΔW) [%] | 0.011 | 0.102 | 0.031 | 0.250 | 0.009 | 0.110 | 0.503 |
| Glass transition temperature Tg [°C] | 304 | 345 | 304 | 296 | 325 | 300 | 292 |

Table 20 shows the contents of the components, the water resistance, and the glass transition temperature of the phosphate glass PGS-101 to PGS-106 in Examples 101 to 106. Table 21 shows the contents of the components, the water resistance, and the glass transition temperature of the phosphate glass PGS-107 to PGS-112 in Examples 107 to 112. Table 22 shows the contents of the components, the water resistance, and the glass transition temperature of the phosphate glass PGS-113 to PGS-118 in Examples 113 to 118. Table 23 shows the contents of the components, the water resistance, and the glass transition temperature of the phosphate glass PGS-119 to PGS-125 in Examples 119 to 125.

**[Table 20]**

| | Example 101 | Example 102 | Example 103 | Example 104 | Example 105 | Example 106 |
|---|---|---|---|---|---|---|
| Composition (mol%) | | | | | | |
| P₂O₅ | 60.0 | 61.0 | 60.0 | 60.0 | 60.0 | 60.0 |
| ZnO | 20.0 | 20.5 | 20.0 | 20.0 | 20.0 | 20.0 |
| Al₂O₃ | 2.0 | 0.0 | 0.0 | 0.0 | 0.0 | 1.5 |
| La₂O₃ | 3.0 | 1.5 | 3.0 | 0.0 | 2.0 | 1.5 |
| Lu₂O₃ | 0.0 | 0.0 | 0.0 | 1.0 | 0.0 | 0.0 |
| Ga₂O₃ | 0.0 | 2.0 | 0.0 | 2.0 | 2.0 | 0.0 |
| Li₂O | 0.0 | 0.0 | 0.0 | 0.0 | 0.0 | 1.0 |
| Na₂O | 0.0 | 0.0 | 0.0 | 0.0 | 0.0 | 1.0 |
| K₂O | 6.0 | 6.0 | 6.0 | 7.0 | 7.0 | 6.0 |
| BaO | 9.0 | 9.0 | 9.0 | 10.0 | 9.0 | 9.0 |
| MgO | 0.0 | 0.0 | 0.0 | 0.0 | 0.0 | 0.0 |
| CaO | 0.0 | 0.0 | 0.0 | 0.0 | 0.0 | 0.0 |
| SrO | 0.0 | 0.0 | 0.0 | 0.0 | 0.0 | 0.0 |
| SiO₂ | 0.0 | 0.0 | 0.0 | 0.0 | 0.0 | 0.0 |
| Y₂O₃ | 0.0 | 0.0 | 2.0 | 0.0 | 0.0 | 0.0 |
| SnO | 0.0 | 0.0 | 0.0 | 0.0 | 0.0 | 0.0 |
| Cu₂O | 0.0 | 0.0 | 0.0 | 0.0 | 0.0 | 0.0 |
| Ag₂O | 0.0 | 0.0 | 0.0 | 0.0 | 0.0 | 0.0 |
| MnO | 0.0 | 0.0 | 0.0 | 0.0 | 0.0 | 0.0 |
| Total | 100.0 | 100.0 | 100.0 | 100.0 | 100.0 | 100.0 |
| Water resistance (ΔW) [%] | 0.019 | 0.031 | 0.020 | 0.045 | 0.145 | 0.014 |
| Glass transition temperature Tg [°C] | 346 | 317 | 349 | 303 | 357 | 314 |

**[Table 21]**

| | Example 107 | Example 108 | Example 109 | Example 110 | Example 111 | Example 112 |
|---|---|---|---|---|---|---|
| Composition (mol%) | | | | | | |
| P₂O₅ | 60.0 | 60.0 | 60.0 | 62.5 | 60.0 | 60.0 |
| ZnO | 20.0 | 20.0 | 20.0 | 22.0 | 20.0 | 20.0 |
| Al₂O₃ | 2.0 | 1.0 | 1.5 | 1.5 | 1.5 | 1.5 |
| La₂O₃ | 2.0 | 2.0 | 3.0 | 2.0 | 2.5 | 2.5 |
| Lu₂O₃ | 0.0 | 0.0 | 0.0 | 0.0 | 0.0 | 0.0 |
| Ga₂O₃ | 0.0 | 0.0 | 0.0 | 2.0 | 1.0 | 0.0 |
| Li₂O | 0.0 | 0.0 | 0.0 | 0.0 | 0.0 | 0.0 |
| Na₂O | 0.0 | 0.0 | 0.0 | 0.0 | 0.0 | 0.0 |
| K₂O | 8.0 | 7.0 | 9.0 | 10.0 | 7.0 | 6.0 |
| BaO | 0.0 | 9.0 | 0.0 | 0.0 | 8.0 | 9.0 |
| MgO | 0.0 | 0.0 | 6.5 | 0.0 | 0.0 | 0.0 |
| CaO | 8.0 | 0.0 | 0.0 | 0.0 | 0.0 | 0.0 |
| SrO | 0.0 | 0.0 | 0.0 | 0.0 | 0.0 | 0.0 |
| SiO₂ | 0.0 | 0.0 | 0.0 | 0.0 | 0.0 | 1.0 |
| Y₂O₃ | 0.0 | 0.0 | 0.0 | 0.0 | 0.0 | 0.0 |
| SnO | 0.0 | 1.0 | 0.0 | 0.0 | 0.0 | 0.0 |
| Cu₂O | 0.0 | 0.0 | 0.0 | 0.0 | 0.0 | 0.0 |
| Ag₂O | 0.0 | 0.0 | 0.0 | 0.0 | 0.0 | 0.0 |
| MnO | 0.0 | 0.0 | 0.0 | 0.0 | 0.0 | 0.0 |
| Total | 100.0 | 100.0 | 100.0 | 100.0 | 100.0 | 100.0 |
| Water resistance (ΔW) [%] | 0.031 | 0.033 | 0.382 | 0.12 | 0.049 | 0.098 |
| Glass transition temperature Tg [°C] | 342 | 339 | 350 | 328 | 355 | 319 |

**[Table 22]**

| | Example 113 | Example 114 | Example 115 | Example 116 | Example 117 | Example 118 |
|---|---|---|---|---|---|---|
| Composition (mol%) | | | | | | |
| P₂O₅ | 62.5 | 63.0 | 61.0 | 60.0 | 60.0 | 60.0 |
| ZnO | 21.0 | 22.0 | 20.0 | 20.0 | 20.0 | 20.0 |
| Al₂O₃ | 2.0 | 2.0 | 2.0 | 1.0 | 1.0 | 1.0 |
| La₂O₃ | 3.0 | 3.0 | 0.0 | 1.0 | 1.0 | 1.0 |
| Lu₂O₃ | 0.0 | 0.0 | 3.0 | 0.0 | 0.0 | 0.0 |
| Ga₂O₃ | 0.0 | 0.0 | 0.0 | 1.0 | 1.0 | 1.0 |
| Li₂O | 0.0 | 0.0 | 0.0 | 0.0 | 0.0 | 0.0 |
| Na₂O | 0.0 | 0.0 | 0.0 | 0.0 | 0.0 | 0.0 |
| K₂O | 10.0 | 10.0 | 6.0 | 7.0 | 7.0 | 7.0 |
| BaO | 0.0 | 0.0 | 8.0 | 9.0 | 9.0 | 9.0 |
| MgO | 0.0 | 0.0 | 0.0 | 0.0 | 0.0 | 0.0 |
| CaO | 0.0 | 0.0 | 0.0 | 0.0 | 0.0 | 0.0 |
| SrO | 0.0 | 0.0 | 0.0 | 0.0 | 0.0 | 0.0 |
| SiO₂ | 1.5 | 0.0 | 0.0 | 0.0 | 0.0 | 0.0 |
| Y₂O₃ | 0.0 | 0.0 | 0.0 | 0.0 | 0.0 | 0.0 |
| SnO | 0.0 | 0.0 | 0.0 | 0.0 | 0.0 | 0.0 |
| Cu₂O | 0.0 | 0.0 | 0.0 | 1.0 | 0.0 | 0.0 |
| Ag₂O | 0.0 | 0.0 | 0.0 | 0.0 | 1.0 | 0.0 |
| MnO | 0.0 | 0.0 | 0.0 | 0.0 | 0.0 | 1.0 |
| Total | 100.0 | 100.0 | 100.0 | 100.0 | 100.0 | 100.0 |
| Water resistance (ΔW) [%] | 0.051 | 0.218 | 0.030 | 0.527 | 0.490 | 0.580 |
| Glass transition temperature Tg [°C] | 340 | 312 | 328 | 319 | 314 | 333 |

**[Table 23]**

| | Example 119 | Example 120 | Example 121 | Example 122 | Example 123 | Example 124 | Example 125 |
|---|---|---|---|---|---|---|---|
| Composition (mol%) | | | | | | | |
| P₂O₅ | 60.0 | 60.0 | 60.0 | 60.0 | 60.0 | 60.0 | 60.0 |
| ZnO | 20.0 | 20.0 | 20.0 | 20.0 | 20.0 | 20.0 | 20.0 |
| Al₂O₃ | 1.0 | 1.0 | 1.0 | 1.0 | 1.0 | 1.0 | 1.0 |
| La₂O₃ | 1.0 | 1.0 | 1.0 | 1.0 | 1.0 | 1.0 | 1.0 |
| Lu₂O₃ | 0.0 | 0.0 | 0.0 | 0.0 | 0.0 | 0.0 | 0.0 |
| Ga₂O₃ | 1.9 | 1.9 | 1.9 | 2.0 | 2.0 | 2.0 | 2.0 |
| Li₂O | 0.0 | 0.0 | 0.0 | 0.0 | 0.0 | 0.0 | 0.0 |
| Na₂O | 0.0 | 0.0 | 0.0 | 0.0 | 0.0 | 0.0 | 0.0 |
| K₂O | 7.0 | 7.0 | 7.0 | 7.0 | 7.0 | 7.0 | 7.0 |
| BaO | 9.0 | 9.0 | 9.0 | 9.0 | 9.0 | 9.0 | 9.0 |
| MgO | 0.0 | 0.0 | 0.0 | 0.0 | 0.0 | 0.0 | 0.0 |
| CaO | 0.0 | 0.0 | 0.0 | 0.0 | 0.0 | 0.0 | 0.0 |
| SrO | 0.0 | 0.0 | 0.0 | 0.0 | 0.0 | 0.0 | 0.0 |
| SiO₂ | 0.0 | 0.0 | 0.0 | 0.0 | 0.0 | 0.0 | 0.0 |
| Y₂O₃ | 0.0 | 0.0 | 0.0 | 0.0 | 0.0 | 0.0 | 0.0 |
| SnO | 0.0 | 0.0 | 0.0 | 0.0 | 0.0 | 0.0 | 0.0 |
| Cu₂O | 0.1 | 0.0 | 0.0 | 0.0 | 0.01 | 0.0 | 0.0 |
| Ag₂O | 0.0 | 0.1 | 0.0 | 0.0 | 0.0 | 0.01 | 0.0 |
| MnO | 0.0 | 0.0 | 0.1 | 0.0 | 0.0 | 0.0 | 0.01 |
| Total | 100.0 | 100.0 | 100.0 | 100.0 | 100.01 | 100.01 | 100.01 |
| Water resistance (ΔW) [%] | 0.01 | 0.045 | 0.033 | 0.005 | 0.127 | 0.191 | 0.262 |
| Glass transition temperature Tg [°C] | 336 | 352 | 335 | 354 | 328 | 331 | 337 |

Table 24 shows the contents of the components, the water resistance, and the glass transition temperature of the phosphate glass PGS-Comp-15 to PGS-Comp-19 in Comparative Examples 15 to 19. Table 25 shows the contents of the components, the water resistance, and the glass transition temperature of the phosphate glass PGS-Comp-20 to PGS-Comp-23 in Comparative Examples 20 to 23.

**[Table 24]**

| | Comparative Example 15 | Comparative Example 16 | Comparative Example 17 | Comparative Example 18 | Comparative Example 19 |
|---|---|---|---|---|---|
| Composition (mol%) | | | | | |
| P₂O₅ | 65.7 | 69.2 | 59.0 | 75.5 | 62.5 |
| ZnO | 23.5 | 4.4 | 21.9 | 9.8 | 32.0 |
| Al₂O₃ | 2.9 | 3.5 | 0.9 | 4.9 | 5.5 |
| La₂O₃ | 0.0 | 1.8 | 0.0 | 2.0 | 0.0 |
| Lu₂O₃ | 0.0 | 0.0 | 0.0 | 0.0 | 0.0 |
| Ga₂O₃ | 0.0 | 0.0 | 0.0 | 0.0 | 0.0 |
| Li₂O | 0.0 | 0.0 | 0.0 | 0.0 | 0.0 |
| Na₂O | 0.0 | 0.0 | 0.0 | 0.0 | 0.0 |
| K₂O | 3.0 | 18.5 | 13.6 | 2.9 | 0.0 |
| BaO | 4.9 | 2.6 | 4.6 | 4.9 | 0.0 |
| MgO | 0.0 | 0.0 | 0.0 | 0.0 | 0.0 |
| CaO | 0.0 | 0.0 | 0.0 | 0.0 | 0.0 |
| SiO₂ | 0.0 | 0.0 | 0.0 | 0.0 | 0.0 |
| Y₂O₃ | 0.0 | 0.0 | 0.0 | 0.0 | 0.0 |
| SnO | 0.0 | 0.0 | 0.0 | 0.0 | 0.0 |
| Cu₂O | 0.0 | 0.0 | 0.0 | 0.0 | 0.0 |
| Ag₂O | 0.0 | 0.0 | 0.0 | 0.0 | 0.0 |
| MnO | 0.0 | 0.0 | 0.0 | 0.0 | 0.0 |
| Total | 100.0 | 100.0 | 100.0 | 100.0 | 100.0 |
| Water resistance (ΔW) [%] | 18.528 | NG | 2.443 | NG | NG |
| Glass transition temperature Tg [°C] | 256 | Unmeasurable | 243 | Unmeasurable | Unmeasurable |

**[Table 25]**

| | Comparative Example 20 | Comparative Example 21 | Comparative Example 22 | Comparative Example 23 |
|---|---|---|---|---|
| Composition (mol%) | | | | |
| P₂O₅ | 65.0 | 63.4 | 59.5 | 54.0 |
| ZnO | 24.0 | 24.3 | 21.6 | 18.4 |
| Al₂O₃ | 2.0 | 5.4 | 2.7 | 3.1 |
| La₂O₃ | 0.5 | 0.0 | 0.0 | 9.8 |
| Lu₂O₃ | 0.5 | 0.0 | 0.0 | 0.0 |
| Ga₂O₃ | 0.0 | 0.0 | 0.0 | 0.0 |
| Li₂O | 0.0 | 0.0 | 0.0 | 0.0 |
| Na₂O | 0.0 | 0.0 | 0.0 | 0.0 |
| K₂O | 2.5 | 4.9 | 5.4 | 4.9 |
| BaO | 5.5 | 2.0 | 10.8 | 9.8 |
| MgO | 0.0 | 0.0 | 0.0 | 0.0 |
| CaO | 0.0 | 0.0 | 0.0 | 0.0 |
| SiO₂ | 0.0 | 0.0 | 0.0 | 0.0 |
| Y₂O₃ | 0.0 | 0.0 | 0.0 | 0.0 |
| SnO | 0.0 | 0.0 | 0.0 | 0.0 |
| Cu₂O | 0.0 | 0.0 | 0.0 | 0.0 |
| Ag₂O | 0.0 | 0.0 | 0.0 | 0.0 |
| MnO | 0.0 | 0.0 | 0.0 | 0.0 |
| Total | 100.0 | 100.0 | 100.0 | 100.0 |
| Water resistance (ΔW) [%] | 8.078 | NG | 1.021 | NG |
| Glass transition temperature Tg [°C] | 238 | Unmeasurable | 285 | Unmeasurable |

In Tables 1 to 25, a smaller value of the loss rate ΔW means higher water resistance, and a larger value of the loss rate ΔW means lower water resistance.

The notation "NG" in Tables 12, 13, 24, and 25 means to be in one of the following states.
(1) The phosphate glass has too high viscosity to flow out.
(2) Vitrification is not achieved.
(3) Phosphoric acid volatilizes so strongly due to the large P₂O₅ content that vitrification cannot be achieved.

Tables 1 to 13 show Examples 1 to 60 and Comparative Examples 1 to 14 in which the phosphate glass PGS was produced through melting at 500°C, and Tables 14 to 25 show Examples 61 to 125 and Comparative Examples 15 to 23 in which the phosphate glass PGS was produced through melting at 800°C.

### [Phosphate Glass Melted at 500°C]

In the phosphate glass PGS-1 to PGS-60 in Examples 1 to 60, the content of P₂O₅ is in the range of 56.1 [mol%] to 64.9 [mol%] in terms of mole percentage based on oxides, the content of ZnO is in the range of 10.8 [mol%] to 25.4 [mol%] in terms of mole percentage based on oxides, the content of Al₂O₃ is in the range of 0.0 [mol%] to 4.9 [mol%] in terms of mole percentage based on oxides, the content of La₂O₃ is in the range of 0.0 [mol%] to 3.0 [mol%] in terms of mole percentage based on oxides, the content of Lu₂O₃ is in the range of 0.0 [mol%] to 3.0 [mol%] in terms of mole percentage based on oxides, the content of Ga₂O₃ is in the range of 0.0 [mol%] to 2.9 [mol%] in terms of mole percentage based on oxides, the content of K₂O is in the range of 0.0 [mol%] to 14.5 [mol%] in terms of mole percentage based on oxides, the content of BaO is in the range of 0.0 [mol%] to 11.1 [mol%] in terms of mole percentage based on oxides, the content of CaO is in the range of 0.0 [mol%] to 8.0 [mol%] in terms of mole percentage based on oxides, the content of SrO is in the range of 0.0 [mol%] to 5.7 [mol%] in terms of mole percentage based on oxides, the content of SiO₂ is in the range of 0.0 [mol%] to 8.5 [mol%] in terms of mole percentage based on oxides, the content of Y₂O₃ is in the range of 0.0 [mol%] to 2.0 [mol%] in terms of mole percentage based on oxides, the content of SnO is in the range of 0.0 [mol%] to 9.1 [mol%] in terms of mole percentage based on oxides, the content of Cu₂O is in the range of 0.0 [mol%] to 1.0 [mol%] in terms of mole percentage based on oxides, the content of Ag₂O is in the range of 0.0 [mol%] to 1.0 [mol%] in terms of mole percentage based on oxides, and the content of MnO is in the range of 0.0 [mol%] to 1.0 [mol%] in terms of mole percentage based on oxides (see Tables 1 to 10).

In the phosphate glass PGS-1 to PGS-60 in Examples 1 to 60, the mass loss rate ΔW of the phosphate glass (hereinafter referred to as "water resistance") is 25.0 [%] or less, and the glass transition temperature Tg is 125°C to 232°C. The loss rate ΔW of 25.0 [%] or less is half or less the loss rate ΔW of the phosphate glass PGS-Comp-1 to PGS-Comp-14 in Comparative Examples 1 to 14 (50.0 [%] to 99.0 [%]), and therefore it can be said that the phosphate glass PGS-1 to the phosphate glass PGS-60 in Examples 1 to 60 are excellent in water resistance.

In the phosphate glass PGS-Comp-1 to PGS-Comp-14 in Comparative Examples 1 to 14, the content of P₂O₅ is in the range of 50.0 [mol%] to 62.9 [mol%] in terms of mole percentage based on oxides, the content of ZnO is in the range of 5.5 [mol%] to 50.0 [mol%] in terms of mole percentage based on oxides, the content of Al₂O₃ is in the range of 0.0 [mol%] to 5.6 [mol%] in terms of mole percentage based on oxides, the content of La₂O₃ is in the range of 0.0 [mol%] to 5.4 [mol%] in terms of mole percentage based on oxides, the content of K₂O is in the range of 0.0 [mol%] to 7.7 [mol%] in terms of mole percentage based on oxides, the content of BaO is in the range of 0.0 [mol%] to 11.8 [mol%] in terms of mole percentage based on oxides, and the content of SnO is in the range of 0.0 [mol%] to 16.5 [mol%] in terms of mole percentage based on oxides (see Tables 7 to 9).

The phosphate glass PGS-Comp-1 to the phosphate glass PGS-Comp-14 in Comparative Examples 1 to 14 are measurable and have a water resistance of 50.0 [%] to 99.0 [%] or more and a glass transition temperature Tg of 50°C to 154°C.

The phosphate glass PGS-Comp-1 to the phosphate glass PGS-Comp-11 in Comparative Examples 1 to 11 include neither Al₂O₃ nor La₂O₃ as components. The phosphate glass PGS-Comp-12 to the phosphate glass PGS-Comp-14 in Comparative Examples 12 to 14 include both Al₂O₃ and La₂O₃ as components, but the water resistance is evaluated to be "NG", and as the result, no phosphate glass is formed.

The phosphate glass PGS-1 to the phosphate glass PGS-60 in Examples 1 to 60 include both at least one of Al₂O₃, Ga₂O₃, or Y₂O₃ and at least one of La₂O₃ or Lu₂O₃ as components.

Therefore, the phosphate glass PGS-1 to the phosphate glass PGS-60 in Examples 1 to 60 have a component composition that differs from those of the phosphate glass PGS-Comp-1 to the phosphate glass PGS-Comp-14 in Comparative Examples 1 to 14.

The phosphate glass PGS-1 to the phosphate glass PGS-9 in Examples 1 to 9 include P₂O₅, ZnO, Al₂O₃, La₂O₃, K₂O, and BaO as components (see Tables 1 and 2).

The phosphate glass PGS-Comp-1 in Comparative Example 1 includes P₂O₅ and ZnO as components, the phosphate glass PGS-Comp-2 and the phosphate glass PGS-Comp-5 in Comparative Examples 2 and 5 include P₂O₅, ZnO, and BaO as components, the phosphate glass PGS-Comp-3 and the phosphate glass PGS-Comp-4 in Comparative Examples 3 and 4 include P₂O₅, ZnO, K₂O, and BaO as components, the phosphate glass PGS-Comp-6 to the phosphate glass PGS-Comp-8 in Comparative Examples 6 to 8 include P₂O₅, ZnO, Al₂O₃, K₂O, and BaO as components, and the phosphate glass PGS-Comp-9 to the phosphate glass PGS-Comp-11 in Comparative Examples 9 to 11 include P₂O₅, ZnO, La₂O₃, K₂O, and BaO as components (see Tables 11 to 13).

The phosphate glass PGS-1 to the phosphate glass PGS-9 in Examples 1 to 9 are significantly superior in water resistance to the phosphate glass PGS-Comp-1 to the phosphate glass PGS-Comp-11 in Comparative Examples 1 to 11. This is considered to be because the phosphate glass PGS-1 to the phosphate glass PGS-9 in Examples 1 to 9 include both Al₂O₃ and La₂O₃ as components, whereas the phosphate glass PGS-Comp-1 to the phosphate glass PGS-Comp-11 in Comparative Examples 1 to 11 include neither Al₂O₃ nor La₂O₃ as components. Therefore, if both Al₂O₃ and La₂O₃ are included as components, the water resistance can be improved.

The phosphate glass PGS-13 to the phosphate glass PGS-17 in Examples 13 to 17 are obtained by adding an SnO component to P₂O₅, ZnO, Al₂O₃, La₂O₃, K₂O, and BaO each having a basic content as in the phosphate glass PGS-8 in Example 8. The phosphate glass PGS-13 to the phosphate glass PGS-17 include SnO at a content of 0.001 [mol%], 0.010 [mol%], 0.100 [mol%], 1.000 [mol%], and 9.100 [mol%], respectively, in terms of mole percentage based on oxides (see Tables 2 and 3). The phosphate glass PGS-13 to the phosphate glass PGS-17 have a water resistance of 0.5 [%] or less.

Therefore, If SnO is included at a content of 0.001 [mol%] to 9.100 [mol%] in terms of mole percentage based on oxides, the water resistance can be improved.

The phosphate glass PGS-Comp-12 to the phosphate glass PGS-Comp-14 in Comparative Examples 12 to 14 include P₂O₅, ZnO, Al₂O₃, La₂O₃, K₂O, BaO, and SnO as components (see Table 13). In the phosphate glass PGS-Comp-12 to the phosphate glass PGS-Comp-14, the water resistance is evaluated to be NG, and the glass transition temperature Tg is unmeasurable. This is considered to be because SnO is included at a very large content of 11.6 [mol%] to 16.5 [mol%] in terms of mole percentage based on oxides.

Therefore, If the content of SnO is set in the range of 0.001 [mol%] to 9.100 [mol%] in terms of mole percentage based on oxides, the phosphate glass PGS-13 to the phosphate glass PGS-17 having excellent water resistance can be produced. In Comparative Example 12 in which SnO is included at a content of 11.6 [mol%], no phosphate glass is formed, and thus the content of SnO of 9.1 [mol%] has a critical significance for formation of phosphate glass including SnO as a component.

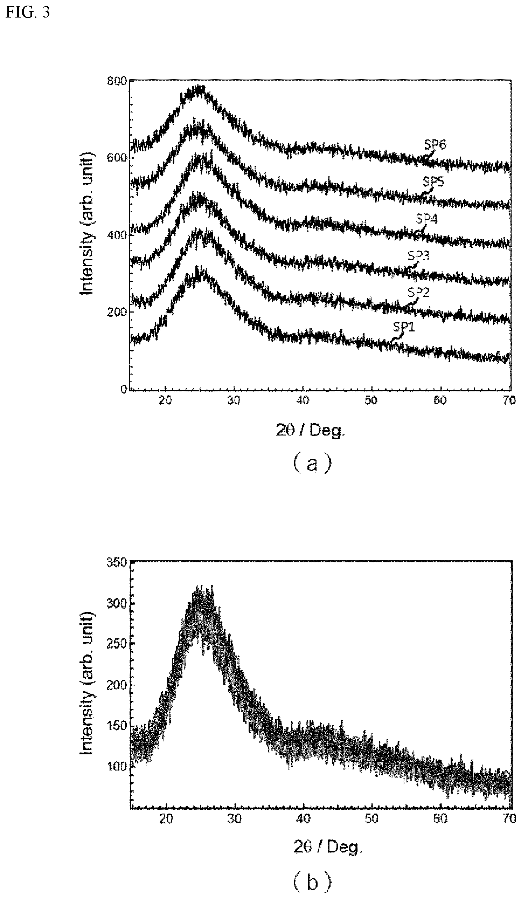

Fig. 3 are graphs showing the X-ray diffraction spectra of the phosphate glass PGS-8 and PGS-13 to PGS-17 in Examples 8 and 13 to 17.

In Fig. 3(a), the spectra SP1 to SP6 indicate the X-ray diffraction spectra of the phosphate glass PGS-8 and PGS-13 to PGS-17 in Examples 8 and 13 to 17, respectively. Fig. 3(b) shows the X-ray diffraction spectra SP1 to SP6 of the phosphate glass PGS-8 and PGS-13 to PGS-17 in an overlapping manner.

As can be seen with reference to Fig. 3, the X-ray diffraction spectra SP1 to SP6 of the phosphate glass PGS-8 and PGS-13 to PGS-17 have the same spectral shape. It has been found that the network structures of the phosphate glass PGS-13 to PGS-17 do not change even if SnO is added at a content of 0.001 [mol%] to 9.100 [mol%] in terms of mole percentage based on oxides because the phosphate glass PGS-8 in Example 8 includes no SnO as a component.

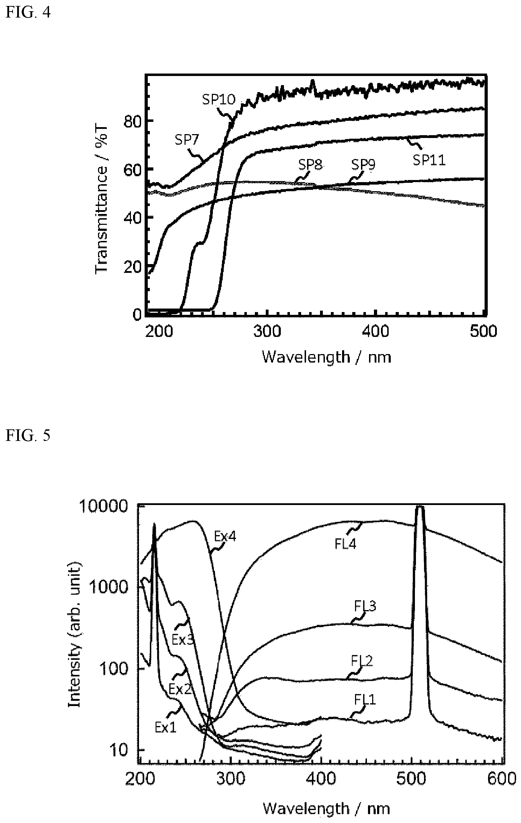

Fig. 4 is a graph showing the light transmission spectra of the phosphate glass PGS-8 and PGS-13 to PGS-16 in Examples 8 and 13 to 16.

In Fig. 4, the spectra SP7 to S11 indicate the light transmission spectra of the phosphate glass PGS-8 and PGS-13 to PGS-16, respectively. When the light transmission spectra SP7 to S11 are measured, the phosphate glass PGS-8 and PGS-13 to PGS-16 have a film thickness of 1.5 mm, 5.0 mm, 1.43 mm, 0.47 mm, and 1.54 mm, respectively.

As can be seen with reference to Fig. 4, the phosphate glass PGS-8 has a light transmission end at a wavelength shorter than 200 nm (see the light transmission spectrum SP7), the phosphate glass PGS-13 has a light transmission end at a wavelength shorter than 200 nm (see the light transmission spectrum SP8), the phosphate glass PGS-14 has a light transmission end at a wavelength of about 190 nm (see the light transmission spectrum SP9), the phosphate glass PGS-15 has a light transmission end at a wavelength of about 220 nm (see the light transmission spectrum SP10), and the phosphate glass PGS-16 has a light transmission end at a wavelength of about 250 nm (see the light transmission spectrum SP11).

Therefore, if the content of SnO is increased, the phosphate glass can have a light transmission end at a wavelength shifted to the long wavelength side in the ultraviolet region. That is, in the ultraviolet region, the wavelength at the light transmission end of the phosphate glass PGS can be controlled by the content of SnO.

In the visible light region, all the phosphate glass absorbs no light and has no color. Meanwhile, the transmittance changed from about 50% to more than 90%.

Fig. 5 is a graph showing the fluorescence spectra of the phosphate glass PGS-13 to PGS-16 in Examples 13 to 16.

In Fig. 5, the spectra Ex1 to Ex4 indicate excitation light spectra, and the spectra FL1 to FL4 indicate the fluorescence spectra of the phosphate glass PGS-13 to PGS-16, respectively.

As can be seen with reference to Fig. 5, the excitation light spectra Ex1 to Ex4 have a peak wavelength of 254 nm. The fluorescence spectra FL1 to FL4 have a peak wavelength of about 510 nm. As a result, it has been found that the phosphate glass PGS-13 to the phosphate glass PGS-16 including SnO at a content of 0.001 [mol%], 0.010 [mol%], 0.100 [mol%], and 1.000 [mol%], respectively, in terms of mole percentage based on oxides have fluorescence spectra FL1 to FL4 having the same peak wavelength. Therefore, combination with a light emitting element (such as an LED) in the ultraviolet light region can yield a light emitting device that emits the fluorescence.

The phosphate glass PGS-8, PGS-18, PGS-21, PGS-24, and PGS-33 in Examples 8, 18, 21, 24, and 33 basically include 62.8 [mol%] of P₂O₅, 17.4 [mol%] of ZnO, 4.7 [mol%] of K₂O, and 9.3 [mol%] of BaO in terms of mole percentage based on oxides, and have a total content of 5.8 [mol%] of two or three components selected from Al₂O₃, La₂O₃, Lu₂O₃, and Ga₂O₃.

The phosphate glass PGS-8 in Example 8 includes, as components, Al₂O₃ and La₂O₃ out of Al₂O₃, La₂O₃, Lu₂O₃, and Ga₂O₃, the phosphate glass PGS-18 in Example 18 includes, as components, Al₂O₃, La₂O₃, and Ga₂O₃ out of Al₂O₃, La₂O₃, Lu₂O₃, and Ga₂O₃, the phosphate glass PGS-21 in Example 21 includes, as components, Lu₂O₃ and Ga₂O₃ out of Al₂O₃, La₂O₃, Lu₂O₃, and Ga₂O₃, the phosphate glass PGS-24 in Example 24 includes, as components, La₂O₃ and Ga₂O₃ out of Al₂O₃, La₂O₃, Lu₂O₃, and Ga₂O₃, and the phosphate glass PGS-33 in Example 33 includes, as components, Al₂O₃ and Lu₂O₃ out of Al₂O₃, La₂O₃, Lu₂O₃, and Ga₂O₃.

As the result, La, which has the smallest atomic number among the lanthanoid elements, and Lu, which has the largest atomic number among the lanthanoid elements, are used in the phosphate glass PGS-8, PGS-18, PGS-21, PGS-24, and PGS-33 in Examples 8, 18, 21, 24, and 33, and therefore it is shown that phosphate glass having excellent water resistance can be produced using any of the lanthanoid elements (lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), and lutetium (Lu)).

The phosphate glass PGS-8, PGS-18, and PGS-24 in Examples 8, 18, and 24 are phosphate glass in which La₂O₃ is selected as an oxide of a lanthanoid element L₂O₃, and at least one of Al₂O₃ or Ga₂O₃ is included. The phosphate glass PGS-8 includes Al₂O₃ out of Al₂O₃ and Ga₂O₃, and has a water resistance of 25.0 [%]. The phosphate glass PGS-18 includes both Al₂O₃ and Ga₂O₃, and has a water resistance of less than 0.5 [%]. The phosphate glass PGS-24 includes Ga₂O₃ out of Al₂O₃ and Ga₂O₃, and has a water resistance of 4.0 [%].

The phosphate glass PGS-19, PGS-21, and PGS-33 in Examples 19, 21, and 33 are phosphate glass in which Lu₂O₃ is selected as an oxide of a lanthanoid element L₂O₃, and at least one of Al₂O₃ or Ga₂O₃ is included. The phosphate glass PGS-19 includes both Al₂O₃ and Ga₂O₃, and has a water resistance of 0.059 [%]. The phosphate glass PGS-21 includes Ga₂O₃ out of Al₂O₃ and Ga₂O₃, and has a water resistance of 1.0 [%]. The phosphate glass PGS-33 includes Al₂O₃ out of Al₂O₃ and Ga₂O₃, and has a water resistance of less than 0.5 [%].

Therefore, the phosphate glass PGS-8, PGS-18, PGS-19, PGS-21, PGS-24, and PGS-33 in Examples 8, 18, 19, 21, 24, and 33 show that if an oxide of a lanthanoid element L₂O₃ and at least one of Al₂O₃ or Ga₂O₃ are included in addition to the components consisting of P₂O₅, ZnO, K₂O, and BaO, phosphate glass having excellent water resistance can be produced.

The phosphate glass PGS-28 in Example 28 includes, in terms of mole percentage based on oxides, 62.1 [mol%] of P₂O₅, 22.6 [mol%] of ZnO, 2.8 [mol%] of Al₂O₃, 1.1 [mol%] of La₂O₃, 5.6 [mol%] of K₂O, and 5.6 [mol%] of CaO. Therefore, the phosphate glass PGS-28 in Example 28 shows that even if BaO in the phosphate glass PGS-1 to PGS-9 in Examples 1 to 9 is replaced with CaO, phosphate glass having excellent water resistance can be produced.

The phosphate glass PGS-29 in Example 29 includes, in terms of mole percentage based on oxides, 59.0 [mol%] of P₂O₅, 20.0 [mol%] of ZnO, 3.5 [mol%] of Al₂O₃, 3.0 [mol%] of La₂O₃, and 14.5 [mol%] of K₂O. That is, the phosphate glass PGS-29 includes none of BaO, MgO, and CaO. Therefore, Example 29 shows that BaO, MgO, and CaO are optional components of the phosphate glass PGS produced through melting at 500°C.

The phosphate glass PGS-34, PGS-35, PGS-37, and PGS-38 in Examples 34, 35, 37, and 38 are obtained by adding SiO₂ to the phosphate glass PGS including P₂O₅, ZnO, Al₂O₃, La₂O₃, K₂O, and BaO. The content of SiO₂ is 0.1 [mol%] to 8.5 [mol%] in terms of mole percentage based on oxides. The phosphate glass PGS-36 in Example 36 is obtained by adding SiO₂ to the phosphate glass PGS including P₂O₅, ZnO, Al₂O₃, La₂O₃, and K₂O (phosphate glass including none of BaO, MgO, and CaO).

The phosphate glass PGS-34 to the phosphate glass PGS-38 in Examples 34 to 38 have a water resistance of 1.0 [%] or less.

Therefore, Examples 34 to 38 show that the phosphate glass PGS including SiO₂ as a component has excellent water resistance.

The phosphate glass PGS-21 in Example 21 has more excellent water resistance than the phosphate glass PGS-22 in Example 22. Therefore, it has been found that in the phosphate glass PGS including Lu₂O₃, Ga₂O₃ more contributes to improvement of water resistance than Y₂O₃.

The phosphate glass PGS-25 in Example 25 has more excellent water resistance than the phosphate glass PGS-24 in Example 24. Therefore, it has been found that in the phosphate glass PGS including La₂O₃, Y₂O₃ more contributes to improvement of water resistance than Ga₂O₃.

The phosphate glass PGS-26 in Example 26 has more excellent water resistance than the phosphate glass PGS-27 in Example 27. Therefore, it has been found that in the phosphate glass PGS including Ga₂O₃ and Y₂O₃, La₂O₃ more contributes to improvement of water resistance than Lu₂O₃.

The phosphate glass PGS-26 and the phosphate glass PGS-27 in Examples 26 and 27 have more excellent water resistance than the phosphate glass PGS-24 in Example 24. Therefore, Examples 26 and 27 show that in the phosphate glass including La₂O₃ or Lu₂O₃ as an oxide of a lanthanoid element L₂O₃, inclusion of both Ga₂O₃ and Y₂O₃ can more contribute to improvement of water resistance than inclusion of only Ga₂O₃.

The phosphate glass PGS-26 has more excellent water resistance than the phosphate glass PGS-27, and therefore in a case where both Ga₂O₃ and Y₂O₃ are included as components, inclusion of La₂O₃ can more improve water resistance than inclusion of Lu₂O₃.

Table 26 shows the components and the water resistance of the phosphate glass PGS-1 to PGS-9, PGS-11, PGS-12, PGS-20 to PGS-22, PGS-26, and PGS-27 in Examples 1 to 9, 11, 12, 20 to 22, 26, and 27.

**[Table 26]**

| | Example 1 to 9 | Example 21 | Example 22 | Example 11 | Example 26 | Example 19 | Example 27 | Example 12 | Example 20 |
|---|---|---|---|---|---|---|---|---|---|
| P₂O₅ | ○ | ○ | ○ | ○ | ○ | ○ | ○ | ○ | |
| ZnO | ○ | ○ | ○ | ○ | ○ | ○ | ○ | ○ | ○ |
| Al₂O₃ | ○ | | | ○ | | ○ | | ○ | ○ |
| Ga₂O₃ | | ○ | | | ○ | ○ | ○ | ○ | ○ |
| Y₂O₃ | | | ○ | ○ | ○ | | ○ | ○ | ○ |
| La₂O₃ | ○ | | | ○ | ○ | | | ○ | |
| Lu₂O₃ | | ● | ● | | | ● | ● | | ● |
| K₂O | ○ | ○ | ○ | ○ | ○ | ○ | ○ | ○ | ○ |
| BaO | ○ | ○ | ○ | ○ | ○ | ○ | ○ | ○ | ○ |
| Water resistance (ΔW) [%] | 1.0 to 25.0 | 1.0 | 9.607 | 0.058 | 0.022 | 0.059 | 0.129 | 0.028 | 0.105 |

The phosphate glass PGS-1 to PGS-9, PGS-11, PGS-12, PGS-20 to PGS-22, PGS-26, and PGS-27 in Examples 1 to 9, 11, 12, 20 to 22, 26, and 27 include P₂O₅, ZnO, K₂O, BaO, and La₂O₃ or Lu₂O₃ in common, and include at least one of Al₂O₃, Ga₂O₃, or Y₂O₃.

The phosphate glass PGS-1 to the phosphate glass PGS-9 include only Al₂O₃ out of Al₂O₃, Ga₂O₃, and Y₂O₃. The phosphate glass PGS-21 includes only Ga₂O₃ out of Al₂O₃, Ga₂O₃, and Y₂O₃. The phosphate glass PGS-22 includes only Y₂O₃ out of Al₂O₃, Ga₂O₃, and Y₂O₃.

The phosphate glass PGS-1 to the phosphate glass PGS-9 have a water resistance of 1.0 to 25.0 [%]. The phosphate glass PGS-21 has a water resistance of 1.0 [%]. The phosphate glass PGS-22 has a water resistance of 9.607 [%].

The phosphate glass PGS-11 includes Al₂O₃ and Y₂O₃ out of Al₂O₃, Ga₂O₃, and Y₂O₃. The phosphate glass PGS-19 includes Al₂O₃ and Ga₂O₃ out of Al₂O₃, Ga₂O₃, and Y₂O₃. The phosphate glass PGS-26 and the phosphate glass PGS-27 include Ga₂O₃ and Y₂O₃ out of Al₂O₃, Ga₂O₃, and Y₂O₃.

The phosphate glass PGS-11 has a water resistance of 0.058 [%]. The phosphate glass PGS-19 has a water resistance of 0.059 [%]. The phosphate glass PGS-26 has a water resistance of 0.022 [%], and the phosphate glass PGS-27 has a water resistance of 0.129 [%].

The phosphate glass PGS-12 and the phosphate glass PGS-20 include Al₂O₃, Ga₂O₃, and Y₂O₃. The phosphate glass PGS-12 has a water resistance of 0.028 [%], and the phosphate glass PGS-20 has a water resistance of 0.105 [%].

The phosphate glass PGS-1 to PGS-9 in Examples 1 to 9, the phosphate glass PGS-11 and PGS-26 in Examples 11 and 26, and the phosphate glass PGS-12 in Example 12 include La₂O₃ in common, and the phosphate glass in the above-described three groups respectively include one component, two components, and three components out of Al₂O₃, Ga₂O₃, and Y₂O₃. In the phosphate glass including La₂O₃, the phosphate glass PGS-11 and the phosphate glass PGS-26 that include two components out of Al₂O₃, Ga₂O₃, and Y₂O₃ have more excellent water resistance than the phosphate glass PGS-1 to the phosphate glass PGS-9 that include one component out of Al₂O₃, Ga₂O₃, and Y₂O₃. In the phosphate glass including La₂O₃, the phosphate glass PGS-12 including three components out of Al₂O₃, Ga₂O₃, and Y₂O₃ has more excellent water resistance than the phosphate glass PGS-11 including two components out of Al₂O₃, Ga₂O₃, and Y₂O₃. The phosphate glass PGS-12 has almost the same water resistance as the phosphate glass PGS-26 including two components out of Al₂O₃, Ga₂O₃, and Y₂O₃.

The phosphate glass PGS-21 and PGS-22 in Examples 21 and 22, the phosphate glass PGS-19 and PGS-27 in Examples 19 and 27, and the phosphate glass PGS-20 in Example 20 include Lu₂O₃ in common, and the phosphate glass in the above-described three groups respectively include one component, two components, and three components out of Al₂O₃, Ga₂O₃, and Y₂O₃. In the phosphate glass including Lu₂O₃, the phosphate glass PGS-19 and the phosphate glass PGS-27 that include two components out of Al₂O₃, Ga₂O₃, and Y₂O₃ have more excellent water resistance than the phosphate glass PGS-21 and the phosphate glass PGS-22 that include one component out of Al₂O₃, Ga₂O₃, and Y₂O₃. In the phosphate glass including La₂O₃, the phosphate glass PGS-20 including three components out of Al₂O₃, Ga₂O₃, and Y₂O₃ has more excellent water resistance than the phosphate glass PGS-27 including two components out of Al₂O₃, Ga₂O₃, and Y₂O₃. The phosphate glass PGS-20 has lower water resistance than the phosphate glass PGS-19 including two components out of Al₂O₃, Ga₂O₃, and Y₂O₃, but the phosphate glass PGS-20 has more excellent water resistance than the phosphate glass PGS-21 and the phosphate glass PGS-22 that include one component out of Al₂O₃, Ga₂O₃, and Y₂O₃.

Therefore, it has been found that the phosphate glass including La₂O₃ or Lu₂O₃ can have improved water resistance by including two or more components out of Al₂O₃, Ga₂O₃, and Y₂O₃.

Furthermore, it has been found that in the phosphate glass PGS-12 and the phosphate glass PGS-20 that include three components of Al₂O₃, Ga₂O₃, and Y₂O₃, inclusion of La₂O₃ can more contribute to improvement of water resistance than inclusion of Lu₂O₃.

In the phosphate glass PGS-1 to PGS-9, PGS-11, PGS-12, PGS-20 to PGS-22, PGS-26, and PGS-27 in Examples 1 to 9, 11, 12, 20 to 22, 26, and 27, La, which has the smallest atomic number among the lanthanoid elements, and Lu, which has the largest atomic number among the lanthanoid elements, are used, and therefore it is shown that the phosphate glass can have improved water resistance by including two or more components out of Al₂O₃, Ga₂O₃, and Y₂O₃ using any of the lanthanoid elements (lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), and lutetium (Lu)). Therefore, the phosphate glass PGS produced through melting at 500°C preferably includes two or more components out of Al₂O₃, Ga₂O₃, and Y₂O₃.

The phosphate glass PGS-29 to the phosphate glass PGS-31 in Examples 29 to 31 include P₂O₅, ZnO, Al₂O₃, and La₂O₃ in common, and include any one of Li₂O, Na₂O, and K₂O.

In the phosphate glass PGS-29 to PGS-31, the phosphate glass PGS-31 has the highest water resistance, the phosphate glass PGS-29 has the second highest water resistance, and the phosphate glass PGS-30 has the lowest water resistance. Therefore, it has been found that among Li₂O, Na₂O, and K₂O, Na₂O most contributes to improvement of water resistance.

The phosphate glass PGS-32 including Na₂O and K₂O has higher water resistance than the phosphate glass PGS-29 to PGS-31 by about one order of magnitude. Therefore, it has been found that the phosphate glass PGS can have further improved water resistance by including two components of Na₂O and K₂O.

### [Phosphate Glass Melted at 800°C]

In the phosphate glass PGS-61 to PGS-125 in Examples 61 to 125, the content of P₂O₅ is in the range of 55.8 [mol%] to 63.0 [mol%] in terms of mole percentage based on oxides, the content of ZnO is in the range of 11.7 [mol%] to 25.5 [mol%] in terms of mole percentage based on oxides, the content of Al₂O₃ is in the range of 0.0 [mol%] to 6.1 [mol%] in terms of mole percentage based on oxides, the content of La₂O₃ is in the range of 0.0 [mol%] to 3.0 [mol%] in terms of mole percentage based on oxides, the content of Lu₂O₃ is in the range of 0.0 [mol%] to 3.0 [mol%] in terms of mole percentage based on oxides, the content of Ga₂O₃ is in the range of 0 [mol%] to 2.9 [mol%] in terms of mole percentage based on oxides, the content of Li₂O is in the range of 0.0 [mol%] to 12.0 [mol%] in terms of mole percentage based on oxides, the content of Na₂O is in the range of 0.0 [mol%] to 12.0 [mol%] in terms of mole percentage based on oxides, the content of K₂O is in the range of 0.0 [mol%] to 14.5 [mol%] in terms of mole percentage based on oxides, the content of BaO is in the range of 0.0 [mol%] to 10.1 [mol%] in terms of mole percentage based on oxides, the content of MgO is in the range of 0.0 [mol%] to 6.5 [mol%] in terms of mole percentage based on oxides, the content of CaO is in the range of 0.0 [mol%] to 8.0 [mol%] in terms of mole percentage based on oxides, the content of SrO is in the range of 0.0 [mol%] to 5.7 [mol%] in terms of mole percentage based on oxides, the content of Y₂O₃ is in the range of 0.0 [mol%] to 2.7 [mol%] in terms of mole percentage based on oxides, the content of SiO₂ is in the range of 0.0 [mol%] to 8.5 [mol%] in terms of mole percentage based on oxides, the content of SnO is in the range of 0.0 [mol%] to 9.1 [mol%] in terms of mole percentage based on oxides, the content of Cu₂O is in the range of 0.0 [mol%] to 1.0 [mol%] in terms of mole percentage based on oxides, the content of Ag₂O is in the range of 0.0 [mol%] to 1.0 [mol%] in terms of mole percentage based on oxides, and the content of MnO is in the range of 0.0 [mol%] to 1.0 [mol%] in terms of mole percentage based on oxides (see Tables 14 to 23).

The phosphate glass PGS-61 to the phosphate glass PGS-125 in Examples 61 to 125 have a water resistance of 0.005 [%] to 0.587 [%] and a glass transition temperature Tg of 258°C to 393°C.

In the phosphate glass PGS-Comp-15 to PGS-Comp-23 in Comparative Examples 15 to 23, the content of P₂O₅ is in the range of 54.0 [mol%] to 75.5 [mol%] in terms of mole percentage based on oxides, the content of ZnO is in the range of 4.4 [mol%] to 32.0 [mol%] in terms of mole percentage based on oxides, the content of Al₂O₃ is in the range of 0.9 [mol%] to 5.5 [mol%] in terms of mole percentage based on oxides, the content of La₂O₃ is in the range of 0.0 [mol%] to 9.8 [mol%] in terms of mole percentage based on oxides, the content of K₂O is in the range of 0.0 [mol%] to 18.5 [mol%] in terms of mole percentage based on oxides, and the content of BaO is in the range of 0 [mol%] to 10.8 [mol%] in terms of mole percentage based on oxides (see Tables 24 and 25).

Among the phosphate glass PGS-Comp-15 to PGS-Comp-25 in Comparative Examples 15 to 23, measurable phosphate glass has a water resistance of 1.021 [%] to 18.528 [%] and a glass transition temperature Tg of 238°C to 285°C.

The phosphate glass PGS-Comp-15, the phosphate glass PGS-Comp-17, and the phosphate glass PGS-Comp-22 in Comparative Examples 15, 17, and 22 include neither Al₂O₃ nor La₂O₃ as components. In the phosphate glass PGS-Comp-16, PGS-Comp-18, PGS-Comp-19, PGS-Comp-21, and PGS-Comp-23 in Comparative Examples 16, 18, 19, 21, and 23, the water resistance is evaluated to be "NG", and as the result, no phosphate glass is formed.

The phosphate glass PGS-61 to the phosphate glass PGS-125 in Examples 61 to 125 include an oxide of a lanthanoid element L₂O₃ and at least one of Al₂O₃, Ga₂O₃, or Y₂O₃ as components.

Therefore, the phosphate glass PGS-61 to the phosphate glass PGS-125 in Examples 61 to 125 have a component composition that differs from those of the phosphate glass PGS-Comp-15 to the phosphate glass PGS-Comp-23 in Comparative Examples 15 to 23.

The phosphate glass PGS-61 to the phosphate glass PGS-70 in Examples 61 to 70 include P₂O₅, ZnO, Al₂O₃, La₂O₃, K₂O, and BaO as components. The phosphate glass PGS-61 to the phosphate glass PGS-70 in Examples 61 to 70 have a water resistance of 0.016 [%] to 0.587 [%] (see Tables 14 and 15).

The phosphate glass PGS was formed in Comparative Examples 15, 17, 20, and 22 among Comparative Examples 15 to 23. The phosphate glass PGS-Comp-15, the phosphate glass PGS-Comp-17, and the phosphate glass PGS-Comp-22 in Comparative Examples 15, 17, and 22 include neither Al₂O₃ nor La₂O₃ as components. The phosphate glass PGS-Comp-15, the phosphate glass PGS-Comp-17, and the phosphate glass PGS-Comp-22 have a water resistance of 18.528 [%], 2.443 [%], and 1.021 [%], respectively. The phosphate glass PGS-Comp-20 in Comparative Example 20 includes both Al₂O₃ and La₂O₃ as components, but the content of La₂O₃ is less than 1.0 [mol%]. The phosphate glass PGS-Comp-20 has a water resistance of 8.078 [%] (see Tables 24 and 25).

As the result, the phosphate glass PGS-61 to the phosphate glass PGS-70 in Examples 61 to 70 have more excellent water resistance than the phosphate glass PGS-Comp-15, PGS-Comp-17, PGS-Comp-20, and PGS-Comp-22 in Comparative Examples 15, 17, 20, and 22. This is because the phosphate glass PGS-61 to the phosphate glass PGS-70 in Examples 61 to 70 include both Al₂O₃ and La₂O₃ as components, and because the content of La₂O₃ is in the range of 1.0 [mol%] to 3.0 [mol%] in terms of mole percentage based on oxides.

Therefore, if both Al₂O₃ and La₂O₃ are included as components and the content of La₂O₃ is set in the range of 1.0 [mol%] to 3.0 [mol%] in terms of mole percentage based on oxides, the water resistance can be improved.

The phosphate glass PGS-74 in Example 74 is obtained by replacing Al₂O₃ in the phosphate glass PGS-70 in Example 70 with Ga₂O₃ at the same content. The phosphate glass PGS-78 in Example 78 is obtained by replacing Al₂O₃ in the phosphate glass PGS-70 in Example 70 with Y₂O₃ at the same content. The phosphate glass PGS-74 has more excellent water resistance than the phosphate glass PGS-70, and the phosphate glass PGS-78 has a water resistance of less than 0.090 [%].

Therefore, even if Ga₂O₃ or Y₂O₃ is included as a component in place of Al₂O₃, the phosphate glass PGS having excellent water resistance can be obtained. As the result, Al₂O₃, Ga₂O₃, and Y₂O₃ constitute the components that improve the water resistance of the phosphate glass PGS.

The phosphate glass PGS-82 in Example 82 is obtained by replacing Al₂O₃ and La₂O₃ in the phosphate glass PGS-70 in Example 70 with Ga₂O₃ and Lu₂O₃, respectively. As the result, Example 82 shows that the phosphate glass PGS obtained can have excellent water resistance also by including both Ga₂O₃ and Lu₂O₃ as components.

The phosphate glass PGS-79 and PGS-81 in Examples 79 and 81 include P₂O₅, ZnO, K₂O, BaO, and Y₂O₃ in common and include La₂O₃ or Lu₂O₃. The phosphate glass PGS-79 has a water resistance of 0.377 [%], and the phosphate glass PGS-81 has a water resistance of 0.323 [%].

Therefore, Examples 79 and 81 show that the phosphate glass PGS including only Y₂O₃ out of Al₂O₃, Ga₂O₃, and Y₂O₃ can obtain almost the same water resistance whether La₂O₃ or Lu₂O₃ is included as a component.

The phosphate glass PGS-70 in Example 70 is obtained by replacing Y₂O₃ in the phosphate glass PGS-79 in Example 79 with Al₂O₃, and the phosphate glass PGS-82 in Example 82 is obtained by replacing Y₂O₃ in the phosphate glass PGS-81 in Example 81 with Ga₂O₃. That is, the phosphate glass PGS-70 includes P₂O₅, ZnO, K₂O, BaO, La₂O₃ out of La₂O₃ and Lu₂O₃, and Al₂O₃ out of Al₂O₃, Ga₂O₃, and Y₂O₃, and the phosphate glass PGS-82 includes P₂O₅, ZnO, K₂O, BaO, Lu₂O₃ out of La₂O₃ and Lu₂O₃, and Ga₂O₃ out of Al₂O₃, Ga₂O₃, and Y₂O₃. Therefore, Examples 70, 79, 81, and 82 show that if phosphate glass including one component out of Al₂O₃, Ga₂O₃, and Y₂O₃ includes one of all lanthanoid oxides from La₂O₃ to Lu₂O₃ as a component, the obtained phosphate glass can have excellent water resistance.

The phosphate glass PGS-71 in Example 71 includes two lanthanoid oxides of La₂O₃ and Lu₂O₃ as components in addition to the components consisting of P₂O₅, ZnO, Al₂O₃, K₂O, and BaO. The phosphate glass PGS-71 has almost the same water resistance as the phosphate glass PGS-68 in Example 68 including one component (La₂O₃) out of La₂O₃ and Lu₂O₃. Therefore, Example 71 shows that phosphate glass having excellent water resistance can be obtained also in a case where two of the lanthanoid oxides from La₂O₃ to Lu₂O₃ are included as components.

The phosphate glass PGS-75 in Example 75 includes P₂O₅, ZnO, Al₂O₃, Lu₂O₃, Ga₂O₃, K₂O, and BaO as components. The phosphate glass PGS-77 in Example 77 is obtained by replacing Ga₂O₃ in the phosphate glass PGS-75 with Y₂O₃ at the same content. The phosphate glass PGS-75 has a water resistance of 0.030 [%], and the phosphate glass PGS-77 has a water resistance of 0.299 [%]. Therefore, it has been found that in the phosphate glass PGS including Lu₂O₃, inclusion of both Al₂O₃ and Ga₂O₃ more contributes to improvement of water resistance than inclusion of both Al₂O₃ and Y₂O₃.

The phosphate glass PGS-79 in Example 79 includes P₂O₅, ZnO, La₂O₃, K₂O, BaO, and Y₂O₃ as components. The phosphate glass PGS-81 in Example 81 is obtained by replacing La₂O₃ in the phosphate glass PGS-79 with Lu₂O₃ at the same content. The phosphate glass PGS-79 and the phosphate glass PGS-81 have almost the same water resistance. As the result, La, which has the smallest atomic number among the lanthanoid elements, and Lu, which has the largest atomic number among the lanthanoid elements, are used in Examples 79 and 81, and therefore it is shown that phosphate glass having excellent water resistance can be obtained using any of the lanthanoid elements (lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), and lutetium (Lu)).

The phosphate glass PGS-84 in Example 84 is obtained by replacing Lu₂O₃ in the phosphate glass PGS-82 in Example 82 with La₂O₃ at the same content. As the result, Example 84 shows that the phosphate glass PGS having more excellent water resistance can be obtained with a combination of Ga₂O₃ and La₂O₃ than with a combination of Ga₂O₃ and Lu₂O₃.

The phosphate glass PGS-85 and the phosphate glass PGS-86 in Examples 85 and 86 include Li₂O, Na₂O, and K₂O as components in addition to the components consisting of P₂O₅, ZnO, Al₂O₃, La₂O₃, and BaO. The phosphate glass PGS-85 has a water resistance of less than 0.130 [%], and the phosphate glass PGS-86 has a water resistance of less than 0.050 [%]. As described above, Examples 85 and 86 show that the phosphate glass PGS having excellent water resistance can be obtained even if the oxides of three alkali metals (Li, Na, K) are included.

The phosphate glass PGS-87 in Example 87 includes P₂O₅, ZnO, Al₂O₃, La₂O₃, and Li₂O as components, the phosphate glass PGS-88 in Example 88 includes P₂O₅, ZnO, Al₂O₃, La₂O₃, and Na₂O as components, and the phosphate glass PGS-89 in Example 89 includes P₂O₅, ZnO, Al₂O₃, La₂O₃, K₂O, and Na₂O as components. That is, the phosphate glass PGS-87 to the phosphate glass PGS-89 include none of BaO, MgO, and CaO. Therefore, Examples 87 to 89 show that BaO, SrO, MgO, and CaO are optional components of the phosphate glass produced through melting at 800°C.

The phosphate glass PGS-93 in Example 93 includes P₂O₅, ZnO, Al₂O₃, La₂O₃, Ga₂O₃, and K₂O as components. That is, the phosphate glass PGS-93 includes none of BaO, MgO, and CaO. Therefore, Example 93 shows that BaO, SrO, MgO, and CaO are optional components in the phosphate glass PGS including Al₂O₃ and Ga₂O₃ out of Al₂O₃, Ga₂O₃, and Y₂O₃.

Furthermore, the phosphate glass PGS-97 in Example 97 includes P₂O₅, ZnO, Al₂O₃, La₂O₃, K₂O, and SiO₂ as components. That is, the phosphate glass PGS-97 includes none of BaO, SrO, MgO, and CaO. Therefore, Example 97 shows that BaO, MgO, and CaO are optional components in the phosphate glass PGS including SiO₂.

The phosphate glass PGS-90 in Example 90 includes CaO as a component in place of BaO in the components consisting of P₂O₅, ZnO, Al₂O₃, La₂O₃, K₂O, and BaO. The phosphate glass PGS-90 has a water resistance of less than 0.400 [%]. As described above, Example 90 shows that even if CaO is included as a component in place of BaO, the phosphate glass PGS having excellent water resistance can be obtained.

The phosphate glass PGS-91 in Example 91 includes 9.1 [mol%] of SnO as a component in terms of mole percentage based on oxides in addition to the components consisting of P₂O₅, ZnO, Al₂O₃, La₂O₃, K₂O, and BaO. The phosphate glass PGS-91 has a water resistance of less than 0.060 [%]. As described above, Example 91 shows that even if P₂O₅, ZnO, Al₂O₃, La₂O₃, K₂O, BaO, and SnO are included as components, the phosphate glass PGS having excellent water resistance can be obtained.

The phosphate glass PGS-91 includes the same components as the phosphate glass PGS-17 in Example 17, and each component is included at the same content as in the phosphate glass PGS-17. Both the phosphate glass PGS-17 and the phosphate glass PGS-91 have a water resistance of less than 0.5 [%]. Therefore, the phosphate glass PGS including an SnO component has the same level of water resistance whether produced at a melting temperature of 500°C or 800°C. Even in the phosphate glass PGS produced at a melting temperature of 800°C, the content of SnO of 9.1 [mol%] has a critical significance in producing the phosphate glass PGS including SnO.

The phosphate glass PGS-92 in Example 92 includes MgO as a component in place of BaO in the components consisting of P₂O₅, ZnO, Al₂O₃, La₂O₃, K₂O, and BaO. The phosphate glass PGS-92 has a water resistance of less than 0.400 [%]. As described above, Example 92 shows that even if MgO is included as a component in place of BaO, the obtained phosphate glass PGS can have excellent water resistance.

The phosphate glass PGS-94 in Example 94 was obtained by reducing the contents of Al₂O₃ and Ga₂O₃ in the phosphate glass PGS-93 in Example 93 of 3.5 [mol%] to 1.4 [mol%] and 1.5 [mol%], respectively, and replacing a part of K₂O with BaO. The phosphate glass PGS-94 has better water resistance than the phosphate glass PGS-93 by one or more orders of magnitude. As described above, Example 94 shows that the water resistance can be further improved by reducing the contents of Al₂O₃ and Ga₂O₃ and replacing K₂O with K₂O and BaO so that the total content of K₂O and BaO is substantially kept at the original content of K₂O. That is, Example 94 shows that the phosphate glass PGS can have more improved water resistance by including both K₂O and BaO as components than by including K₂O simple substance.

The phosphate glass PGS-95, PGS-96, and PGS-98 to PGS-100 in Examples 95, 96, and 98 to 100 are obtained by adding SiO₂ as a component to the components consisting of P₂O₅, ZnO, Al₂O₃, La₂O₃, K₂O, and BaO. The phosphate glass PGS-97 in Example 97 is obtained by adding SiO₂ as a component to the components consisting of P₂O₅, ZnO, Al₂O₃, La₂O₃, and K₂O. The phosphate glass PGS-95 to the phosphate glass PGS-100 have a water resistance of less than 0.510 [%].

Therefore, Examples 95 to 100 show that even if SiO₂ is included as a component, the obtained phosphate glass PGS can have excellent water resistance. Example 97 shows that the phosphate glass PGS including SiO₂ as a component has excellent water resistance even if none of BaO, MgO, and CaO is included. Furthermore, Examples 95 to 100 show that even in a case where SiO₂ is present in an environment in which the phosphate glass PGS is produced, and is automatically incorporated into the phosphate glass PGS, the phosphate glass PGS obtained can have excellent water resistance as long as the content of SiO₂ is in the range of 0.1 [mol%] to 8.5 [mol%].

Table 27 shows the components and the water resistance of the phosphate glass PGS-61 to PGS-70, PGS-73 to PGS-78, PGS-80, PGS-82, and PGS-83 in Examples 61 to 70, 73 to 78, 80, 82, and 83.

**[Table 27]**

| | Example 61 to 70 | Example 74 | Example 78 | Example 82 | Example 80 | Example 75 | Example 77 | Example 83 | Example 73 | Example 76 |
|---|---|---|---|---|---|---|---|---|---|---|
| P₂O₅ | ○ | ○ | ○ | ○ | ○ | ○ | ○ | ○ | ○ | ○ |
| ZnO | ○ | ○ | ○ | ○ | ○ | ○ | ○ | ○ | ○ | ○ |
| Al₂O₃ | ○ | | | | | ○ | ○ | | ○ | ○ |
| Ga₂O₃ | | ○ | | ○ | ○ | | ○ | ○ | ○ | ○ |
| Y₂O₃ | | | ○ | | ○ | ○ | | ○ | ○ | ○ |
| La₂O₃ | ○ | ○ | ○ | | ○ | | | | ○ | |
| Lu₂O₃ | | | | ● | | ● | ● | ● | | ● |
| K₂O | ○ | ○ | ○ | ○ | ○ | ○ | ○ | ○ | ○ | ○ |
| BaO | ○ | ○ | ○ | ○ | ○ | ○ | ○ | ○ | ○ | ○ |
| Water resistance (ΔW) [%] | 0.016 to 0.587 | 0.009 | 0.089 | 0.075 | 0346 | 0.030 | 0.299 | 0.537 | 0.542 | 0.536 |
| | Average: 0.159 | | | | | Average: 0.289 | | | | |

The phosphate glass PGS-61 to PGS-70, PGS-73 to PGS-78, PGS-80, PGS-82, and PGS-83 in Examples 61 to 70, 73 to 78, 80, 82, and 83 include P₂O₅, ZnO, K₂O, BaO, and La₂O₃ or Lu₂O₃ in common, and include at least one of Al₂O₃, Ga₂O₃, or Y₂O₃.

The phosphate glass PGS-61 to the phosphate glass PGS-70 include only Al₂O₃ out of Al₂O₃, Ga₂O₃, and Y₂O₃. The phosphate glass PGS-52 and the phosphate glass PGS-60 include only Ga₂O₃ out of Al₂O₃, Ga₂O₃, and Y₂O₃. The phosphate glass PGS-78 includes only Y₂O₃ out of Al₂O₃, Ga₂O₃, and Y₂O₃.

The phosphate glass PGS-61 to the phosphate glass PGS-70 have a water resistance of 0.016 to 0.587 [%]. The phosphate glass PGS-74 has a water resistance of 0.009 [%]. The phosphate glass PGS-78 has a water resistance of 0.089 [%]. The phosphate glass PGS-82 has a water resistance of 0.075 [%].

The phosphate glass PGS-77 includes Al₂O₃ and Y₂O₃ out of Al₂O₃, Ga₂O₃, and Y₂O₃. The phosphate glass PGS-80 and the phosphate glass PGS-83 include Ga₂O₃ and Y₂O₃ out of Al₂O₃, Ga₂O₃, and Y₂O₃. The phosphate glass PGS-75 includes Al₂O₃ and Ga₂O₃ out of Al₂O₃, Ga₂O₃, and Y₂O₃.

The phosphate glass PGS-77 has a water resistance of 0.299 [%]. The phosphate glass PGS-80 has a water resistance of 0.346 [%], and the phosphate glass PGS-83 has a water resistance of 0.537 [%]. The phosphate glass PGS-75 has a water resistance of 0.030 [%].

The phosphate glass PGS-73 and the phosphate glass PGS-76 include Al₂O₃, Ga₂O₃, and Y₂O₃. The phosphate glass PGS-73 has a water resistance of 0.542 [%], and the phosphate glass PGS-76 has a water resistance of 0.536 [%].

The phosphate glass PGS-61 to PGS-70, PGS-74, and PGS-78 in Examples 61 to 70, 74, and 78, the phosphate glass PGS-80 in Example 80, and the phosphate glass PGS-73 in Example 73 include La₂O₃ in common, and the phosphate glass in the above-described three groups respectively include one component, two components, and three components out of Al₂O₃, Ga₂O₃, and Y₂O₃. In the phosphate glass including La₂O₃, the phosphate glass PGS-61 to PGS-70, PGS-74, and PGS-78 that include one component out of Al₂O₃, Ga₂O₃, and Y₂O₃ have an average water resistance of 0.159 [%]. Therefore, in the phosphate glass including La₂O₃, the phosphate glass PGS-61 to PGS-70, PGS-74, and PGS-78 that include one component out of Al₂O₃, Ga₂O₃, and Y₂O₃ have more excellent water resistance than the phosphate glass PGS-80 including two components out of Al₂O₃, Ga₂O₃, and Y₂O₃, and the phosphate glass PGS-80 including two components out of Al₂O₃, Ga₂O₃, and Y₂O₃ has more excellent water resistance than the phosphate glass PGS-73 including three components out of Al₂O₃, Ga₂O₃, and Y₂O₃.

The phosphate glass PGS-82 in Examples 82, the phosphate glass PGS-75, PGS-77, and PGS-83 in Examples 75, 77, and 83, and the phosphate glass PGS-76 in Example 76 include Lu₂O₃ in common, and the phosphate glass in the above-described three groups respectively include one component, two components, and three components out of Al₂O₃, Ga₂O₃, and Y₂O₃. In the phosphate glass including Lu₂O₃, the phosphate glass PGS-75, PGS-77, and PGS-83 that include two components out of Al₂O₃, Ga₂O₃, and Y₂O₃ have an average water resistance of 0.289 [%]. Therefore, in the phosphate glass including Lu₂O₃, the phosphate glass PGS-83 including one component out of Al₂O₃, Ga₂O₃, and Y₂O₃ has more excellent water resistance than the phosphate glass PGS-75, PGS-77, and PGS-83 that include two components out of Al₂O₃, Ga₂O₃, and Y₂O₃, and the phosphate glass PGS-75, PGS-77, and PGS-83 that include two components out of Al₂O₃, Ga₂O₃, and Y₂O₃ have more excellent water resistance than the phosphate glass PGS-76 including three components out of Al₂O₃, Ga₂O₃, and Y₂O₃.

As described above, it has been found that in the phosphate glass PGS produced through melting at 800°C, the phosphate glass PGS-61 to 70, PGS-74, PGS-78, and PGS-82 that include one component out of Al₂O₃, Ga₂O₃, and Y₂O₃ have more excellent water resistance than the phosphate glass PGS-75, PGS-77, PGS-80, and PGS-83 that include two components out of Al₂O₃, Ga₂O₃, and Y₂O₃ and the phosphate glass PGS-73 and PGS-76 that include three components out of Al₂O₃, Ga₂O₃, and Y₂O₃, whether La₂O₃ or Lu₂O₃ is included as a component.

In the phosphate glass PGS-61 to PGS-70, PGS-73 to PGS-78, PGS-80, PGS-82, and PGS-83 in Examples 61 to 70, 73 to 78, 80, 82, and 83, La, which has the smallest atomic number among the lanthanoid elements, and Lu, which has the largest atomic number among the lanthanoid elements, are used, and therefore it is shown that the phosphate glass can have improved water resistance by including one component out of Al₂O₃, Ga₂O₃, and Y₂O₃ using any of the lanthanoid elements (lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), and lutetium (Lu)). Therefore, the phosphate glass PGS produced through melting at 800°C preferably includes one component out of Al₂O₃, Ga₂O₃, and Y₂O₃.

The phosphate glass PGS-87 to the phosphate glass PGS-89 in Examples 87 to 89 include P₂O₅, ZnO, Al₂O₃, and La₂O₃ in common, and include any of Li₂O, Na₂O, and two components constituting of Na₂O and K₂O.

In the phosphate glass PGS-87 to PGS-89, the phosphate glass PGS-88 has the highest water resistance, the phosphate glass PGS-87 has the second highest water resistance, and the phosphate glass PGS-89 has the lowest water resistance. Therefore, it has been found that among Li₂O, Na₂O, and the two components constituting of Na₂O and K₂O, Na₂O most contributes to improvement of water resistance.

The phosphate glass PGS-61 to PGS-67, PGS-69, PGS-70, PGS-74, PGS-75, PGS-77 to PGS-82, and PGS-84 to PGS-99 in Examples 61 to 67, 69, 70, 74, 75, 77 to 82, and 84 to 99 have a water resistance of less than 0.400. Therefore, the phosphate glass produced through melting at 800°C preferably includes, in terms of mole percentage based on oxides, P₂O₅ at a content of 55 to 63 [mol%], ZnO at a content of 12 to 26 [mol%], R₂O₃ being at least one of Al₂O₃, Ga₂O₃, or Y₂O₃ at a content of 1.0 to 6.1 [mol%], a lanthanoid oxide being at least one of La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, or Lu₂O₃ at a content of 1 to 3 [mol%], X₂O being at least one of Li₂O, Na₂O, K₂O, Rb₂O, Cs₂O, or Fr₂O at a content of 4.3 to 14.5 [mol%], and SiO₂ at a content of 0.0 to 7 [mol%].

Fig. 6 are graphs, with the content of each component indicated in terms of mole percentage based on oxides, showing a relationship between the water resistance and the content of a specific component and a relationship between the glass transition temperature Tg and the content of the specific component in phosphate glass PGS-1 to PGS-9, PGS-13 to PGS-18, PGS-21, PGS-24, PGS-28, PGS-29, PGS-33 to PGS-38, PGS-61 to PGS-70, PGS-74, PGS-78, PGS-82, PGS-84 to PGS-86, PGS-90 to PGS-100, and PGS-Comp-1 to PGS-Comp-23 in Examples 1 to 9, 13 to 18, 21, 24, 28, 29, 33 to 38, 61 to 70, 74, 78, 82, 84 to 86, 90 to 100, and Comparative Examples 1 to 23.

The specific component is [(X₂O + P₂O₅) - (M₂O₃ + SiO₂)]. Here, M in M₂O₃ is any of Al, Ga, Y, and the lanthanoid elements.

Fig. 6(a) illustrates a relationship between [(X₂O + P₂O₅) - (M₂O₃ + SiO₂)] and the water resistance (ΔW), and Fig. 6(b) illustrates a relationship between [(X₂O + P₂O₅) - (M₂O₃ + SiO₂)] and the glass transition temperature Tg.

As a result of plotting and linearly approximating the relationship between the amount of [(X₂O + P₂O₅) - (M₂O₃ + SiO₂)] and the water resistance, a contribution ratio of 0.16 was obtained (see Fig. 6(a)).

As a result of plotting and linearly approximating the relationship between the amount of [(X₂O + P₂O₅) - (M₂O₃ + SiO₂)] and the glass transition temperature Tg, a contribution ratio of 0.20 was obtained (see Fig. 6(b)).

Fig. 7 are graphs, with the content of each component indicated in terms of mole percentage based on cations, showing a relationship between the water resistance and the content of a specific component and a relationship between the glass transition temperature Tg and the content of the specific component in the phosphate glass PGS-1 to PGS-9, PGS-13 to PGS-18, PGS-21, PGS-24, PGS-28, PGS-29, PGS-33 to PGS-38, PGS-61 to PGS-70, PGS-74, PGS-78, PGS-82, PGS-84 to PGS-86, PGS-90 to PGS-100, and PGS-Comp-1 to PGS-Comp-23 in Examples 1 to 9, 13 to 18, 21, 24, 28, 29, 33 to 38, 61 to 70, 74, 78, 82, 84 to 86, 90 to 100, and Comparative Examples 1 to 23.

The specific component is [(XO_{1/2} + PO_{5/2}) - (MO_{3/2} + SiO₂)]. Here, M in MO_{3/2} is any of Al, Ga, Y, and the lanthanoid elements.

Fig. 7(a) illustrates a relationship between [(XO_{1/2} + PO_{5/2}) - (MO_{3/2} + SiO₂)] and the water resistance (ΔW), and Fig. 7(b) illustrates a relationship between [(XO_{1/2} + PO_{5/2}) - (MO_{3/2} + SiO₂)] and the glass transition temperature Tg.

As a result of plotting and linearly approximating the relationship between the amount of [(XO_{1/2} + PO_{5/2}) - (MO_{3/2} + SiO₂)] and the water resistance, a contribution ratio of 0.28 was obtained (see Fig. 7(a)).

The correlation in the relationship between the amount of [(XO_{1/2} + PO_{5/2}) - (MO_{3/2} + SiO₂)] and the water resistance shown in Fig. 7(a) is better than the correlation in the relationship between the amount of [(X₂O + P₂O₅) - (M₂O₃ + SiO₂)] and the water resistance shown in Fig. 6(a).

Therefore, a better correlation is exhibited between the amount of [(XO_{1/2} + PO_{5/2}) - (MO_{3/2} + SiO₂)] in which the content is indicated in terms of mole percentage based on cations and the water resistance.

As a result of plotting and linearly approximating the relationship between the amount of [(XO_{1/2} + PO_{5/2}) - (MO_{3/2} + SiO₂)] and the glass transition temperature Tg, a contribution ratio of 0.35 was obtained (see Fig. 7(b)).

The correlation in the relationship between the amount of [(XO_{1/2} + PO_{5/2}) - (MO_{3/2} + SiO₂)] and the glass transition temperature Tg shown in Fig. 7(b) is better than the correlation in the relationship between the amount of [(X₂O + P₂O₅) - (M₂O₃ + SiO₂)] and the glass transition temperature Tg shown in Fig. 6(b).

Therefore, a better correlation is exhibited between the amount of [(XO_{1/2} + PO_{5/2}) - (MO_{3/2} + SiO₂)] in which the content is indicated in terms of mole percentage based on cations and the glass transition temperature Tg.

The relationship between the glass transition temperature Tg and the melting temperature was examined using two component compositions having different contents. Table 28 shows the two component compositions. The content of each component in component compositions 1 and 2 in Table 28 are indicated in terms of mole percentage based on oxides.

**[Table 28]**

| | | Component composition 1 | Component composition 2 |
|---|---|---|---|
| P₂O₅ | [mol%] | 59.4 | 61.5 |
| ZnO | [mol%] | 23.5 | 22.3 |
| Al₂O₃ | [mol%] | 2.9 | 2.8 |
| La₂O₃ | [mol%] | 2.4 | 2.2 |
| K₂O | [mol%] | 5.9 | 5.6 |
| BaO | [mol%] | 2.9 | 5.6 |

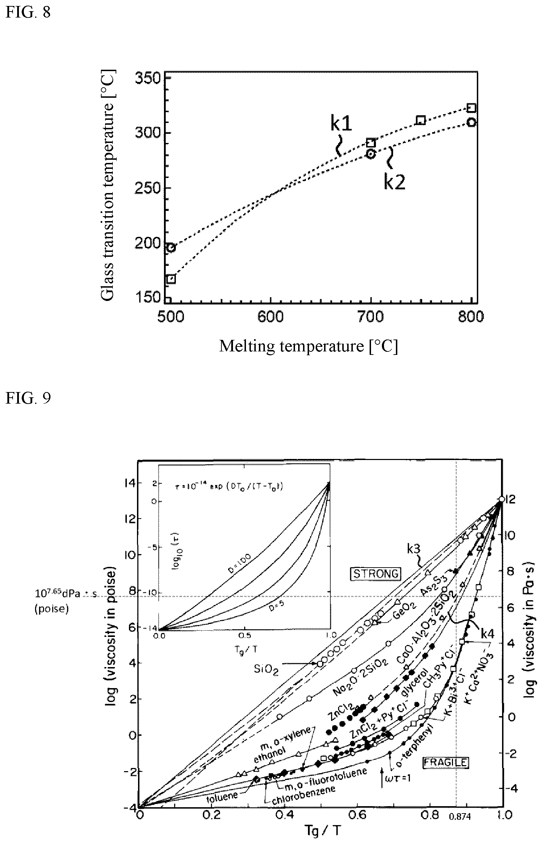

Fig. 8 is a graph showing relationships between the glass transition temperature and the melting temperature. In Fig. 8, a curve k1 shows the relationship between the glass transition temperature Tg and the melting temperature in the component composition 1, and a curve k2 shows the relationship between the glass transition temperature Tg and the melting temperature in the component composition 2.

As can be seen with reference to Fig. 8, the phosphate glass PGS produced using the component composition 1 has a glass transition temperature Tg in the range of 160°C to 322°C in the melting temperature range of 500°C to 800°C (see the curve k1). The phosphate glass PGS produced using the component composition 2 has a glass transition temperature Tg in the range of 195°C to 310°C in the melting temperature range of 500°C to 800°C (see the curve k2).

In the phosphate glass PGS produced using each of the component compositions 1 and 2, the glass transition temperature Tg increases as the melting temperature increases (see the curves k1 and k2). Then, it was confirmed that the water resistance was improved as the glass transition temperature Tg increased.

The phosphate glass PGS produced at a melting temperature of 500°C using the component composition 1 and that produced using the component composition 2, respectively, have glass transition temperatures of 160°C and 195°C, which are in the range of the glass transition temperature Tg of the phosphate glass PGS-1 to PGS-60 in Examples 1 to 60, that is, in the range of 125°C to 232°C. The phosphate glass PGS produced at a melting temperature of 800°C using the component composition 1 and that produced using the component composition 2, respectively, have glass transition temperatures of 310°C and 322°C, which are in the range of the glass transition temperature Tg of the phosphate glass PGS-61 to PGS-125 in Examples 61 to 125, that is, in the range of 258°C to 393°C.

Therefore, the phosphate glass PGS produced using each of the component compositions shown in Examples 1 to 125 at a melting temperature in the range of 500°C to 800°C is considered to have a glass transition temperature Tg of 393°C or lower.

Fig. 9 is a graph showing relationships between the viscosity and the glass transition temperature. The relationships between the viscosity and the glass transition temperature shown in Fig. 9 are described in Non-Patent Document 3. In Fig. 9, the relationships between the viscosity and the glass transition temperature in oxide glass are shown in the range from the curve k3 to the curve k4.

The temperature at which the viscosity of glass η is η = 10^{7.65} dPa · s (poise) is referred to as the softening point of low melting point glass. The softening point of low melting point glass is 600°C or lower. Therefore, in Fig. 9, Tg/T = 0.874 was extracted at the point corresponding to the viscosity of η = 10^{7.65} dPa · s (poise) on the curve k4. The softening point of glass is 600°C or lower, and therefore, when T = 600°C = 873 K is substituted for T in Tg/T = 0.874, Tg = 763 K = 490°C is obtained. Therefore, the glass transition temperature Tg of the low melting point glass is 490°C or lower. Therefore, in an embodiment of the present invention, glass having a glass transition temperature Tg of 490°C or lower is referred to as "low melting point glass".

The phosphate glass PGS-1 to the phosphate glass PGS-125 in Examples 1 to 125 described above has a glass transition temperature Tg of lower than 490°C. Therefore, the phosphate glass PGS-1 to the phosphate glass PGS-125 are low melting point glass.

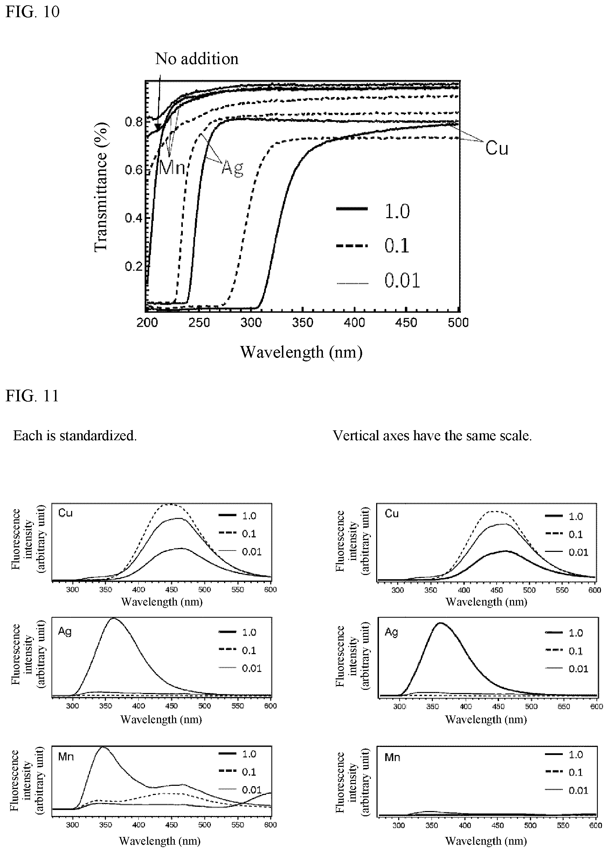

For the phosphate glass in Examples 116 to 125 (in which Cu, Ag, and Mn are added at an amount shown in Table 29 described below), Fig. 10 shows relationships between the light transmittance and the wavelength, and Fig. 12 shows relationships between the fluorescence intensity and the wavelength.

**[Table 29]**

| Addition amount | Additive | | |
|---|---|---|---|
| | Cu | Ag | Mn |
| 0 | Example 122 | | |
| 0.01 | Example 123 | Example 124 | Example 125 |
| 0.1 | Example 119 | Example 120 | Example 121 |
| 1.0 | Example 116 | Example 117 | Example 118 |

As can be seen in Examples 1 to 125 described above, the glass transition temperature Tg is lower than 490°C, and in terms of mole percentage based on oxides, the content of P₂O₅ is 55 to 65 [mol%], the content of ZnO is 10 to 27 [mol%], the content of R₂O₃ being at least one of Al₂O₃, Ga₂O₃, or Y₂O₃ is 0.7 to 7 [mol%], the content of a lanthanoid oxide L₂O₃ being at least one of La₂O₃, Ce₂O₃, Pr₂O₃, Nd₂O₃, Pm₂O₃, Sm₂O₃, Lu₂O₃, Gd₂O₃, Tb₂O₃, Dy₂O₃, Ho₂O₃, Er₂O₃, Tm₂O₃, Yb₂O₃, or Lu₂O₃ is 0.7 to 3.5 [mol%], and the content of X₂O being at least one of Li₂O, Na₂O, K₂O, Rb₂O, Cs₂O, or Fr₂O is 4.3 to 14.5 [mol%].

Therefore, the phosphate glass PGS according to an embodiment of the present invention has a glass transition temperature of lower than 490°C and includes, in terms of mole percentage based on oxides, 55 to 65 [mol%] of P₂O₅, 10 to 27 [mol%] of ZnO, 0.5 to 7 [mol%] of R₂O₃ being at least one of Al₂O₃, Ga₂O₃, or Y₂O₃, 0.5 to 3.5 [mol%] of L₂O₃ being at least one of La₂O₃, Ce₂O₃, Pr₂O₃, Nd₂O₃, Pm₂O₃, Sm₂O₃, Lu₂O₃, Gd₂O₃, Tb₂O₃, Dy₂O₃, Ho₂O₃, Er₂O₃, Tm₂O₃, Yb₂O₃, or Lu₂O₃, and 4 to 15 [mol%] of X₂O being at least one of Li₂O, Na₂O, K₂O, Rb₂O, Cs₂O, or Fr₂O.

Furthermore, as can be seen in Examples 1 to 125, the content of QO being at least one of BaO, SrO, MgO, or CaO as an optional component is 0 to 11.1 [mol%] in terms of mole percentage based on oxides, and in a case where QO is included, the minimum content is 5.4 [mol%]. Therefore, the phosphate glass PGS according to an embodiment of the present invention preferably includes 5 to 12 [mol%] of QO in terms of mole percentage based on oxides.

The phosphate glass PGS has a glass transition temperature Tg of lower than 400°C.

The phosphate glass PGS is characterized by including P₂O₅ at a large content of 55 to 65 [mol%]. The content of P₂O₅ of 55 to 65 [mol%] results in the total content of P₂O₅ and ZnO of 68 to 85 [mol%].

P₂O₅ and ZnO mainly contribute to maintenance of the glass structure of the phosphate glass PGS, R₂O₃ and L₂O₃ mainly contribute to improvement of the water resistance, and X₂O mainly contributes to having a low melting point. As a result, the phosphate glass PGS having a low melting point and excellent water resistance while maintaining a glass structure can be realized by adjusting the contents of P₂O₅ and ZnO, the contents of R₂O₃ and L₂O₃, and the content of X₂O in the above-described ranges.

### INDUSTRIAL APPLICABILITY

The present invention is applied to phosphate glass and a light emitting device in which the phosphate glass is used.

### DESCRIPTION OF REFERENCE SIGNS

1: Light emitting element
2: Coating material
10: Light emitting device

## Claims

1. Phosphate glass comprising, in terms of mole percentage based on oxides:
55 to 65 [mol%] of P₂O₅;
10 to 27 [mol%] of ZnO;
0.5 to 7 [mol%] of R₂O₃ being at least one of Al₂O₃, Ga₂O₃, or Y₂O₃;
0.5 to 3.5 [mol%] of a lanthanoid oxide L₂O₃ being at least one of La₂O₃, Ce₂O₃, Pr₂O₃, Nd₂O₃, Pm₂O₃, Sm₂O₃, Lu₂O₃, Gd₂O₃, Tb₂O₃, Dy₂O₃, Ho₂O₃, Er₂O₃, Tm₂O₃, Yb₂O₃, or Lu₂O₃; and
4 to 15 [mol%] of X₂O being at least one of Li₂O, Na₂O, K₂O, Rb₂O, Cs₂O, or Fr₂O, the phosphate glass having a glass transition temperature of lower than 400°C.

2. The phosphate glass according to claim 1, wherein
a total content of the P₂O₅ and the ZnO is 68 to 85 [mol%], and
a total content of the R₂O₃ and the L₂O₃ is 1 to 10 [mol%].

3. The phosphate glass according to claim 1 or 2, wherein the glass transition temperature is 240°C or lower.

4. The phosphate glass according to claim 3, wherein a content of the Al₂O₃ is 1 to 5 [mol%].

5. The phosphate glass according to claim 3 or 4, further comprising 0.001 to 10.0 [mol%] of SnO.

6. The phosphate glass according to claim 1 or 2, wherein the glass transition temperature is higher than 240°C.

7. The phosphate glass according to any one of claims 1 to 6, further comprising 5 to 12 [mol%] of QO being at least one of BaO, SrO, CaO, or MgO.

8. The phosphate glass according to any one of claims 1 to 7, further comprising 0.1 to 9 [mol%] of SiO₂.

9. A light emitting device comprising:
a light emitting element; and
a coating material with which the light emitting element is coated, the coating material including the phosphate glass according to any one of claims 1 to 8.

## Patentansprüche

1. Phosphatglas, das, ausgedrückt in Mol-Prozent bezogen auf Oxide, Folgendes umfasst:
55 bis 65 [Mol-%] P₂O₅;
10 bis 27 [Mol-%] ZnO;
0,5 bis 7 [Mol-%] R₂O₃, das zumindest eines aus Al₂O₃, Ga₂O₃ und Y₂O₃ ist;
0,5 bis 3,5 [Mol-%] eines Lanthanoidoxids L₂O₃, das zumindest eines aus La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃ und Lu₂O₃ ist; und
4 bis 15 [Mol-%] X₂O, das zumindest eines aus Li₂O, Na₂O, K₂O, Rb₂O, Cs₂O und Fr₂O ist, wobei das Phosphatglas eine Glasübergangstemperatur von weniger als 400 °C aufweist.

2. Phosphatglas nach Anspruch 1, wobei
der Gehalt von P₂O₅ und ZnO insgesamt 68 bis 85 [Mol-%] beträgt und
der Gehalt von R₂O₃ und L₂O₃ insgesamt 1 bis 10 [Mol-%] beträgt.

3. Phosphatglas nach Anspruch 1 oder 2, wobei die Glasübergangstemperatur 240 °C oder niedriger ist.

4. Phosphatglas nach Anspruch 3, wobei der Gehalt von Al₂O₃ 1 bis 5 [Mol-%] beträgt.

5. Phosphatglas nach Anspruch 3 oder 4, das weiters 0,001 bis 10,0 [Mol-%] SnO umfasst.

6. Phosphatglas nach Anspruch 1 oder 2, wobei die Glasübergangstemperatur höher als 240 °C ist.

7. Phosphatglas nach einem der Ansprüche 1 bis 6, das weiters 5 bis 12 [Mol-%] QO umfasst, das zumindest eines aus BaO, SrO, CaO und MgO ist.

8. Phosphatglas nach einem der Ansprüche 1 bis 7, das weiters 0,1 bis 9 [Mol-%] SiO₂ umfasst.

9. Lichtemittierende Vorrichtung, die Folgendes umfasst:
ein lichtemittierendes Element; und
ein Beschichtungsmaterial, mit dem das lichtemittierende Element beschichtet ist, wobei das Beschichtungsmaterial ein Phosphatglas nach einem der Ansprüche 1 bis 8 umfasst.

## Revendications

1. Verre au phosphate comprenant, en termes de pourcentage molaire basé sur les oxydes :
de 55 à 65 [% molaire] de P₂O₅ ;
de 10 à 27 [% molaire] de ZnO ;
de 0,5 à 7 [% molaire] de R₂O₃ étant au moins un parmi Al₂O₃, Ga₂O₃ ou Y₂O₃ ;
de 0,5 à 3,5 [% molaire] d'un oxyde de lanthanide L₂O₃ étant au moins un parmi La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃ ou Lu₂O₃ ; et
de 4 à 15 [% molaire] de X₂O étant au moins un parmi Li₂O, Na₂O, K₂O, Rb₂O, Cs₂O ou Fr₂O, le verre au phosphate présentant une température de transition vitreuse inférieure à 400°C.

2. Verre au phosphate selon la revendication 1, dans lequel
une teneur totale du P₂O₅ et du ZnO est de 68 à 85 [% molaire], et
une teneur totale du R₂O₃ et du L₂O₃ est de 1 à 10 [% molaire].

3. Verre au phosphate selon la revendication 1 ou 2, dans lequel la température de transition vitreuse est de 240°C ou moins.

4. Verre au phosphate selon la revendication 3, dans lequel la teneur du Al₂O₃ est de 1 à 5 [% molaire].

5. Verre au phosphate selon la revendication 3 ou 4, comprenant en outre de 0,001 à 10,0 [% molaire] de SnO.

6. Verre au phosphate selon la revendication 1 ou 2, dans lequel la température de transition vitreuse est supérieure à 240°C.

7. Verre au phosphate selon l'une quelconque des revendications 1 à 6, comprenant en outre de 5 à 12 [% molaire] de QO étant au moins un parmi BaO, SrO, CaO ou MgO.

8. Verre au phosphate selon l'une quelconque des revendications 1 à 7, comprenant en outre de 0,1 à 9 [% molaire] de SiO₂.

9. Dispositif électroluminescent comprenant :
un élément électroluminescent ; et
un matériau de revêtement dont l'élément électroluminescent est recouvert, le matériau de revêtement comprenant le verre au phosphate selon l'une quelconque des revendications 1 à 8.
